(19) Europäisches Patentamt / European Patent Office / Office européen des brevets

(11) **EP 4 793 317 A1**

(12) **EUROPEAN PATENT APPLICATION**
published in accordance with Art. 153(4) EPC


(43) Date of publication:
**19.08.2026 Bulletin 2026/34**

(21) Application number: **24877273.3**

(22) Date of filing: **11.10.2024**

(51) International Patent Classification (IPC):
***C08L 67/00*** $^{(2006.01)}$ ***C08J 5/18*** $^{(2006.01)}$
***C08K 5/00*** $^{(2006.01)}$ ***B29C 48/08*** $^{(2019.01)}$
***B29C 48/88*** $^{(2019.01)}$

(52) Cooperative Patent Classification (CPC):
**B32B 3/266; B32B 7/023; B32B 7/025; B32B 27/00; B32B 27/18; B32B 27/20; B32B 27/30; B32B 27/36; C08G 63/00; C08G 63/183; C08J 5/18; C08J 7/04; C08J 7/043; C08J 9/00; C08K 3/00;** (Cont.)

(86) International application number:
**PCT/JP2024/036413**

(87) International publication number:
**WO 2025/079679 (17.04.2025 Gazette 2025/16)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**13.10.2023 JP 2023177741**
**01.03.2024 JP 2024031431**
**01.03.2024 JP 2024031434**
**29.03.2024 JP 2024055982**
**29.03.2024 JP 2024055985**
**29.03.2024 JP 2024055986**
**08.05.2024 JP 2024076078**
**11.06.2024 JP 2024094269**
**11.06.2024 JP 2024094270**
**16.07.2024 JP 2024113434**
**16.07.2024 JP 2024113436**
**16.07.2024 JP 2024113437**



(71) Applicant: **Toyobo Co., Ltd.**
**Kita-ku**
**Osaka-shi, Osaka 530-0001 (JP)**

(72) Inventors:
- **WATANABE, Naoko**
  **Otsu-shi, Shiga 520-0292 (JP)**
- **HIGO, Eri**
  **Otsu-shi, Shiga 520-0292 (JP)**
- **HIGUCHI, Makoto**
  **Otsu-shi, Shiga 520-0292 (JP)**
- **HIROI, Norihiko**
  **Otsu-shi, Shiga 520-0292 (JP)**
- **HAYAKAWA, Shota**
  **Tsuruga-shi, Fukui 914-8550 (JP)**
- **MURATA, Hironori**
  **Tsuruga-shi, Fukui 914-8550 (JP)**
- **ITO, Katsuya**
  **Osaka-shi, Osaka 530-0001 (JP)**

(74) Representative: **Vossius & Partner**
**Patentanwälte Rechtsanwälte mbB**
**Siebertstraße 3**
**81675 München (DE)**


(54) **POLYESTER FILM, METHOD FOR PRODUCING SAME, AND RESIN COMPOSITION**


(57) Provided are a polyester film that has excellent electrostatic adhesion and a method for production thereof, and a resin composition for use in the production method. The polyester film comprises an ionic compound in an amount of 0.01 ppm by mass or more and 950 ppm by mass, the ionic compound having an anion-cation dissociation energy Q of 850 kJ/mol or less.


EP 4 793 317 A1

(52) Cooperative Patent Classification (CPC): (Cont.)
**C08K 3/013; C08K 3/017; C08K 5/00;
C08K 5/098; C08K 5/17; C08K 5/42; C08K 5/51;
C08L 23/00; C08L 67/00; C08L 67/03;
C08L 101/00; G02B 1/11; G02B 1/14; G02B 5/02;
G02B 5/30; H05B 33/14; H10K 50/86;
H10K 59/10;** B29C 48/08; B29C 48/88

## Description

### Technical Field

The present application claims priority based on Japanese Patent Application Nos. 2023-177741, 2024-031431, 2024-031434, 2024-055982, 2024-055985, 2024-055986, 2024-076078, 2024-094269, 2024-094270, 2024-113434, 2024-113436, and 2024-113437. The disclosures of these patent applications are incorporated herein, in their entirety, by reference.

The present invention relates to a polyester film and a production method therefor, and a resin composition for use in the production method.

### Background Art

Polyester films, such as polyethylene terephthalate, have excellent mechanical properties, heat resistance, electrical insulation properties, chemical resistance, etc., and are thus used for various applications.

A polyester film is typically produced by bringing a sheet-shaped material, which has been prepared by melt-extrusion using an extruder, into intimate contact with the surface of, for example, a cooling drum that rotates, to produce an unstretched film, which is used as an unstretched film or further subjected to uniaxial or biaxial stretching and used as a stretched film.

In order to improve the thickness uniformity of such unstretched and stretched films and to increase production speed, it is necessary to quickly and uniformly bring the melt-extruded sheet into intimate contact with the surface of the cooling drum or other equipment.

One well-known method for achieving the intimate contact is the electrostatic adhesion method. In this method, an electrode is placed between a die and a cooling rotary drum and a high voltage to deposit static electricity on the surface of the molten sheet, thus bringing the molten sheet into intimate contact with the surface of the cooling rotary drum by electrostatic force.

In the electrostatic adhesion method, increasing the amount of electric charge on the surface of the molten sheet is effective, and it is known that lowering the resistivity of the polyester, which is used as the raw material, is effective in increasing the charge amount. In order to lower this resistivity, for example, a compound of an alkali metal (Group 1) or an alkaline earth metal (Group 2) is added.

However, these methods have a tendency for the added metals to precipitate as foreign matter, which can lead to defects of the film or a reduction in clarity. Therefore, a method for reducing precipitation of foreign matter by optimizing factors such as the amount and timing of the additive added has been proposed (for example, Patent Literature (PTL) 1).

### Citation List

#### Patent Literature

[PTL 1] JP2002-327053

### Summary of Invention

#### Technical Problem

In particular, in recent years, polyester films have been used as essential films in fields that require high precision, such as optical films, process films, and high-barrier films. A polyester that can be produced with high productivity using the electrostatic adhesion method, in particular, a high-clarity polyester film with excellent electrostatic adhesion and fewer problems incurred by the precipitation of additives has been desired.

In view of the above circumstance, an object of the present invention is to provide a polyester film that has excellent electrostatic adhesion, in particular, a high-clarity polyester film suitable for use in various applications.

In recent years, driven by awareness of Sustainable Development Goals (SDGs), polyesters produced using biomass-derived materials, material-recycled polyesters obtained by collecting used polyester products such as bottles, and chemical-recycled polyesters produced by polymerization of monomers or oligomers obtained by decomposing used polyesters as starting materials have become increasingly used widely. Polyester films produced using such polyesters as raw materials are also required to have similar resistivity and high clarity. The resin used in polyester films often contains an electrostatic adhesive and lubricant particles as additives. However, from the perspective of economic efficiency and reducing environmental impact, a method in which a polyester that does not contain additives or the like is produced on a large scale, and additives for film are added separately, has also been used.

In view of the above circumstances, an object of the present invention is to provide a polyester film with excellent electrostatic adhesion, in particular, a high-clarity polyester film suitable for various applications; a method for producing the polyester film; and a resin composition for use in the production method.

Solution to Problem

Through diligent research, the present inventors found that the above problem can be solved by producing a polyester film using a method comprising:

incorporating an ionic compound in an amount of 0.01 ppm by mass or more and 950 ppm by mass or less into a polyester film, the ionic compound having an anion-cation dissociation energy Q of 850 kJ/mol or less;
mixing a polyester resin composition A, which comprises the ionic compound, with a polyester resin B having a melt resistivity higher than that of composition A (or a melt resistivity of $1 \times 10^8$ $\Omega$·cm or more); and
forming the resulting mixture of the polyester resin composition A and the polyester resin B into a film.
As a result of further research, the present invention has been accomplished.

The present invention includes the embodiments described in the following Items.

Item 1
A polyester film comprising an ionic compound in an amount of 0.01 ppm by mass or more and 950 ppm by mass or less, the ionic compound having an anion-cation dissociation energy Q of 850 kJ/mol or less.

Item 2
The polyester film according to Item 1, comprising a resin having a melt resistivity of 20 x $10^8$ $\Omega$·cm or less.

Item 3
The polyester film according to Item 1 or 2, comprising a resin having a melt resistivity of 0.001 x $10^8$ $\Omega$·cm or more.

Item 4
The polyester film according to any one of Items 1 to 3, wherein the ionic compound comprises at least one ion selected from the group consisting of an anion and a cation, the at least one ion having an ionic radius of 10 Å or less.

Item 5
The polyester film according to any one of Items 1 to 4, wherein the ionic compound comprises at least one ion selected from the group consisting of an anion and a cation, the at least one ion having an absolute value of average charge density of 0.0025 e/Å$^2$ or more and 0.075 e/Å$^2$ or less.

Item 6
The polyester film according to any one of Items 1 to 5, wherein the ionic compound comprises a cation having an ionic radius of 2 Å or more.

Item 7
The polyester film according to any one of Items 1 to 6, wherein the ionic compound comprises a cation having an absolute value of average charge density of 0.015 e/Å$^2$ or less.

Item 8
The polyester film according to any one of Items 1 to 7, comprising the ionic compound in an amount of less than 100 ppm by mass.

Item 9
The polyester film according to any one of Items 1 to 8, comprising a resin that is polyethylene terephthalate and/or polyethylene naphthalate.

Item 10
A method for producing a polyester film comprising an ionic compound having an anion-cation dissociation energy Q of 850 kJ/mol or less, the method comprising:

mixing a polyester resin composition A, which comprises a polyester resin A and an ionic compound having an

anion-cation dissociation energy Q of 850 kJ/mol or less, with a polyester resin B having a melt resistivity greater than that of the polyester resin composition A; and
forming the resulting mixture of the polyester resin composition A and the polyester resin B into a film.

Item 11
The method according to Item 10, wherein the polyester resin composition A has a melt resistivity of 5 x $10^8$ Ω·cm or less.

Item 12
A method for producing a polyester film comprising an ionic compound having an anion-cation dissociation energy Q of 850 kJ/mol or less, the method comprising:

mixing a polyester resin composition A, which comprises a polyester resin A and an ionic compound having an anion-cation dissociation energy Q of 850 kJ/mol or less, with a polyester resin B having a melt resistivity of 1 × $10^8$ Ω·cm or more, and
forming the resulting mixture of the polyester resin composition A and the polyester resin B into a film.

Item 13
A method for producing the polyester film of any one of Items 1 to 9, the method comprising:

mixing a polyester resin composition A, which comprises a polyester resin A and an ionic compound having an anion-cation dissociation energy Q of 850 kJ/mol or less, with a polyester resin B having a melt resistivity greater than that of the polyester resin composition A; and
forming the resulting mixture of the polyester resin composition A and the polyester resin B into a film.

Item 14
A method for producing the polyester film of any one of Items 1 to 9, comprising:

mixing a polyester resin composition A, which comprises a polyester resin A and an ionic compound having an anion-cation dissociation energy Q of 850 kJ/mol or less, with a polyester resin B having a melt resistivity of 1 × $10^8$ Ω·cm or more, and
forming the resulting mixture of the polyester resin composition A and the polyester resin B into a film.

Item 15
A polyester resin composition comprising a polyester resin and an ionic compound having an anion-cation dissociation energy Q of 850 kJ/mol or less, the polyester resin composition having a melt resistivity of 0.0001 × $10^8$ Ω·cm or more and 0.1 × $10^8$ Ω·cm or less.

Item 16
The polyester resin composition according to Item 15, wherein the ionic compound comprises at least one ion selected from the group consisting of an anion and a cation, the at least one ion having an ionic radius of 10 Å or less.

Item 17
The polyester resin composition according to Item 15 or 16, wherein the ionic compound comprises at least one ion selected from the group consisting of an anion and a cation, the at least one ion having an absolute value of average charge density of 0.0025 e/$Å^2$ or more and 0.075 e/$Å^2$ or less.

Item 18
The polyester resin composition according to any one of Items 15 to 17, wherein the ionic compound comprises a cation having an ionic radius of 2 Å or more.

Item 19
The polyester resin composition according to any one of Items 15 to 18, wherein the ionic compound comprises a cation having an absolute value of average charge density of 0.015 e/$Å^2$ or less.

Item 20
The method according to any one of Items 10 to 12, wherein the polyester resin A and the polyester resin B are each polyethylene terephthalate and/or polyethylene naphthalate.

Item 21
The polyester resin composition according to any one of Items 15 to 19, wherein the polyester resin is polyethylene terephthalate and/or polyethylene naphthalate.

## Advantageous Effects of Invention

The present invention can provide a polyester film with excellent electrostatic adhesion, in particular, a polyester film with high clarity as well as excellent electrostatic adhesion.

## Description of Embodiments

### Polyester Film

In the present specification, the term "polyester film" refers to a film whose main resin component (which may be referred to below as the "raw resin") is a polyester resin. The polyester film may simply be referred to below as "the film." The term "main component" refers to the component present in the largest amount among the raw resins. The proportion of the polyester resin is preferably selected from the range of 50 mass% or more, based on 100 mass% of the raw resin, and can be, for example, 60 mass% or more, 70 mass% or more, 80 mass% or more, 90 mass% or more, or 95 mass% or more. The raw resin of the film may consist only of a polyester resin. When a polyester resin is used in combination with a resin other than polyester resin, the proportion of the polyester resin is preferably selected from the range of 50 mass% or more and less than 100 mass%, based on 100 mass% of the raw resin, and is, for example, in the range of 70 mass% or more and 99 mass% or less.

### Polyester Resin

In present specification, "polyester resin" refers to a resin having a repeating unit comprising a dicarboxylic acid component and a glycol component, or a resin having a repeating unit comprising a hydroxycarboxylic acid component, or the repeating unit may be a mixture of these components.
Examples of dicarboxylic acid components include aromatic dicarboxylic acid components such as terephthalic acid, isophthalic acid, 1,6-naphthalenedicarboxylic acid, 2,6-naphthalenedicarboxylic acid, 4,4'-biphenyldicarboxylic acid, and sodium sulfoisophthalate; alicyclic dicarboxylic acid components such as 1,4-cyclohexanedicarboxylic acid and 1,3-cyclohexanedicarboxylic acid; aliphatic dicarboxylic acid components such as malonic acid, succinic acid, maleic acid, glutaric acid, adipic acid, suberic acid, sebacic acid, and dimer acid; and heterocyclic ring-containing dicarboxylic acid components such as furandicarboxylic acid. The dicarboxylic acid components may be used singly or in a combination of two or more.
Examples of glycol components include aliphatic glycol components such as ethylene glycol, diethylene glycol (DEG), triethylene glycol, 1,2-propylene glycol, 1,3-propylene glycol, 1,4-butanediol, 1,2-butanediol, 1,3-butanediol, neopentyl glycol, and 1,6-hexanediol; alicyclic glycol components such as 1,4-cyclohexanedimethanol, 1,3-cyclohexanedimethanol, spiroglycol, and isosorbide; and aromatic glycol components such as p-xylylene glycol, m-xylylene glycol, and ethylene oxide adducts of bisphenol A. Such glycol components can be used singly or in a combination of two or more.
Examples of hydroxycarboxylic acid components include lactic acid (lactide), glycolic acid, 3-hydroxypropionic acid, and 6-hydroxycaproic acid ($\varepsilon$-caprolactone). Such hydroxycarboxylic acid components can be used singly or in a combination of two or more.
Specific examples of polyester resins include polyethylene terephthalate (PET), polyethylene naphthalate (PEN), polytrimethylene terephthalate (PTT), polybutylene terephthalate (PBT), polycyclohexylene dimethylene terephthalate (PCT), polyethylene furanoate (PEF), polylactic acid (PLA), polybutylene succinate (PBS), polybutylene succinate adipate (PBSA), polybutylene succinate lactate (PBSL), polybutylene adipate terephthalate (PBAT), and polyethylene succinate (PES). In particular, polyethylene terephthalate (PET) and/or polyethylene naphthalate (PEN) are preferable. In the present specification, when the polyester resin is a polyester resin such as those mentioned above, the total amount of the polymer components derived from the specific polyester resin is preferably 60 mol% or more, based on the total amount of polymer components (the dicarboxylic acid component and glycol component and/or the hydroxycarboxylic acid component) of the polyester resin taken as 100 mol%. For example, when the polyester resin is polyethylene terephthalate (PET), the term "polyester resin" refers to a polyester resin in which the total amount of the terephthalic acid component and the ethylene glycol component accounts for 60 mol% or more of the total polymer components. The polyester resin preferably contains a polymer component derived from the polyester resin in a proportion of 70 mol% or more, preferably 80 mol% or more, more preferably 85 mol% or more, and particularly preferably 90 mol% or more, and can be, for example, 95 mol% or more, 97 mol% or more, or 98 mol% or more, based on the total polymer components. Polymers such as dimers and trimers of glycol components, such as diethylene glycol produced as by-

products, are not included as polymer components derived from the polyester resin. The upper limit of the polymer component derived from the polyester resin is 100 mol% based on all the polymer components. However, when the polyester resin is produced using a dicarboxylic acid component and a glycol component, the polymer of the glycol component may be copolymerized, and the upper limit of the polymer component may be 99.5 mol% or may be 99 mol%.

Further, the polyester resin may contain, as copolymer components, tri- or higher-functional carboxylic acid components such as trimellitic acid and pyromellitic acid; and tri- or higher-functional alcohol components such as propane and pentaerythritol. Such copolymer components may be used singly or in a combination of two or more. When the total acid components are defined as 100 mol% and the total alcohol components are defined as 100 mol%, the total amount of multifunctional carboxylic acid components and multifunctional alcohol components is preferably 5 mol% or less, and more preferably 3 mol% or less. The lower limit of the total amount of multifunctional carboxylic acid components and multifunctional alcohol components is not particularly limited, and may be 0 mol% or may be 0.1 mol%.

The dicarboxylic acid component, glycol component, and hydroxycarboxylic acid component may be derived from petroleum sources. However, if those derived from biomass are industrially available, the biomass-derived ones are preferred.

The terephthalic acid component (or ethylene terephthalate component) may be bis(2-hydroxyethyl) terephthalate (BHET) obtained by chemical recycling.

Polyester resins may be used singly or in a mixture of two or more different types of polyester resins. The polyester film may contain a polyester resin as a single layer or as multiple layers with different compositions.

When polyester resins having the same composition are to be used, a mixture of biomass-derived polyester resin and petroleum-derived polyester resin may be used, and a mixture of recycled polyester resin and non-recycled polyester resin may also be used.

In particular, it is preferable to use material-recycled PET obtained by collecting used PET bottles and the like.

The lower limit of the intrinsic viscosity (which may be referred to as inherent viscosity or IV) of the polyester resin is preferably 0.45 dl/g, more preferably 0.5 dl/g, and even more preferably 0.55 dl/g. The upper limit of the intrinsic viscosity of the polyester resin is preferably 1.2 dl/g, more preferably 1 dl/g, even more preferably 0.9 dl/g, and particularly preferably 0.8 dl/g. In one embodiment, the intrinsic viscosity of the polyester resin is preferably 0.45 dl/g or higher and 1.2 dl/g or lower. Setting the intrinsic viscosity within the above range ensures mechanical properties of the film and facilitates stable production while suppressing the generation of foreign matter and discoloration caused by thermal degradation during film formation. The intrinsic viscosity of the polyester resin can be measured at 30°C using an Ostwald viscometer, after the polyester resin is dissolved in a mixed solvent of phenol (6 parts by mass) and 1,1,2,2-tetrachloroethane (4 parts by mass).

The lower limit of the acid value (which may be referred to as AV) of the polyester resin is preferably 0 eq/ton, more preferably 1 eq/ton, even more preferably 3 eq/ton, and particularly preferably 5 eq/ton. The upper limit of the acid value of the polyester resin is preferably 50 eq/ton, more preferably 40 eq/ton, and even more preferably 30 eq/ton. In one embodiment, the acid value of the polyester resin is preferably selected from the range of 30 eq/ton or less, and can be, for example, within the range of 1 eq/ton or more to 30 eq/ton. The acid value of the polyester resin can be measured by titration using a solution of potassium hydroxide in ethanol, with phenol red as an indicator, after the polyester resin is dissolved in benzyl alcohol.

The raw resin, such as polyester resin, preferably has a heat stability parameter (TS), which indicates heat resistance, of 0.5 or less. Setting the heat stability parameter within the above range ensures high heat resistance. This can also suppress a decrease in molecular weight and the generation of low-molecular-weight oligomers due to thermal degradation, thereby reducing defects and foreign matter in the film and preventing deterioration in processability. Further, this also suppresses breakage of molded products, which starts from foreign matter, thereby preventing deterioration in productivity. TS can be determined by placing the raw resin composition (polyester resin composition) into a glass ampoule, purging the ampoule with nitrogen and sealing the ampoule under a reduced pressure of 13.3 kPa (in a nitrogen atmosphere), heating the resulting composition at a temperature 40°C higher than the melting point of the raw resin for 2 hours, and then measuring the intrinsic viscosity of the raw resin composition, and calculating the intrinsic viscosity using the following formula:

$$TS = 0.245 \left\{ [IV]_{f2}^{-1.47} - [IV]_{i}^{-1.47} \right\}$$

wherein $[IV]_i$ and $[IV]_{f2}$ refer to the intrinsic viscosities of the raw resin composition before and after heat treatment, respectively.

It is preferable that the polyester film contains less foreign matter. The total number of particles of 5 μm or larger in the polyester film (or polyester resin) is preferably 15 or less, more preferably 14 or less, even more preferably 13 or less, still even more preferably 12 or less, particularly preferably 11 or less, and most preferably 10 or less, and can be less than 10, or can be 5 or less. Setting the total number of particles within the above range imparts a high degree of clarity to the formed film and the molded article. The total number of particles can be determined, for example, by observing 20 fields of

view, each with an area of 718 μm × 583 μm, under a phase-contrast microscope at 100× magnification, and counting the number of particles of 5 μm or larger using an image analyzer.

When the polyester resin is PET, the polyester resin may contain a cyclic trimer (CT). The CT content is usually 1.1 mass% or less, and preferably 1 mass% or less. From the perspective of suppressing contamination of the film production equipment caused by CT and an increase in haze by heating the film, the CT content is more preferably 0.7 mass% or less, particularly preferably 0.6 mass% or less, and most preferably 0.5 mass% or less. From the perspective of the productivity of the polyester resin, the lower limit of the CT content is preferably 0.3 mass%, more preferably 0.33 mass%, and even more preferably 0.35 mass%. The CT content can be quantified, for example, by accurately weighing 100 mg of a finely ground sample, dissolving the sample in 3 mL of a hexafluoroisopropanol/chloroform mixture (volume ratio = 2/3), diluting the solution with an additional 20 mL of chloroform, adding 10 mL of methanol to precipitate the polymer, then filtering the mixture, evaporating the filtrate to dryness, and dissolving the residue in 10 mL of dimethylformamide to a fixed volume to quantify the CT content by high-performance liquid chromatography.

The polymerization catalyst for raw resins such as polyester resin is not particularly limited. Examples of usable polymerization catalysts include antimony compounds such as antimony trioxide, antimony pentoxide, antimony acetate, and antimony glycolate; germanium compounds such as germanium dioxide; aluminum compounds such as aluminum acetate; titanium compounds such as organic titanium compounds; manganese compounds such as manganese acetate; and mixtures of two or more of these compounds. Among them, from the standpoint of the transparency of the resulting polyester resin and availability, at least one compound selected from antimony compounds such as antimony trioxide, germanium compounds such as germanium dioxide, aluminum compounds, and titanium compounds is preferred.

The lower limit of the Sb content in the raw resin, such as polyester resin, is preferably 40 ppm by mass, more preferably 50 ppm by mass, even more preferably 60 ppm by mass, particularly preferably 70 ppm by mass, and most preferably 76 ppm by mass. The lower limit of the Sb content may be 78 ppm by mass or may be 80 ppm by mass. The upper limit of the Sb content is preferably 400 ppm by mass, more preferably 350 ppm by mass, even more preferably 300 ppm by mass, and particularly preferably 250 ppm by mass, may be less than 250 ppm by mass, and is most preferably 200 ppm by mass. In one embodiment, the Sb content is preferably 40 ppm by mass or more and 400 ppm by mass or less.

The lower limit of the Ge content in the raw resin, such as a polyester resin, is preferably 10 ppm by mass, more preferably 20 ppm by mass, and even more preferably 30 ppm by mass. The upper limit of the Ge content is preferably 200 ppm by mass, more preferably 150 ppm by mass, and even more preferably 100 ppm by mass. In one embodiment, the Ge content is preferably 10 ppm by mass or more and 200 ppm by mass or less.

The lower limit of the Ti content in the raw resin, such as polyester resin, is 1 ppm by mass, more preferably 2 ppm by mass, even more preferably 3 ppm by mass, particularly preferably 4 ppm by mass, and most preferably 5 ppm by mass. The upper limit of the Ti content is preferably 50 ppm by mass, more preferably 40 ppm by mass, even more preferably 30 ppm by mass, particularly preferably 25 ppm by mass, and most preferably 20 ppm by mass. In one embodiment, the Ti content is preferably 1 ppm by mass or more and 50 ppm by mass or less.

The lower limit of the Mn content in the raw resin, such as polyester resin, is preferably 10 ppm by mass, more preferably 20 ppm by mass, and even more preferably 25 ppm by mass. The upper limit of the Mn content is preferably 100 ppm by mass, more preferably 80 ppm by mass, and even more preferably 70 ppm by mass. In one embodiment, the Mn content is preferably 10 ppm by mass or more and 100 ppm by mass or less.

The lower limit of the Al content in the raw resin, such as polyester resin, is preferably 1 ppm by mass, more preferably 3 ppm by mass, even more preferably 5 ppm by mass, particularly preferably 7 ppm by mass, and most preferably 10 ppm by mass. The upper limit of the Al content is preferably 100 ppm by mass, more preferably 70 ppm by mass, even more preferably 50 ppm by mass, particularly preferably 40 ppm by mass, and most preferably 30 ppm by mass, and may be 20 ppm by mass. By setting the Al content at or below the above-mentioned upper limit, foreign matter can be further suppressed. In one embodiment, the Al content is preferably 1 ppm by mass or more and 100 ppm by mass or less.

By setting the amount of polymerization catalyst within the above range, polymerization can proceed within an appropriate time frame, ensuring resin productivity. This can also suppress discoloration of the resin and the generation of foreign matter due to degradation products, and also suppress the formation of foreign matter caused by precipitation or aggregation of catalyst metals.

The raw resin, such as a polyester resin, may further contain a phosphorus compound. The addition of a phosphorus compound tends to suppress the precipitation of a metal used as a polymerization catalyst. Further, the combined use of an aluminum compound and a phosphorus compound as polymerization catalysts can enhance polymerization catalyst activity, which is desirable.

The phosphorus compound is not particularly limited. However, phosphonic acid-based compounds and phosphinic acid-based compounds are preferred because they provide significantly enhanced catalyst activity. Among these phosphorus compounds, phosphonic acid-based compounds are more preferable because they provide a particularly significantly enhanced catalyst activity.

Among the phosphorus compounds mentioned above, phosphorus compounds that have both a phosphorus

element and a phenol structure within the same molecule are preferable. Phosphorus compounds having a phosphorus atom and a phenol structure within the same molecule are not particularly limited, but it is preferable to use one or more compounds selected from the group consisting of phosphonic acid-based compounds having a phosphorus atom and a phenol structure within the same molecule and phosphinic acid-based compounds having a phosphorus atom and a phenol structure within the same molecule because such compounds provide a significantly enhanced catalyst activity. It is more preferable to use one or more phosphonic acid-based compounds having a phosphorus atom and a phenol structure within the same molecule because such compounds provide a highly improved catalyst activity of aluminum.

Examples of compounds containing both a phosphorus element and a phenol structure within the same molecule include phosphonic acid-based compounds represented by $P(=O)R^1(OR^2)(OR^3)$ and phosphinic acid-based compounds represented by $P(=O)R^1R^4(OR^2)$. $R^1$ represents a $C_1$-$C_{50}$ hydrocarbon group containing a phenol structure, or a $C_1$-$C_{50}$ hydrocarbon group containing a substituent, such as a hydroxyl group, a halo group, an alkoxy group, or an amino group, and a phenol structure. $R^4$ represents hydrogen, a $C_1$-$C_{50}$ hydrocarbon group, or a $C_1$-$C_{50}$ hydrocarbon group containing a substituent, such as a hydroxy group, a halo group, an alkoxy group, or an amino group. $R^2$ and $R^3$ each independently represent hydrogen, a $C_1$-$C_{50}$ hydrocarbon group, or a $C_1$-$C_{50}$ hydrocarbon group containing a substituent, such as a hydroxy group or an alkoxy group. The hydrocarbon group may contain a branched chain structure, an alicyclic structure such as cyclohexyl, an aromatic ring structure such as phenyl or naphthyl; and the like. The ends of $R^2$ and $R^4$ may also be bound to each other.

Examples of phosphorus compounds having a phosphorus element and a phenol structure within the same molecule include p-hydroxyphenylphosphonic acid, dimethyl p-hydroxyphenylphosphonate, diethyl p-hydroxyphenylphosphonate, diphenyl p-hydroxyphenylphosphonate, bis(p-hydroxyphenyl)phosphinic acid, methyl bis(p-hydroxyphenyl)phosphinate, phenyl bis(p-hydroxyphenyl)phosphinate, p-hydroxyphenylphosphinic acid, methyl p-hydroxyphenylphosphinate, and phenyl p-hydroxyphenylphosphinate.

Examples of phosphorus compounds having a phosphorus element and a phenol structure within the same molecule include, in addition to the phosphorus compounds mentioned above as examples, phosphorus compounds having a phosphorus element and a hindered phenol structure (e.g., a phenol structure in which an alkyl group having a tertiary carbon (preferably an alkyl group having a tertiary carbon at the benzylic position, such as a tert-butyl group or a texyl group; or a neopentyl group) is bonded to one or two ortho positions of a hydroxyl group) within the same molecule. Phosphorus compounds preferably are preferably phosphorus compounds having a phosphorus element and a structure represented by formula A below within the same molecule. Among them, a 3,5-di-tert-butyl-4-hydroxybenzyl dialkylphosphonate represented by formula B below is preferable.

HO— * (Formula A)

(In formula A, * represents a bonding site.)

HO—CH2—P(=O)(OX2)—OX1 (Formula B)

(In formula B, $X^1$ and $X^2$ independently represent hydrogen or a $C_1$-$C_4$ alkyl group.)

In the above formula B, $X^1$ and $X^2$ are both preferably $C_1$-$C_4$ alkyl, more preferably $C_1$-$C_3$ alkyl, and even more preferably $C_1$-$C_2$ alkyl. In particular, the diethyl ester compound having 2 carbon atoms is preferably Irganox 1222 (produced by BASF) because it is commercially available and easy to obtain.

When an aluminum compound is used as a polymerization catalyst, it is also preferable to add a lithium compound, such as lithium acetate. The lower limit of Li content in the raw resin, such as polyester resin, is preferably 1

ppm by mass, more preferably 3 ppm by mass, and even more preferably 5 ppm by mass. The upper limit of Li content in the raw resin, such as polyester resin is preferably 50 ppm by mass, more preferably 30 ppm by mass, and even more preferably 20 ppm by mass. In one embodiment, the lithium content in the raw resin, such as polyester resin, is preferably 1 ppm by mass or more and 50 ppm by mass or less.

The lower limit of the total content of Mg and Ca in the raw resin such as polyester resin is preferably 0 ppm by mass (below the detection limit), more preferably 0.01 ppm by mass, even more preferably 0.1 ppm by mass, and particularly preferably 0.5 ppm by mass. The upper limit of the total content of Mg and Ca is preferably 50 ppm by mass, more preferably 40 ppm by mass, even more preferably 30 ppm by mass, still even more preferably 20 ppm by mass, particularly preferably 10 ppm by mass, and most preferably 5 ppm by mass. By setting the total content at or below the above-mentioned upper limit, the generation of foreign matter can be further suppressed.

The lower limit of the Mg content in the raw resin, such as polyester resin, is preferably 0 ppm by mass (below the detection limit), more preferably 0.01 ppm by mass, even more preferably 0.1 ppm by mass, and particularly preferably 0.5 ppm by mass. The upper limit of the Mg content is preferably 10 ppm by mass, more preferably 9 ppm by mass, even more preferably 8 ppm by mass, particularly preferably 7 ppm by mass, and most preferably 6 ppm by mass. By setting the Mg content at or below the above upper limit, the generation of foreign matter can be further reduced.

The lower limit of the total alkali metal content in the raw resin, such as polyester resin, is preferably 0 ppm by mass (below the detection limit), more preferably 0.1 ppm by mass, and even more preferably 0.5 ppm by mass. The upper limit of the total alkali metal content is preferably 18 ppm by mass, more preferably 16 ppm by mass, even more preferably 15 ppm by mass, particularly preferably 14 ppm by mass, and most preferably 13 ppm by mass. By setting the total alkali metal content at or below the above-mentioned upper limit, discoloration of the polyester film can be further suppressed.

The lower limit of the Na content in the raw resin, such as polyester resin, is preferably 0 ppm by mass (below the detection limit), more preferably 0.1 ppm by mass, and even more preferably 0.5 ppm by mass. The upper limit of the Na content is preferably 13 ppm by mass, more preferably 10 ppm by mass, even more preferably 7 ppm by mass, particularly preferably 5 ppm by mass, and most preferably 3 ppm by mass. By setting the Na content at or below the above upper limit, discoloration of the polyester film can be further suppressed.

In particular, by setting the alkali metal (e.g., sodium) content in the raw resin, such as polyester resin, at or below the above-mentioned upper limit, discoloration can be suppressed even when the resin undergoes significant thermal history, for example, in the case where the extrusion temperature during film production is high, where the pipe is long and the residence time at high temperatures is long, or where recycled materials, such as film edge trim, are mixed as resin raw materials.

The above Ca, Mg, and alkali metals do not necessarily need to be excluded. Even if these metals are present, stable electrostatic adhesion by ionic compound is possible. By setting the alkali metal content within the above range, the generation of foreign matter and discoloration can be suppressed, resulting in a film suitable for stable production.

The lower limit of the Mn content in the raw resin, such as polyester resin, is preferably 0 ppm by mass (below the detection limit). The upper limit of the Mn content is preferably 22 ppm by mass, more preferably 20 ppm by mass, even more preferably 18 ppm by mass, and particularly preferably 16 ppm by mass. By setting the Mn content at or below the above-mentioned upper limit, the generation of foreign matter and discoloration can be further suppressed.

The lower limit of the Cu content in the raw resin, such as polyester resin, is preferably 0 ppm by mass (below the detection limit). The upper limit of the Cu content is preferably 160 ppm by mass, and more preferably 150 ppm by mass. By setting the Cu content at or below the above-mentioned upper limit, the generation of foreign matter and discoloration can be further suppressed.

Setting the Sb content in the raw material resin, such as polyester resin, to 76 ppm by mass or more and setting the Mg content to 10 ppm by mass or less are preferable in order to suppress the generation of foreign matter while increasing the productivity of the polyester resin. Having an antimony (Sb) content of 76 ppm by mass or more and a copper (Cu) content of 160 ppm by mass or less in the raw resin, such as polyester resin, is preferable to increase the productivity of the raw resin while suppressing the generation of foreign matter.

The lower limit of the total metal content in the raw resin, such as polyester resin, is preferably 1 ppm by mass, more preferably 2 ppm by mass, even more preferably 3 ppm by mass, particularly preferably 4 ppm by mass, and most preferably 5 ppm by mass. The upper limit of the total metal content is preferably 500 ppm by mass, more preferably 450 ppm by mass, even more preferably 400 ppm by mass, particularly preferably 300 ppm by mass, and most preferably 250 ppm by mass. By setting the total metal content at or below the above-mentioned upper limit, the generation of foreign matter and discoloration can be further suppressed. In one embodiment, the total metal content is 1 ppm by mass or more and 500 ppm by mass or less.

The metal content in the raw resin can be calculated by subjecting a sample to a pretreat (such as preliminary carbonization, ashing treatment, acid treatment, or dissolution) to prepare a measurement solution, and then measuring the concentrations of elements in the obtained measurement solution using a high-frequency inductively coupled plasma (ICP) emission spectrometer (for example, SPECTROBLUE, produced by Hitachi High-Tech Science Corporation). If it is difficult to conduct measurements at the wavelengths described in the Examples below, measurements can be conducted

at other wavelengths by referring to literature or the like.

Biomass PET

Biomass-derived PET (bio-PET) is also preferably used as the PET of polyester resin.

Bio-PET contains a biomass-derived material in at least one of the polymer components, either ethylene glycol or terephthalic acid. When the ethylene glycol contains ethylene glycol derived from biomass, ethylene glycol derived from biomass preferably accounts for 10 mass% or more, more preferably 30 mass% or more, even more preferably 50 mass% or more, particularly preferably 80 mass% or more, and more particularly preferably 90 mass% or more, of the entire ethylene glycol, and may account for 100%. When the terephthalic acid contains terephthalic acid derived from biomass, terephthalic acid derived from biomass preferably accounts 10 mass% or more, more preferably 30 mass% or more, even more preferably 50 mass% or more, still even more preferably 80 mass% or more, and particularly preferably 90 mass% or more of the entire terephthalic acid, and may account for 100 mass%.

Bio-PET may be used without being mixed with petroleum-derived PET, or may be used by mixing with petroleum-derived PET.

The biomass PET preferably accounts for 10 mass% or more, 30 mass% or more, 50 mass% or more, 70 mass% or more, 80 mass% or more, 90 mass% or more, and 95 mass% or more, of the raw resin for polyester film (particularly PET), in ascending order of preference. The biomass PET more preferably accounts for more than 95 mass%, even more preferably 96 mass% or more, particularly preferably 97 mass% or more, and most preferably 100 mass% of the entire raw resin.

Based on the total carbon content of the raw resin (in particular, PET) of the polyester film, the biomass-derived carbon content as determined by radiocarbon ($C^{14}$) measurement is preferably 2% or more, 6% or more, 10% or more, 14% or more, 16% or more, 18% or more, or 19% or more, in ascending order of preference, and is most preferably more than 19%. When only ethylene glycol for use is derived from biomass, the theoretical upper limit of biomass-derived carbon content is 20%. When terephthalic acid for use is also derived from biomass, the biomass-derived carbon content may exceed 20%. A higher content is preferable. Therefore, the most preferable value is 100%, but may be 95% or less, 90% or less, 80% or less, or 70% or less.

The biomass-derived carbon content stated above is based on the carbon ratio. If calculation is made based on the mass of biomass raw materials, including hydrogen and oxygen, with the assumption that total amount of the ethylene glycol is derived from biomass and total amount of the terephthalic acid is derived from petroleum, the biomass-derived content is calculated as 31.25 mass%.

Since carbon dioxide in the atmosphere contains $C^{14}$ in a certain proportion (105.5 pMC), it is known that plants that grow by absorbing atmospheric carbon dioxide, such as corn, have a $C^{14}$ content of about 105.5 pMC. It is also known that fossil fuels contain almost no $C^{14}$. Accordingly, by measuring the proportion of $C^{14}$ in the total carbon contained in polyester resin, the proportion of biomass-derived carbon (biomass content) can be calculated. The biomass content can be measured, for example, by radioactive carbon ($C^{14}$) measurement as shown in ASTM D6866-16 Method B (AMS).

When polyester film is produced using bio-PET, an ionic compound may be added in the same manner as when polyester film is produced using petroleum-derived PET. However, a method using a masterbatch is preferable. The masterbatch PET may be one derived from either petroleum or biomass, or a mixture of both.

A polyester film may be composed of two or more layers. At least one layer may include biomass-derived PET.

Bio-PET is preferably produced using an aluminum compound as the polymerization catalyst.

Chemically Recycled PET

As PET of the polyester resin, it is also preferable to use polyethylene terephthalate (chemical recycled PET or CR-PET) polymerized using bis(2-hydroxyethyl) terephthalate (chemical recycled BHET or CR-BHET) obtained through chemical recycling.

Chemical recycled BHET is preferably obtained by depolymerizing PET through heating in the presence of ethylene glycol. The PET as the starting material is preferably one that has already been used. Examples include containers, such as PET bottles and trays, collected from urban areas, fibers and products, discarded products before being cut into finished products during manufacturing, B-grade products not shipped to the market, edge portions held during film stretching, scraps from slits, and molded articles that have been returned due to complaints or the like. The PET as the starting material may be derived from petroleum-based terephthalic acid and/or ethylene glycol, or may be derived from biomass. The PET as the starting material may also be a molded article from mechanical recycling. Such PETs as the starting material may be used singly or in a combination of two or more.

The PET as the starting material is generally subjected to a depolymerization step after being crushed and washed and having foreign matter removed therefrom.

The chemically recycled BHET may contain linear dimers and polymers, and may also contain mono-2-

hydroxyethyl terephthalate, terephthalic acid, ethylene glycol, or the like.

The sum of the acid value and the hydroxyl value of the chemically recycled BHET is preferably 6500 eq/ton or more, more preferably 7000 eq/ton or more, and even more preferably 7500 eq/ton or more. The upper limit of the above sum is preferably 9500 eq/ton, more preferably 9000 eq/ton, and even more preferably 8500 eq/ton. In one embodiment, the above sum is preferably 6500 eq/ton or more and 9500 eq/ton or less. By setting the sum of the acid vale and hydroxyl value within the above range, productivity can be secured while maintaining sufficient purity.

The chemically recycled BHET may contain dicarboxylic acid components other than terephthalic acid and/or glycol components other than ethylene glycol. Examples of dicarboxylic acid components other than terephthalic acid include naphthalenedicarboxylic acid and isophthalic acid. Dicarboxylic acid components other than terephthalic acid may be used singly or in a combination of two or more. Examples of glycol components other than ethylene glycol include diethylene glycol, neopentyl glycol, cyclohexanedimethanol, trimethylene glycol, tetramethylene glycol, ethylene glycol or propylene glycol adducts of bisphenol A, and ethylene glycol or propylene glycol adducts of bisphenol S. Such glycol components other than ethylene glycol may be used singly or in a combination of two or more.

When the dicarboxylic acid components and the glycol components in the chemically recycled BHET are each set to 100 mol%, the amount of the terephthalic acid component of the dicarboxylic acid components and the amount of the glycol components other than ethylene glycol are each independently preferably 2 mol% or less, more preferably 1.5 mol% or less, even more preferably 1 mol% or less, particularly preferably 0.7 mol% or less, and most preferably 0.5 mol% or less. As described above, it is preferable that the chemically recycled BHET be obtained by depolymerizing PET that includes post-consumer collected materials. Although post-consumer PET may contain components other than PET, which are added for purposes such as adjusting crystallinity or physical properties, it is more cost-effective to use the post-consumer PET as is, with such non-PET components remaining, rather than sorting out only pure PET from the collected materials or purifying the BHET to a level at which no components other than terephthalic acid or ethylene glycol are detected. Accordingly, when the dicarboxylic acid component and the glycol component are each taken as 100 mol%, the amount of the dicarboxylic acid component other than terephthalic acid and the amount of the glycol component other than ethylene glycol may be independently preferably 0.01 mol % or more, and more preferably 0.05 mol % or more.

The lower limit of the amount of chemically recycled BHET, relative to the amount of BHET used when manufacturing CR-PET, is preferably 50 mass%, more preferably 60 mass%, even more preferably 70 mass%, particularly preferably 80 mass%, and most preferably 90 mass%, and may be 100 mass%.

CR-PET may be used in combination with PET resin other than those obtained by chemical recycling. When PET is blended with polyester resins other than PET, CR-PET may be used as a PET component.

The polyester film may consist of two or more layers, with at least one layer containing chemically recycled PET resin.

CR-PET preferably accounts for 10 mass% or more, 30 mass% or more, 50 mass% or more, 70 mass% or more, 80 mass% or more, 90 mass% or more, and 95 mass% or more, of the entire raw resin for polyester film (in particular, PET) in ascending order of preference. CR-PET may account for more than 95 mass%, 96 mass% or more, 97 mass% or more, or 100 mass% of the entire raw resin. Even in a masterbatch containing an ionic compound and an additive such as a lubricant in high concentrations, the CR-PET contained in the masterbatch is calculated as chemically recycled resin.

When polyester film is produced using CR-PET, an ionic compound may be added in the same manner as when polyester film is produced using PET other than chemical recycled PET. However, a method using a masterbatch is preferable. The polyester resin of the masterbatch may be CR-PET, non-CR-PET, or a mixture of both.

CR-PET is preferably produced using an aluminum compound as a polymerization catalyst.

Recovered Polyester Resin

It is also preferable to use a recovered polyester resin as polyester resin. Recovered polyester resin is generally obtained by collecting polyester resin molded articles that were either unused or used and subsequently collected.

Examples include containers, such as PET bottles and trays, collected from urban areas, fibers and products, discarded products before being cut into finished products during manufacturing, B-grade products not shipped to the market, edge portions held during film stretching, scraps from slits, and molded products that have been returned due to complaints or the like. These may be single-origin materials, such as collected PET bottles or film edge trim, or mixtures of materials from different sources. Among them, the recovered polyester resin is preferably a material derived from collected PET bottles, and preferably comprises the material derived from collected PET bottles in a proportion of 90 mass% or more, and more preferably 95 mass% or more.

The recovered polyester resin may be in the form of, for example, chips, flakes, or powder. The recovered polyester resin may be one obtained by pulverizing collected molded articles described above. However, from the standpoint of ease of handling, a material obtained by melting the recovered molded articles and pelletizing is preferable.

When the total amount of the polyester resin polymer components (dicarboxylic acid components and glycol components and/or hydroxycarboxylic acid components) is defined as 100 mol%, it is preferable that the total amount of

terephthalic acid components and ethylene glycol components is 50 mol% or more, more preferably 70 mol% or more, even more preferably 80 mol% or more, and particularly preferably 90 mol% or more, based on the total polymer components (dicarboxylic acid components and glycol components and/or hydroxycarboxylic acid components) of the polyester resin taken as 100 mol%. Examples of optional copolymer components include di- or higher-valent carboxylic acid components other than terephthalic acid, di- or higher-valent alcohol components other than ethylene glycol, hydroxycarboxylic acid components, and the like. Specific example of optional copolymer components are as mentioned above.

The recovered polyester resin preferably contains at least one selected from antimony, titanium, and germanium. That is, the recovered polyester resin is preferably produced using at least one polymerization catalyst selected from the group consisting of antimony compounds, titanium compounds, and germanium compounds. Among them, recovered polyester resins containing antimony and germanium are more preferred.

The total content of antimony, titanium, and germanium in the recovered polyester resin is preferably 2 ppm by mass or more, more preferably 5 ppm by mass or more, even more preferably 10 ppm by mass or more, still even more preferably 30 ppm by mass or more, and particularly preferably 50 ppm by mass or more. The total content is preferably 500 ppm by mass or less, more preferably 400 ppm by mass or less, even more preferably 300 ppm by mass or less, and particularly preferably 250 ppm by mass or less. In one embodiment, the total content is preferably 2 ppm by mass or more and 500 ppm by mass or less, more preferably 5 ppm by mass or more and 400 ppm by mass or less, even more preferably 10 ppm by mass or more and 300 ppm by mass or less, and particularly preferably 50 ppm by mass or more and 250 ppm by mass or less.

The recovered polyester resin may contain additives such as the colorants, lubricants (in particular, lubricant particles), ultraviolet absorbers, melt resistivity adjusters, antistatic agents, antioxidants, and heat stabilizers described below. The additives may be used singly or in a combination of two or more.

The recovered polyester resin preferably has an intrinsic viscosity of 0.5 dl/g or more, more preferably 0.55 dl/g or more, and even more preferably 0.57 dl/g or more. The recovered polyester resin preferably has an intrinsic viscosity of 0.8 dl/g or less, more preferably 0.75 dl/g or less, and even more preferably 0.73 dl/g or less. In one embodiment, the recovered polyester resin preferably has an intrinsic viscosity of 0.5 dl/g or more and 0.8 dl/g or less, more preferably 0.55 dl/g or more and 0.75 dl/g or less, and even more preferably 0.57 dl/g or more and 0.73 dl/g or less.

The recovered polyester resin is preferably PET recovered from PET bottles for beverages or the like. PET recovered from beverage PET bottles is sometimes referred to as bottle-recycled PET. The bottle-recycled PET content of the recovered polyester resin is preferably 70 mass% or more, more preferably 80 mass% or more, and even more preferably 90 mass% or more, and may be 100 mass%.

The recovered polyester resin (in particular, bottle-recycled PET) may contain an isophthalic acid component as a copolymerized component. When the total acid component is defined as 100 mol%, the lower limit of the isophthalic acid component content is preferably 0.02 mol%, more preferably 0.05 mol%, even more preferably 0.1 mol%, particularly preferably 0.2 mol%, and most preferably 0.3 mol%. The upper limit of the isophthalic acid component content is preferably 5 mol%, more preferably 4 mol%, even more preferably 3 mol%, and particular preferably 2.5 mol%, and most preferably 2 mol%. In one embodiment, the isophthalic acid component content is preferably 0.02 mol% or more and 5 mol% or less.

Diethylene glycol may be contained not only in the polyester resin as a by-product of ethylene glycol during polyester polymerization, but may also be added during polymerization for the purpose of adjusting crystallization.

When the total glycol content is defined as 100 mol%, the lower limit of the diethylene glycol component content of the recovered polyester resin (in particular, bottle-recycled PET) is preferably 0.5 mol%, more preferably 0.8 mol%, even more preferably 1 mol%, particularly preferably 1.2 mol%, and most preferably 1.4 mol%. The upper limit of the diethylene glycol component content is preferably 5 mol%, more preferably 4 mol%, even more preferably 3.5 mol%, and particularly preferably 3 mol%. In one embodiment, it is preferable that the diethylene glycol component content is 0.5 mol% or more and 5 mol% or less.

The upper limit of the copolymer components other than isophthalic acid and diethylene glycol present in the recovered polyester resin (in particular, bottle-recycled PET) is 3 mol%, more preferably 2.5 mol%, and even more preferably 2 mol%, when the total acid components and total glycol components are each taken as 100 mol%.

When the sum of total acid components and total glycol components is set to 200 mol%, the lower limit of the total amount of copolymer components in the recovered polyester resin (in particular, bottle-recycled PET) is preferably 0.5 mol%, more preferably 1 mol%, even more preferably 1.5 mol%, and particularly preferably 2 mol%. The upper limit of the total amount is preferably 7 mol%, more preferably 6 mol%, even more preferably 5 mol%, and particularly preferably 4 mol%. When the total amount is equal to or less than the upper limit, a decrease in heat resistance and mechanical strength of the resulting polyester film can be suppressed, thereby ensuring that there is no restriction on the amount of recycled polyester resin to be added. In one embodiment, the total amount is preferably 0.5 mol% or more and 7 mol% or less.

The recovered polyester resin may be used as a mixture with virgin polyester resin. When PET is blended with a polyester resin other than PET, bottle-recycled PET may be used as PET.

The polyester film may consist of two or more layers, and at least one layer may contain recovered polyester

resin.

The raw resin for polyester film (in particular, polyester resin) may contain a recovered polyester resin in an amount of 10 mass% or more, 30 mass% or more, 50 mass% or more, 70 mass% or more, 80 mass% or more, 90 mass% or more, or 95 mass% or more, and may be more than 95 mass%, 96 mass% or more, 97 mass% or more, or 100 mass%. Even in a masterbatch containing an ionic compound and an additive, such as a lubricant, in high concentrations, the recovered polyester resin contained in the masterbatch is calculated as recovered polyester resin.

When polyester film is produced using recovered polyester resin, the ionic compound can be added in the same manner as when polyester film is produced using virgin polyester resin. However, a method using masterbatch is preferable. The polyester resin in the masterbatch can be a virgin polyester resin, a recovered polyester resin, or a mixture of both. The polyester resin in the masterbatch may contain CR-PET.

Resin Other Than Polyester Resin

The resin other than polyester resin may be a resin that is either compatible or non-compatible with polyester resin. Examples of resins other than polyester resin include polystyrene; polycarbonate; polyolefins such as polypropylene, polymethylpentene, and polycycloolefin; polyamides such as nylon 6 and nylon 6,6; polyether amide; polyamide imide; polyimide; polyether imide; polysulfone; and thermoplastic resins such as polyethersulfone. These resins can be used singly or in a combination of two or more.

Ionic Compound

The ionic compound can control (e.g., reduce), for example, melt resistivity. The mechanism of controlling melt resistivity, is presumably as follows: when a voltage is applied, a cation and an anion that constitute the ionic compound migrate as ions within the raw resin in a molten state, resulting in a charge imbalance in the raw resin.

In present specification, the term "ionic compound" refers to a salt composed of a cation and an anion. Examples of ionic compounds include metal salts containing alkali metals, alkaline earth metals, transition metals (metals of Groups 3 to 11), and metals of Groups 12 to 16; and ionic liquids derived from a combination of an organic or inorganic cation with an organic or inorganic anion. Among them, ionic liquids are more preferable because they exhibit excellent dispersibility in the raw resin and allow melt resistivity of the raw resin to be controlled by adding only a small amount of such ionic liquids. Such ionic compounds can be used singly or in a combination of two or more. When two or more ionic compounds are used in combination, any of the following may be used: a combination of metal salts, a combination of ionic liquids, or a combination of a metal salt and an ionic liquid; however, a combination of ionic liquids or a combination of a metal salt and an ionic liquid is more preferable.

The amount (which can be paraphrased as the content) of the ionic compound added to the resin that constitutes the film is greater than 0 ppm by mass, preferably 0.01 ppm by mass or more, more preferably 0.1 ppm by mass or more, and even more preferably 0.5 ppm by mass or more, based on the mass of the raw resin (in particular, polyester resin). The amount of the ionic compound added is preferably 950 ppm by mass or less, more preferably 800 ppm by mass or less, and even more preferably 700 ppm by mass or less. In one embodiment, the amount of the ionic compound added is preferably 0.01 ppm by mass or more and 950 ppm by mass or less, more preferably 0.1 ppm by mass or more and 800 ppm by mass or less, and even more preferably 0.5 ppm by mass or more and 700 ppm by mass or less. Setting the amount of the ionic compound added within the range described above enables high levels of moldability and processability to be exhibited, while suppressing, for example, the generation of foreign matter. The amount of the ionic compound added may be 500 ppm by mass or less, 250 ppm by mass or less, or 150 ppm by mass or less. The amount of the ionic compound added may be less than 100 ppm by mass, 99 ppm by mass or less, 95 ppm by mass or less, 90 ppm by mass or less, 70 ppm by mass or less, 50 ppm by mass or less, 40 ppm by mass or less, 30 ppm by mass or less, 20 ppm by mass or less, or 10 ppm by mass or less. Further, it may be less than 10 ppm by mass, 9 ppm by mass or less, 8 ppm by mass or less, or 7 ppm by mass or less. The amount of the ionic compound added can be appropriately set according to the type of ionic compound and the value of the melt resistivity of the resin that constitutes the film.

By reducing the amount of the ionic compound added, various advantages can be obtained, such as making bleed-out of the ionic compound onto the film surface less likely to occur, thereby facilitating the suppression of contamination of the film production line, etc., and reducing time-dependent changes in adhesiveness to adhesives, coating layers, printing inks, and the like. Accordingly, taking into account compatibility with the resin, one approach is to select an ionic compound that can efficiently reduce the melt resistivity even when added in a small amount.

The relationship between the amount of ionic compound R added and the dissociation energy Q preferably satisfies the following equation (1) and/or equation (2).

$$R \leq 0.15 \times Q + 890 \quad (1)$$

$$R \leq -20 \times Q + 16000 \quad (2)$$

(In the formulas, R is the amount of the ionic compound added to the raw resin (ppm by mass), and Q is the dissociation energy (kJ/mol) of the anion and cation that constitute the ionic compound.)

When multiple ionic compounds are used in combination, R is defined as the total amount of the ionic compounds i ($R = \Sigma R_i$), and Q is defined as the sum of the products of the mass fraction of each ionic compound i relative to the total amount of all ionic compounds ($R_i$ / R) and the Q value of each ionic compound ($Q_i$) (i.e., $Q = \Sigma(R_i / R)Q_i$).

Equation (1) demonstrates that ionic compounds with low dissociation energy can more efficiently dissociate into cations and anions, and therefore are capable of exhibiting electrostatic chargeability even in small amounts. When R satisfies equation (1), the conductivity of the raw resin can be prevented from becoming too high, and sparks can be prevented from occurring when voltage is applied to the raw resin to charge the raw resin, thus enabling stable production. Furthermore, there is no risk that the raw resin will suffer damage such as scratches, pinholes, or breakage, which would otherwise make processing of the raw resin using charging difficult.

Equation (2) indicates that even when an ionic compound with lower dissociation energy is present in a large amount, the raw resin can have high clarity. It is presumed that an ionic compound having a high dissociation energy exhibits strong bonding between a cation and an anion, causing the ionic compound itself to aggregate to form foreign matter, thereby tending to reduce the clarity of the raw resin.

It is more preferable that the dissociation energy of the ionic compound and the amount added relative to the raw resin satisfy both the equation (1) and equation (2). In such a case, it becomes possible to provide a film having high clarity as well as excellent moldability and processability and a method for producing the film can be provided.

The dissociation energy Q (KJ/mol) of the anion and cation constituting the ionic compound is preferably 850 or less, more preferably 800 or less, even more preferably 700 or less, still even more preferably 600 or less, particularly preferably 500 or less, and most preferably 400 or less. The dissociation energy Q is not particularly limited as long as it is 0 or more, or more than 0. The lower limit is, for example, 10, and preferably 50, and may be 100, 150, 200, or 250. By setting the dissociation energy Q within the above range, the electrostatic dischargeabilty during melting of the raw resin is improved, thereby achieving excellent moldability and processability. This is considered to be due to the moderate weakening of ionic interactions, which facilitates dissociation into ions when a voltage is applied.

The absolute value of the average charge density (e/Å$^2$) of each of the anion and the cation constituting the ionic compound is preferably independently 0.0025 or more, more preferably 0.003 or more, even more preferably 0.0035 or more, and may be 0.0038 or more. The absolute value of the average charge density (e/Å$^2$) of each of the anion and cation is preferably independently 0.075 or less, more preferably 0.07 or less, and even more preferably 0.065 or less, and may be 0.06 or less, 0.05 or less, 0.04 or less, 0.03 or less, 0.02 or less, or 0.015 or less. In one embodiment, the absolute value of the average charge density of at least one of the anion and cation is preferably independently in the range of 0.0025 or more and 0.075 or less, more preferably 0.003 or more and 0.07 or less, and even more preferably 0.0035 or more and 0.065 or less. The absolute values of the average charge densities of both the anion and the cation are preferably in the range of 0.0025 or more and 0.075 or less, more preferably 0.003 or more and 0.07 or less, and even more preferably 0.0035 or more and 0.065 or less. Setting the absolute value of the average charge density (e/Å$^2$) of the ions within the above range improves the electrostatic chargeability of the raw resin during melting, thus achieving excellent moldability and processability. This is considered to be because the ionic interaction with the counterion is a factor influenced by the average charge density of the anion or cation, and by setting the absolute value of the average charge density within the above range, dissociation into ions is facilitated when a voltage is applied.

Further, the lower limit of the absolute value of the average charge density (e/Å$^2$) of the anion constituting the ionic compound may be 0.0038 or 0.004, whereas the upper limit thereof may be 0.015, 0.01, 0.0095, 0.009, or 0.008. In one embodiment, it is preferable that the absolute value of the average charge density of the anion constituting the ionic compound is 0.0038 or more and 0.015 or less.

The lower limit of the absolute value of the average charge density (e/Å$^2$) of the cation constituting the ionic compound may be 0.0038, 0.004, or 0.0045, whereas the upper limit thereof may be 0.02, 0.015, 0.0145, 0.013, 0.01, or 0.008. In one embodiment, the absolute value of the average charge density (e/Å$^2$) of the cation constituting the ionic compound is preferably 0.0038 or more and 0.015 or less.

Either the ionic radius of the anion constituting the ionic compound (which may also be referred to below as anion radius) or the ionic radius of the cation constituting the ionic compound (which may also be referred to below as cation radius) is preferably 1 Å or more, and more preferably 1.5 Å or more, and may be 2 Å or more. Either the anion radius or the cation radius is preferably 10 Å or less, more preferably 5 Å or less, and particularly preferably 4 Å or less. In one embodiment, it is preferable that the ionic radius of at least one of the anion and cation constituting the ionic compound (i.e., one of the anion radius and the cation radius) is 10 Å or less, more preferably 1 Å or more and 10 Å or less, and even more preferably 1.5 Å or more and 5 Å or less. It is also preferable that at least one of the anion and cation constituting the ionic compound (or either the anion radius or the cation radius) has a ionic radius of 2 Å or more. The ionic radius is a factor that affects the average charge density of ions. Setting the ionic radius within the above range improves the electrostatic

chargeability during melting, thus achieving excellent moldability and processability.

Both the anion radius and the cation radius are preferably within the above range. On the other hand, the lower limit of the anion radius may be 2.5Å, 2.6Å, 2.65Å, 2.7Å, 2.8Å, 2.9Å, or 3Å. In one embodiment, the anion radius is preferably 2.5 Å or more and 10 Å or less. The lower limit of the cation radius may be 1.4Å, 1.5Å, 1.7Å, 2Å, or 2.2Å. The upper limit of the cation radius may be 3.7Å or 3.5Å. In one embodiment, the cation radius is preferably 1.4 Å or more and 3.7 Å or less.

By selecting an ionic compounds with low dissociation energy and selecting, as constituents of the ionic compound, an cation and an anion with large ionic radii and small absolute values of average charge density, it becomes easier to adjust the molten resistivity to fall within an appropriate range even when the ionic compound is added in a reduced amount. The above-specified ionic compound is believed to exhibit good compatibility with the polyester resin due to the nature of the ions themselves, without being excessively constrained, thereby contributing to a stable reduction in melt resistivity and suppression of aggregation. Among them, it is preferable to select an ionic compound comprising a cation with a large ionic radius and/or a small absolute value of average charge density. Furthermore, by using an anion with a large ionic radius and/or a small absolute value of average charge density, it becomes easier to suppress the formation of foreign matter even when a metal such as magnesium or calcium is used as the cation.

The anion radius, cation radius, average charge density of the anion, and average charge density of the cation can be calculated by the following procedures using, for example, the quantum chemistry calculation software "Gaussian 16" by the COSMO method.

First, structure optimization of the anion and cation is performed in a vacuum. The structural optimization is carried out by the density functional theory (DFT) method. BVP86 is used as the functional, TZVP as the basis set, and DGA1 as the fitting basis set. The keyword "opt" is specified.

Next, based on the structure optimized in vacuum, structural optimization is performed under conditions where the molecular surface is shielded by a conductor. The same DFT method, functional, basis set, and fitting basis set as those used in the vacuum phase are used for the structural optimization. As a keyword, opt scrf=(cpcm, read) is specified. Further, radii=klamt is specified as an additional option.

Next, based on the structure optimized under conductor-shielded conditions, the COSMO method is used. The same DFT method, functional, basis set, and fitting basis set as those used in the vacuum calculations are used in the COSMO method. By specifying scRF=cosmors as a keyword, a file containing charge information when the surface of the molecule is shielded with a conductor is output.

The anion radius and cation radius are calculated by approximating the molecular shape as a sphere, based on the volume recorded in the file output by the COSMO method.

The average charge density of the anion and the average charge density of the cation can be calculated by dividing the charge of each ion by its corresponding surface area, as recorded in the files output by the COSMO method. When necessary, unit conversion was performed using 1 Bohr = 0.529117 Å.

The dissociation energy is calculated as the difference between the sum of the energies of the anion and cation constituting the ionic compound and the energy of the ionic compound itself.

(Dissociation energy) = (Energy of anion) + (Energy of cation) - (Energy of ionic compound)

The energies of the anion, cation, and ionic compound are calculated using the total energy obtained from structure optimization in vacuum. Density Functional Theory (DFT) is used for structure optimization. BVP86 is used as the functional, TZVP as the basis set, and DGA1 as the fitting basis set. As a keyword, "opt" is specified. The dissociation energy is calculated using the energy obtained upon completion of the structural optimization.

In one embodiment, the ionic compound is a metal salt. The metal salt preferably contains an alkali metal and/or an alkaline earth metal. Examples of alkali metals include lithium, sodium, and potassium. Examples of alkaline earth metals include magnesium, calcium, and barium. These can be used singly or in a combination of two or more.

When a metal salt is used as an ionic compound, it is preferable that the total amount of metal (in particular, alkali metal and alkaline earth metal) contained in the resin, such as polyester resin, be 80 ppm by mass or less, more preferably 70 ppm by mass or less, 60 ppm by mass or less, 50 ppm by mass or less, 40 ppm by mass or less, 30 ppm by mass or less, 20 ppm by mass or less, 10 ppm by mass or less, and 5 ppm by mass or less in ascending order of preference. Furthermore, the total amount may be 0 mass% (below the detection limit).

Examples of the form of the metal salt include hydroxide, aliphatic carboxylates (such as acetate and butyrate, preferably acetate), aromatic carboxylates, and salts with compounds having hydroxyl groups (such as salts with a phenol). These may be used singly or in a combination of two or more.

In one embodiment, the ionic compound preferably contains at least one compound that is in the form of a liquid at 100°C and 1 atm, in particular, an ionic liquid. In the present specification, the term "ionic liquid" refers to a salt that becomes liquid at relatively low temperatures compared to typical inorganic salts and that has a melting point of 100°C or

lower. The ionic liquids is characterized not only by its non-volatility and low viscosity, but also by its excellent solubility for both organic and inorganic compounds, due to its high polarity based on its aprotic ionic structure. As methods for synthesizing an ionic liquid, methods such as anion exchange, acid esterification, and neutralization can be used.

The anion constituting the ionic compound may be either an inorganic anion or an organic anion, and is not particularly limited. Specific examples of usable anion species include $Cl^-$, $Br^-$, $I^-$, $AlCl_4^-$, $Al_2Cl_7^-$, $BF_4^-$, $PF_6^-$, $ClO_4^-$, $NO_3^-$, $CH_3COO^-$ (abbreviated as AA), $CF_3COO^-$, $CH_3SO_3^-$, $CF_3SO_3^-$, $C_4F_9SO_3^-$, $(CF_3SO_2)_2N^-$, $(C_2F_5SO_2)_2N^-$, $(C_3F_7SO_2)_2N^-$, $(C_4F_9SO_2)_2N^-$, $(CF_3SO_2)_3C^-$, $AsF_6^-$ $SbF_6^-$, $NbF_6^-$, $TaF_6^-$, $F(HF)_n^-$ (n is an integer of 1 or more, for example an integer of 1 to 5), $(CN)_2N^-$ (abbreviated as DCA), $C_4F_9SO_3^-$, $(C_2F_5SO_2)_2N^-$, $C_2F_7COO^-$, $(CF_3SO_2)(CF_3CO)N^-$, $C_9H_{19}COO^-$, $(CH_3)_2PO_4^-$ (abbreviated as DMP), $(C_2H_5)_2PO_4^-$, $C_2H_5OSO_3^-$, $C_6H_{13}OSO_3^-$, $C_8H_{17}OSO_3^-$, $CH_3(OC_2H_4)_2OSO_3^-$, $C_6H_4(CH_3)SO_3^-$, $(C_2F_5)_3PF_3^-$, $CH_3CH(OH)COO^-$, and $(FSO_2)_2N^-$. Among them, $(CF_3SO_2)_2N^-$ (abbreviated as TFSI) and $(FSO_2)N^-$ (abbreviated as FSI) are preferred due to their large ionic radii, low absolute values of the average charge density, and excellent electrostatic chargeability.

The cation constituting the ionic compound is not particularly limited. However, organic compound cations are preferred because they can increase the ionic radius and reduce the absolute value of the average charge density. By using an organic compound cation, it is possible to enlarge the cation radius (e.g., to 2 Å or more) and reduce the absolute value of the average charge density (e.g., to 0.015 e/Å$^2$ or less). Among organic compound cations, nitrogen-containing compound cations are particularly preferred. Preferable examples of nitrogen-containing compound cations include at least one selected from the group consisting of (1) to (16) below.

(1) Pyridinium cations such as 1-ethylpyridinium cation, 1-butylpyridinium cation, 1-hexylpyridinium cation, 1-butyl-3-methylpyridinium cation, 1-butyl-4-methylpyridinium cation, 1-hexyl-3-methylpyridinium cation, and 1-butyl-3,4-dimethylpyridinium cation;

(2) pyrrolidinium cations such as 1,1-dimethylpyrrolidinium cation, 1-ethyl-1-methylpyrrolidinium cation, 1-methyl-1-propylpyrrolidinium cation, 1-methyl-1-butylpyrrolidinium cation, 1-methyl-1-pentylpyrrolidinium cation, 1-methyl-1-hexylpyrrolidinium cation, 1-methyl-1-heptylpyrrolidinium cation, 1-ethyl-1-propylpyrrolidinium cation, 1-ethyl-1-butylpyrrolidinium cation, 1-ethyl-1-pentylpyrrolidinium cation, 1-ethyl-1-hexylpyrrolidinium cation, 1-ethyl-1-heptylpyrrolidinium cation, 1,1-dipropylpyrrolidinium cation, 1-propyl-1-butylpyrrolidinium cation, 1,1-dibutylpyrrolidinium cation, and pyrrolidinium-2-one cation;

(3) piperidinium cations such as 1-propylpiperidinium cation, 1-pentylpiperidinium cation, 1,1-dimethylpiperidinium cation, 1-methyl-1-ethylpiperidinium cation, 1-methyl-1-propylpiperidinium cation, 1-methyl-1-butylpiperidinium cation, 1-methyl-1-pentylpiperidinium cation, 1-methyl-1-hexylpiperidinium cation, 1-methyl-1-heptylpiperidinium cation, 1-ethyl-1-propylpiperidinium cation, 1-ethyl-1-butylpiperidinium cation, 1-ethyl-1-pentylpiperidinium cation, 1-ethyl-1-hexylpiperidinium cation, 1-ethyl-1-heptylpiperidinium cation, 1,1-dipropylpiperidinium cation, 1-propyl-1-butylpiperidinium cation, and 1,1-dibutylpiperidinium cation;

(4) pyrrolinium cations such as 2-methyl-1-pyrrolinium cation;

(5) indium cations such as 1-ethyl-2-phenylindolium cation and 1,2-dimethylindolium cation;

(6) carbazolium cations such as 1-ethylcarbazolium cation;

(7) morpholinium cations such as N-ethyl-N-methyl cation;

(8) imidazolium cations such as 1,3-dimethylimidazolium cation, 1,3-diethylimidazolium cation, 1-ethyl-3-methylimidazolium cation, 1-butyl-3-methylimidazolium cation, 1-hexyl-3-methylimidazolium cation, 1-octyl-3-methylimidazolium cation, 1-decyl-3-methylimidazolium cation, 1-dodecyl-3-methylimidazolium cation, 1-tetradecyl-3-methylimidazolium cation, 1,2-dimethyl-3-propylimidazolium cation, 1-ethyl-2,3-dimethylimidazolium cation, 1-butyl-2,3-dimethylimidazolium cation, 1-hexyl-2,3-dimethylimidazolium cation, 1-(2-methoxyethyl)-3-methylimidazolium cation, and 1-allyl-3-methylimidazolium cation;

(9) tetrahydropyrimidinium cations such as 1,3-dimethyl-1,4,5,6-tetrahydropyrimidinium cation, 1,2,3-trimethyl-1,4,5,6-tetrahydropyrimidinium cation, 1,2,3,4-tetramethyl-1,4,5,6-tetrahydropyrimidinium cation, and 1,2,3,5-tetramethyl-1,4,5,6-tetrahydropyrimidinium cation;

(10) dihydropyrimidinium cations such as 1,3-dimethyl-1,4-dihydropyrimidinium cation, 1,3-dimethyl-1,6-dihydropyrimidinium cation, 1,2,3-trimethyl-1,4-dihydropyrimidinium cation, 1,2,3-trimethyl-1,6-dihydropyrimidinium cation, 1,2,3,4-tetramethyl-1,4-dihydropyrimidinium cation, and 1,2,3,4-tetramethyl-1,6-dihydropyrimidinium cation;

(11) pyrazolium cations such as 1-methylpyrazolium cation, 2-methylpyrazolium cation, 3-methylpyrazolium cation, 1-ethyl-2-methylpyrazolium cation, 1-ethyl-2,3,5-trimethylpyrazolium cation, 1-propyl-2,3,5-trimethylpyrazolium cation, and 1-butyl-2,3,5-trimethylpyrazolium cation;

(12) pyrazolinium cations such as 1-ethyl-2,3,5-trimethylpyrazolinium cation, 1-propyl-2,3,5-trimethylpyrazolinium cation, and 1-butyl-2,3,5-trimethylpyrazolinium cation;

(13) tetraalkylammonium cations such as tetramethylammonium cation, tetraethylammonium cation, tetrabutylammonium cation, tetrapentylammonium cation, tetrahexylammonium cation, and tetraheptylammonium cation;

(14) trialkylsulfonium cations such as trimethylsulfonium cation, triethylsulfonium cation, tributylsulfonium cation,

trihexylsulfonium cation, diethylmethylsulfonium cation, dibutylethylsulfonium cation, and dimethyldecylsulfonium cation;

(15) tetralkylphosphonium cations such as tetramethylphosphonium cation, tetraethylphosphonium cation, tetrabutylphosphonium cation, tetrahexylphosphonium cation, tetraoctylphosphonium cation, triethylmethylphosphonium cation, tributylethylphosphonium cation, trimethyldecylphosphonium cation, diaryldimethylammonium cation, and tributyl-(2-methoxyethyl)phosphonium cation; and

(16) tetraalkylammonium cations such as N,N-diethyl-N-methyl-N-(2-methoxyethyl)ammonium cation, glycidyltrimethylammonium cation, diallyldimethylammonium cation, N,N-dimethyl-N-ethyl-N-propylammonium cation, N,N-dimethyl-N-ethyl-N-butylammonium cation, N,N-dimethyl-N-ethyl-N-pentylammonium cation, N,N-dimethyl-N-ethyl-N-hexylammonium cation, N,N-dimethyl-N-ethyl-N-heptylammonium cation, N,N-dimethyl-N-ethyl-N-nonylammonium cation, N,N-dimethyl-N,N-dipropylammonium cation, N,N-dimethyl-N-propyl-N-butylammonium cation, N,N-diethyl-N-propyl-N-butylammonium cation, N,N-dimethyl-N-propyl-N-pentylammonium cation, N,N-dimethyl-N-propyl-N-hexylammonium cation, N,N-dimethyl-N-propyl-N-heptylammonium cation, N,N-dimethyl-N-butyl-N-hexylammonium cation, N,N-dimethyl-N-butyl-N-heptylammonium, N,N-diethyl-N-butyl-N-heptylammonium cation, N,N-dimethyl-N-pentyl-N-hexylammonium cation, N,N-dimethyl-N,N-dihexyammonium cation, trimethylheptylammonium cation, N,N-diethyl-N-methyl-N-propylammonium cation, N,N-diethyl-N-methyl-N-pentylammonium cation, N,N-diethyl-N-methyl-N-heptylammonium cation, N,N-diethyl-N-propyl-N-pentylammonium cation, trimethyldecylammonium cation, triethylmethylammonium cation, triethylpropylammonium cation, triethylpentylammonium cation, triethylheptylammonium cation, tributylethylammonium cation, N,N-dipropyl-N-methyl-N-ethylammonium cation, N,N-dipropyl-N-methyl-N-pentylammonium cation, N,N-dipropyl-N-butyl-N-hexylammonium cation, N,N-dipropyl-N,N-dihexyammonium cation, N,N-dibutyl-N-methyl-N-pentylammonium cation, N,N-dibutyl-N-methyl-N-hexylammonium cation, trioctylmethylammonium cation, and N-methyl-N-ethyl-N-propyl-N-pentylammonium cation.

In the above, the alkyl group is preferably $C_1$-$C_{10}$ alkyl, and may be $C_1$-$C_8$ alkyl, $C_1$-$C_6$ alkyl, $C_1$-$C_4$ alkyl, $C_1$-$C_3$ alkyl, or $C_1$ or $C_2$ alkyl. Among those mentioned above, imidazolium cations such as 1-ethyl-3-methylimidazolium cation (abbreviated as EMIM), 1,3-dimethylimidazolium cation (abbreviated as MMIM), and 1-allyl-3-methylimidazolium cation (abbreviated as AMIM) are preferred, and pyrrolidinium cations such as 1-(2-methoxyethyl)-1-methylpyrrolidinium cation (abbreviated as MEMP) are particularly preferred from the standpoint of high thermal stability.

Specific examples of ionic compounds include suitable combinations of the above-mentioned cations and anions, such as 1-butylpyridinium tetrafluoroborate, 1-butylpyridinium hexafluorophosphate, 1-butyl-3-methylpyridinium tetrafluoroborate, 1-butyl-3-methylpyridinium trifluoromethanesulfonate, 1-butyl-3-methylpyridinium bis (trifluoromethanesulfonyl) imide, 1-butyl-3-methylpyridinium bis(pentafluoroethanesulfonyl)imide, 1-hexylpyridinium tetrafluoroborate, 1,1-dimethylpyrolydinium bis(trifluoromethanesulfonyl)imide, 1-methyl-1-ethylpyrolydinium bis(trifluoromethanesulfonyl)imide, 1-methyl-1-propylpyrolydinium bis(trifluoromethanesulfonyl)imide, 1-methyl-1-butylpyrolydinium bis(trifluoromethanesulfonyl)imide, 1-methyl-1-pentylpyrolydinium bis(trifluoromethanesulfonyl)imide, 1-methyl-1-hexylpyrolydinium bis(trifluoromethanesulfonyl)imide, 1-methyl-1-heptylpyrolydinium bis(trifluoromethanesulfonyl)imide, 1-ethyl-1-propylpyrolydinium bis(trifluoromethanesulfonyl)imide, 1-ethyl-1-butylpyrolydinium bis(trifluoromethanesulfonyl)imide, 1-ethyl-1-pentylpyrolydinium bis(trifluoromethanesulfonyl)imide, 1-ethyl-1-hexylpyrolydinium bis(trifluoromethanesulfonyl)imide, 1-ethyl-1-heptylpyrolydinium bis(trifluoromethanesulfonyl)imide, 1,1-dipropylpyrolydinium bis(tripleomethanesulfonyl)imide, 1-propyl-1-butylpyrolydinium bis(trifluoromethanesulfonyl)imide, 1,1-dibutylpyrolydinium bis(tripleomethanesulfonyl)imide, 1-propylpiperidinium bis(trifluoromethanesulfonyl)imide, 1-pentylpiperidinium bis(trifluoromethanesulfonyl)imide, 1,1-dimethylpiperidinium bis(trifluoromethanesulfonyl)imide, 1-methyl-1-ethylpiperidinium bis(trifluoromethanesulfonyl)imide, 1-methyl-1-propylpiperidinium bis(trifluoromethanesulfonyl)imide, 1-methyl-1-butylpiperidinium bis(trifluoromethanesulfonyl)imide, 1-methyl-1-pentylpiperidinium bis(trifluoromethanesulfonyl)imide, 1-methyl-1-hexylpiperidinium bis(trifluoromethanesulfonyl)imide, 1-methyl-1-heptylpiperidinium bis(trifluoromethanesulfonyl)imide, 1-ethyl-1-propylpiperidinium bis(trifluoromethanesulfonyl)imide, 1-ethyl-1-butylpiperidinium bis(trifluoromethanesulfonyl)imide, 1-ethyl-1-pentylpiperidinium bis(trifluoromethanesulfonyl)imide, 1-ethyl-1-hexylpiperidinium bis(trifluoromethanesulfonyl)imide, 1-ethyl-1-heptylpiperidinium bis(trifluoromethanesulfonyl)imide, 1,1-dipropylpiperidinium bis(trifluoromethanesulfonyl)imide, 1-propyl-1-butylpiperidinium bis(trifluoromethanesulfonyl)imide, 1,1-dibutylpiperidinium bis(trifluoromethanesulfonyl)imide, 1,1-dimethylpyrolydinium bis(pentafluoroethanesulfonyl)imide, 1-methyl-1-ethylpyrolydinium bis(pentafluoroethanesulfonyl)imide, 1-methyl-1-propylpyrolydinium bis(pentafluoroethanesulfonyl)imide, 1-methyl-1-butylpyrolydinium bis(pentafluoroethanesulfonyl)imide, 1-methyl-1-pentylpyrolydinium bis(pentafluoroethanesulfonyl)imide, 1-methyl-1-hexylpyrolydinium bis(pentafluoroethanesulfonyl)imide, 1-methyl-1-heptylpyrolydinium bis(pentafluoroethanesulfonyl)imide, 1-ethyl-1-propylpyrolydinium bis(pentafluoroethanesulfonyl) imide, 1-ethyl-1-butylpyrolydinium bis(pentafluoroethanesulfonyl)imide, 1-ethyl-1-pentylpyrolydinium bis(pentafluoroethanesulfonyl)imide, 1-ethyl-1-hexylpyrolydinium bis(pentafluoroethanesulfonyl)imide, 1-ethyl-1-heptylpyrolydinium bis(pentafluoroethanesulfonyl)imide, 1,1-dipropylpyrolydinium bis(pentafluoroethanesulfonyl)imide, 1-propyl-1-butylpyrolydinium bis(pentafluoroethanesulfonyl)imide, 1,1-dibutylpyrolydinium bis(pentafluoroethanesulfonyl)imide, 1-pro-

pylpiperidinium bis(pentafluoroethanesulfonyl)imide, 1-pentylpiperidinium bis(pentafluoroethanesulfonyl)imide, 1,1-dimethylpiperidinium bis(pentafluoroethanesulfonyl)imide, 1-methyl-1-ethylpiperidinium bis(pentafluoroethanesulfonyl) imide, 1-methyl-1-propylpiperidinium bis(pentafluoroethanesulfonyl)imide, 1-methyl-1-butylpiperidinium bis(pentafluoroethanesulfonyl)imide, 1-methyl-1-pentylpiperidinium bis(pentafluoroethanesulfonyl)imide, 1-methyl-1-hexylpiperidinium bis(pentafluoroethanesulfonyl)imide, 1-methyl-1-heptylpiperidinium bis(pentafluoroethanesulfonyl)imide, 1-ethyl-1-propylpiperidinium bis(pentafluoroethanesulfonyl)imide, 1-ethyl-1-butylpiperidinium bis(pentafluoroethanesulfonyl)imide, 1-ethyl-1-pentylpiperidinium bis(pentafluoroethanesulfonyl)imide, 1-ethyl-1-hexylpiperidinium bis(pentafluoroethanesulfonyl)imide, 1-ethyl-1-heptylpiperidinium bis(pentafluoroethanesulfonyl)imide, 1,1-dipropylpiperidinium bis(pentafluoroethanesulfonyl)imide, 1-propyl-1-butylpiperidinium bis(pentafluoroethanesulfonyl)imide, 1,1-dibutylpiperidinium bis(pentafluoroethanesulfonyl)imide, 2-methyl-1-pyrolyum tetrafluoroborate, 1-ethyl-2-phenylindolium tetrafluoroborate, 1,2-dimethylindolium tetrafluoroborate, 1-ethylcarbazolium tetrafluoroborate, 1-ethyl-3-methylimidazolium tetrafluoroborate, 1-ethyl-3-methylimidazolium acetate, 1-ethyl-3-methylimidazolium trifluoroacetate, 1-ethyl-3-methylimidazolium heptafluorobutyrate, 1-ethyl-3-methylimidazolium trifluoromethanesulfonate, 1-ethyl-3-methylimidazolium perfluorobutanesulfonate, 1-ethyl-3-methylimidazolium dicyanamide, 1-ethyl-3-methylimidazolium bis(trifluoromethanesulfonyl)imide, 1-ethyl-3-methylimidazolium bis(pentafluoroethanesulfonyl)imide, 1-ethyl-3-methylimidazolium tris(trifluoromethanesulfonyl)methide, 1-butyl-3-methylimidazolium tetrafluoroborate, 1-butyl-3-methylimidazolium hexafluorophosphate, 1-butyl-3-methylimidazolium trifluoroacetate, 1-butyl-3-methylimidazolium heptafluorobutyrate, 1-butyl-3-methylimidazolium trifluoromethanesulfonate, 1-butyl-3-methylimidazolium perfluorobutanesulfonate, 1-butyl-3-methylimidazolium bis(trifluoromethanesulfonyl)imide, 1-hexyl-3-methylimidazolium bromide, 1-hexyl-3-methylimidazolium chloride, 1-hexyl-3-methylimidazolium tetrafluoroborate, 1-hexyl-3-methylimidazolium hexafluorophosphate, 1-hexyl-3-methylimidazolium trifluoromethanesulfonate, 1-octyl-3-methylimidazolium tetrafluoroborate, 1-octyl-3-methylimidazolium hexafluorophosphate, 1-hexyl-2,3-dimethylimidazolium tetrafluoroborate, 1,2-dimethyl-3-propylimidazolium bis(trifluoromethanesulfonyl)imide, 1-methylpyrazolium tetrafluoroborate, 2-methylpyrazolium tetrafluoroborate, 1-ethyl-2,3,5-trimethylpyrazolium bis(trifluoromethanesulfonyl)imide, 1-propyl-2,3,5-trimethylpyrazolium bis(trifluoromethanesulfonyl)imide, 1-butyl-2,3,5-trimethylpyrazolium bis(trifluoromethanesulfonyl)imide, 1-ethyl-2,3,5-trimethylpyrazolium bis(pentafluoroethanesulfonyl)imide, 1-propyl-2,3,5-trimethylpyrazolium bis(pentafluoroethanesulfonyl)imide, 1-butyl-2,3,5-trimethylpyrazolium bis(pentafluoroethanesulfonyl)imide, 1-ethyl-2,3,5-trimethylpyrazolium bis(trifluoromethanesulfonyl) trifluoroacetamide, 1-propyl-2,3,5-trimethylpyrazolium bis(trifluoromethanesulfonyl) trifluoroacetamide, 1-butyl-2,3,5-trimethylpyrazolium bis(trifluoromethanesulfonyl) trifluoroacetamide, 1-ethyl-2,3,5-trimethylpyrazolinium bis(trifluoromethanesulfonyl)imide, 1-propyl-2,3,5-trimethylpyrazolinium bis(trifluoromethanesulfonyl)imide, 1-butyl-2,3,5-trimethylpyrazolinium bis(trifluoromethanesulfonyl)imide, 1-ethyl-2,3,5-trimethylpyrazolinium bis(pentafluoroethanesulfonyl)imide, 1-propyl-2,3,5-trimethylpyrazolinium bis(pentafluoroethanesulfonyl)imide, 1-butyl-2,3,5-trimethylpyrazolinium bis(pentafluoroethanesulfonyl)imide, 1-ethyl-2,3,5-trimethylpyrazolinium bis(trifluoromethanesulfonyl) trifluoroacetamide, 1-propyl-2,3,5-trimethylpyrazolinium bis(trifluoromethanesulfonyl) trifluoroacetamide, 1-butyl-2,3,5-trimethylpyrazolinium bis(trifluoromethanesulfonyl) trifluoroacetamide, tetrapentylammonium trifluoromethanesulfonate, tetrapentylammonium bis(trifluoromethanesulfonyl)imide, tetrahexylammonium trifluoromethanesulfonate, tetrahexylammonium bis(trifluoromethanesulfonyl)imide, tetrabutylammonium trifluoromethanesulfonate, tetrabutylammonium bis(trifluoromethanesulfonyl)imide, diallyldimethylammonium tetrafluoroborate, diallyldimethylammonium trifluoromethanesulfonate, diallyldimethylammonium bis(trifluoromethanesulfonyl)imide, diallyldimethylammonium bis(pentafluoroethanesulfonyl)imide, N,N-diethyl-N-methyl-N-(2-methoxyethyl)ammonium tetrafluoroborate, N,N-diethyl-N-methyl-N-(2-methoxyethyl)ammonium trifluoromethanesulfonate, N,N-diethyl-N-methyl-N-(2-methoxyethyl) ammonium bis(trifluoromethanesulfonyl)imide, N,N-diethyl-N-methyl-N-(2-methoxyethyl)ammonium bis(pentafluoroethanesulfonyl)imide, glycidyltrimethylammonium trifluoromethanesulfonate, glycidyltrimethylammonium bis(trifluoromethanesulfonyl)imide, glycidyltrimethylammonium bis(pentafluoroethanesulfonyl)imide, tetraoctlphosphonium trifluoromethanesulfonate, tetraoctlphosphonium bis(trifluoromethanesulfonyl)imide, N,N-dimethyl-N-ethyl-N-propylammonium bis(trifluoromethanesulfonyl)imide, N,N-dimethyl-N-ethyl-N-butylammonium bis(trifluoromethanesulfonyl)imide, N,N-dimethyl-N-ethyl-N-pentylammonium bis(trifluoromethanesulfonyl)imide, N,N-dimethyl-N-ethyl-N-hexylammonium bis(trifluoromethanesulfonyl)imide, N,N-dimethyl-N-ethyl-N-heptylammonium bis(trifluoromethanesulfonyl)imide, N,N-dimethyl-N-ethyl-N-nonylammonium bis(trifluoromethanesulfonyl)imide, N,N-dimethyl-N,N-dipropylammonium bis(trifluoromethanesulfonyl)imide, N,N-dimethyl-N-propyl-N-butylammonium bis(trifluoromethanesulfonyl)imide, N,N-dimethyl-N-propyl-N-pentylammonium bis(trifluoromethanesulfonyl)imide, N,N-dimethyl-N-propyl-N-hexylammonium bis(trifluoromethanesulfonyl)imide, N,N-dimethyl-N-propyl-N-heptylammonium bis(trifluoromethanesulfonyl)imide, N,N-dimethyl-N-butyl-N-hexylammonium bis(trifluoromethanesulfonyl)imide, N,N-dimethyl-N-butyl-N-heptylammonium bis(trifluoromethanesulfonyl)imide, N,N-dimethyl-N-pentyl-N-hexylammonium bis(trifluoromethanesulfonyl)imide, N,N-dimethyl-N,N-dihexylammonium bis(trifluoromethanesulfonyl)imide, trimethylheptylammonium bis(trifluoromethanesulfonyl)imide, N,N-diethyl-N-methyl-N-propylammonium bis(trifluoromethanesulfonyl)imide, N,N-diethyl-N-methyl-N-pentylammonium bis(trifluoromethanesulfonyl)imide, N,N-diethyl-N-methyl-N-heptylammonium bis(trifluoromethanesulfonyl)imide, N,N-diethyl-N-propyl-N-pentylammonium bis(trifluoromethanesulfonyl)imide, triethylpropylammonium bis(tri-

fluoromethanesulfonyl)imide, triethylpentylammonium bis(trifluoromethanesulfonyl)imide, triethylheptylammonium bis(trifluoromethanesulfonyl)imide, N,N-dipropyl-N-methyl-N-ethylammonium bis(trifluoromethanesulfonyl)imide, N,N-dipropyl-N-methyl-N-pentylammonium bis (trtrifluoromethanesulfonyl) imide, N,N-dipropyl-N-butyl-N-hexylammonium bis(trifluoromethanesulfonyl)imide, N,N-dipropyl-N,N-dihexylammonium bis(trifluoromethanesulfonyl)imide, N,N-dibutyl-N-methyl-N-pentylammonium bis(trifluoromethanesulfonyl)imide, N,N-dibutyl-N-methyl-N-hexylammonium bis(trifluoromethanesulfonyl)imide, trioctylmethylammonium bis(trifluoromethanesulfonyl)imide, N-methyl-N-ethyl-N-propyl-N-pentylammonium bis(trifluoromethanesulfonyl)imide, 1-butylpyridinium (trifluoromethanesulfonyl) trifluoroacetamide, 1-butyl-3-methylpyridinium (trifluoromethanesulfonyl) trifluoroacetamide, 1-ethyl-3-methylimidazolium (trifluoromethanesulfonyl) trifluoroacetamide, N-ethyl-N-methylmorpholinium thiocyanate, and 4-ethyl-4-methylmorpholinium methyl carbonate. These ionic compounds may be used alone, or in a combination of two or more. Among these, from the viewpoint of exhibiting excellent melt resistivity, the ionic compound is preferably a combination of an imidazolium cation with a bis(trifluoromethanesulfonyl)imide anion (abbreviated as TFSI) or bis(fluorosulfonyl)imide anion (abbreviated as FSI), or a combination of a pyrrolidinium cation with TFSI or FSI, more preferably a combination of an imidazolium cation with TFSI or FSI, particularly preferably a combination of 1,3-dialkylimidazolium cations with TFSI or FSI, and most preferably a combination of 1-ethyl-3-methylimidazolium cation (abbreviated as EMIM) with bis(trifluoromethanesulfonyl)imide (abbreviated as TFSI) .

The ionic compound content of the polyester film and the ionic compound content of the masterbatch described below can be measured, for example, by liquid chromatography-mass spectrometry. Since the cation and anion of the ionic compound may differ in terms of decomposability and volatility, the content of the ionic compound in the polyester film can be defined as the total amount of the detected cation and anion. The preferred content of the ionic compound in the polyester film is the same as described above.

The method for adding the ionic compound includes, for example, the following methods (A) to (C).

(A) Method for Adding the Ionic Compound to the Raw Resin (in Particular, Polyester Resin) Beforehand

The method (A) is, for example, a method of adding an ionic compound during the polymerization of a polyester resin. The timing of the addition may be before the start of the esterification reaction, during the reaction, or after the completion of the reaction. When the ionic acid is added during the esterification reaction, it is preferable from the viewpoint of ensuring uniformity to add the compound after the esterification reaction rate has reached 95% or more, and more preferably 97% or more.

When the ionic compound is added, the ionic compound may be dissolved in a solvent (such as water or an organic solvent, such as ethylene glycol) and then added, from the viewpoint of supply accuracy. The organic solvent to be used is not particularly limited, but may be selected, for example, from the following solvents in consideration of factors such as the solubility of the ionic compound, compatibility with the raw resin, and reactivity with the raw resin: aromatic solvents such as toluene and xylene; aliphatic solvents such as hexane, heptane, and octane; alcohol solvents such as methanol, ethanol, propanol, butanol, and benzyl alcohol; glycol solvents such as ethylene glycol; ketone solvents such as acetone, methyl ethyl ketone, methyl isobutyl ketone, cyclohexanone, and cyclopentanone; ether solvents such as diethyl ether and tetrahydrofuran; ester solvents such as methyl acetate, ethyl acetate, and butyl acetate; amide solvents such as N,N-dimethylformamide, N,N-dimethylacetamide, N,N-dimethylpropionamide, 1,3-dimethylimidazolidinone, N-methyl-2-pyrrolidone, and N-ethyl-2-pyrrolidone; lactone solvents such as γ-butyrolactone; and phenol solvents such as phenol. Among them, ketone-based solvents such as methyl ethyl ketone and acetone; alcohol-based solvents such as methanol and ethanol; and glycol-based solvents such as ethylene glycol are preferred from the standpoint of solubility of the ionic compound. In addition, when the polycondensation process is carried out in the presence of the ionic compound, these solvents are also preferred because they do not interfere with the polycondensation reaction. These solvents can be used singly or in a combination of two or more.

After the raw material resin (in particular, polyester resin) is produced, the ionic compound may be added during the period after chipping and before melt-kneading to form a polyester film. The method can be, for example, a method of adding the ionic compound during the period between chipping the raw resin (in particular, polyester resin) and drying the raw resin (in particular, immediately before drying). In this case as well, it is preferable to dissolve the ionic compound in a solvent (such as water or an organic solvent) and then add the ionic compound. The solvent is preferably one having a boiling point of not higher than the drying temperature (for example, 135°C or lower).

(B) Method of Melt-Kneading Raw Resin (in Particular, Polyester Resin) and Adding Ionic Compound

In Method (B), as well as in Method (A), the ionic compound is preferably added in the state of being dissolved in a solvent (e.g., water or an organic solvent). Method (B) also includes a method of adding the ionic compound to the raw resin melt-kneaded during the film formation.

(C) Method for Blending a First Raw Resin Composition (e.g., a Polyester Resin Composition) Containing an Ionic Compound

(Particularly at a High Concentration) with a Second Raw Resin (e.g., a Polyester Resin) or a Second Raw Resin Composition (e.g., a Polyester Resin Composition) that Contains No Ionic Compound or Contains an Ionic Compound at a Lower Concentration than the First Composition, or that Has a Higher Melt Resistivity Than the First Raw Resin Composition, or that Has a Melt Resistivity of $1\times10^8$ Ω·cm or More

The above method (C) is explained in more detail.

In the following explanation, one example of the first raw resin composition that is a polyester resin composition comprising a polyester resin and an ionic compound having an anion-cation dissociation energy (Q) of 850 kJ/mol or less is referred to as polyester resin composition A. The polyester resin used in the polyester resin composition A is referred to as polyester resin A. A polyester resin that is one example of the second raw resin and that has a melt resistivity higher than that of the polyester resin composition A (or a melt resistivity of $1 \times 10^8$ Ω·cm or more) is referred to as polyester resin B.

In one embodiment, the above method (C) preferably includes a step of mixing (in particular, melt-mixing) a polyester resin composition A containing polyester resin A and an ionic compound having an anion-cation dissociation energy Q of 850 kJ/mol or less with a polyester resin B having a higher melt resistivity than the polyester resin composition A (or having a melt resistivity of $1 \times 10^8$ Ω·cm or more). In this method, the polyester resin B preferably has a high melt resistivity and low electrostatic adhesion. Mixing the polyester resin B with the polyester resin composition A containing an ionic compound can reduce melt resistivity, thereby achieving excellent electrostatic adhesion.

Polyester Resin Composition A

The polyester resin composition A may be referred to as the ionic compound masterbatch or electrostatic adhesion agent masterbatch, or simply referred to as the masterbatch (MB).

Polyester resin A is preferably selected from the polyester resins mentioned above, specifically selected from PET, PEN, PTT, PBT, PCT, PEF, PLA, PBS, PBSA, PBSL, PBAT, and PES. Polyester resin A and polyester resin B are preferably polyester resins that have the same main polymer components (dicarboxylic acid components and glycol components and/or hydroxycarboxylic acid components), but the components do not need to be strictly identical. When the total amount of polymer components (dicarboxylic acid components and glycol components and/or hydroxycarboxylic acid components) in the polyester resin is defined as 100 mol%, the total amount of polymer components that are different between polyester resin A and polyester resin B is preferably 7 mol% or less, more preferably 5 mol% or less, even more preferably 3 mol% or less, and particularly preferably 2 mol% or less, and may be 0 mol% or exceed 0 mol%.

Specific Example

| | Polymer components | | | |
|---|---|---|---|---|
| | Dicarboxylic acid components | | Glycol components | |
| Polyester resin A | Terephthalic acid component 50 mol% | - | Ethylene glycol component 49. 3 mol% | Diethylene glycol component 0.7 mol% |
| Polyester resin B | Terephthalic acid component 49 mol% | Isophthalic acid component 1 mol% | Ethylene glycol component 48.9 mol% | Ethylene glycol component 1.1 mol% |

In the specific example above, the difference in terephthalic acid component among the total dicarboxylic acid components is 1 mol%, and the difference in ethylene glycol component among the total glycol components is 0.4 mol%, resulting in a total difference of 1.4 mol%.

When multiple polyester resins A and/or multiple polyester resins B are used, the composition is calculated based on the average values.

When the polyester resin used as the raw material for the polyester film is a copolymer polyester resin or a blend of multiple polyester resins with different compositions, the kinds and amounts of the components used are not limited to the above. In cases where the polyester resin used as the raw material for the polyester film is a copolymerized polyester resin, the polyester resin A may not be the above-mentioned PET or like resins, but a polyester resin composition A produced by using polyester resin B to prepare a masterbatch may be formed. When multiple polyester resins of different compositions are blended, it is also a preferred embodiment to incorporate an ionic compound into at least one of the polyester resins to form a polyester resin composition A.

The amount of the ionic compound added to the polyester resin composition A is preferably 1 mass% (10000 ppm by mass) or less, more preferably 5000 ppm by mass or less, even more preferably 2000 ppm by mass or less, and particularly preferably 1000 ppm by mass or less. The amount of the ionic compound added can be appropriately optimized based on the melt resistivity of the resin that constitutes the film to be formed and the dissociation energy of the ionic compound. An ionic compound with low dissociation energy can reduce the melt resistivity even when used in a smaller amount, thus reducing the amount of the ionic compound to be added to the polyester resin.

The amount of the ionic compound added to the polyester resin composition A may be 950 ppm by mass or less, 900 ppm by mass or less, 850 ppm by mass or less, 700 ppm by mass or less, 500 ppm by mass or less, 400 ppm by mass or less, 250 ppm by mass or less, 150 ppm by mass or less, 90 ppm by mass or less, 40 ppm by mass or less, 20 ppm by mass or less, 10 ppm by mass or less, or 9 ppm by mass or less.

The amount of the ionic compound added to the polyester resin composition A is preferably 1 ppm by mass or more, more preferably 2 ppm by mass or more, even more preferably 3 ppm by mass or more, particularly preferably 4 ppm by mass or more, and more particularly preferably 5 ppm by mass or more. In one embodiment, the amount of the ionic compound added to the polyester resin composition A is preferably 1 ppm by mass or more and 10000 ppm by mass or less.

The above addition amounts can be interpreted as the contents.

The polyester resin composition A preferably satisfies the above formulas (1) and (2).

The method for adding the ionic compound to the polyester resin A includes, for example, the above-mentioned methods (A) to (C).

The concentration C1 of the ionic compound contained in the polyester resin composition A is preferably 3 times or more, more preferably 5 times or more, even more preferably 8 times or more, and particularly preferably 10 times or more, relative to the concentration C2 of the ionic compound contained in the polyester film (or the raw resin such as polyester resin). The concentration C1 is preferably 10000 times or less, more preferably 1000 times or less, even more preferably 500 times or less, particularly preferably 200 times or less, and most preferably 100 times or less, relative to the concentration C2. In one embodiment, the concentration C1 is preferably 3 times or more and up to 10000 times the concentration C2.

The upper limit of the melt resistivity of the polyester resin composition A is preferably $5 \times 10^8\ \Omega\cdot cm$, more preferably $2 \times 10^8\ \Omega\cdot cm$, even more preferably $1 \times 10^8\ \Omega\cdot cm$, particularly preferably $0.5 \times 10^8\ \Omega\cdot cm$, and most preferably $0.1 \times 10^8\ \Omega\cdot cm$. The lower limit of the melt resistivity of the polyester resin composition A is preferably $0.0001 \times 10^8\ \Omega\cdot cm$, more preferably $0.0005 \times 10^8\ \Omega\cdot cm$, even more preferably $0.001 \times 10^8\ \Omega\cdot cm$, particularly preferably $0.005 \times 10^8\ \Omega\cdot cm$, and most preferably $0.01 \times 10^8\ \Omega\cdot cm$. In one embodiment, it is preferable that the melt resistivity of the polyester resin composition A is $0.0001 \times 10^8\ \Omega\cdot cm$ or more and $0.1 \times 10^8\ \Omega\cdot cm$ or less. By setting the melt resistivity within the above range, economical production becomes easier, and uniform mixing becomes easier, which facilitates stable production.

The polyester resin composition A may contain components other than the polyester resin A and the ionic compound. Specific examples of such other components include pigments such as colorants, lubricants (in particular, lubricant particles), ultraviolet absorbers, antistatic agents, antioxidants, heat stabilizers, and resins other than polyester resin A. Components other than the polyester resin A and the ionic compound may be used singly or in a combination of two or more.

In many cases, a lubricant (particularly lubricant particles) is added to the film to ensure slip properties and enable winding. Such a film can typically be produced by a method comprising the step of blending a polyester resin that does not contain (or contains a low concentration of) a lubricant (particularly lubricant particles) with a polyester resin composition (lubricant masterbatch) in which a lubricant (in particular, lubricant particles) is added (or added at a high concentration). It is also a preferable method to incorporate an ionic compound into the lubricant masterbatch to obtain a polyester resin composition A.

Lubricant Masterbatch

The lubricant masterbatch is explained below.

Examples of lubricants include oxides, carbonates, silicates, sulfates, and aluminates of metals such as titanium, aluminum, silicon, calcium, magnesium, and barium. Specific examples include, but are not limited to, titanium dioxide, alumina, aluminosilicate, silicon dioxide (silica), calcium oxide, calcium carbonate, and barium sulfate, as well as naturally occurring particles such as talc, mica, kaolinite, and zeolite. Lubricants can be used singly or in a combination of two or more.

The lower limit of the average particle size of the lubricant is preferably 0.1 μm, more preferably 0.2 μm, even more preferably 0.3 μm, particularly preferably 0.4 μm, and most preferably 0.5 μm. The upper limit of the average particle size of the lubricant is preferably 5 μm, more preferably 4 μm, even more preferably 3 μm, particularly preferably 2.7 μm, and most preferably 2.5 μm. In one embodiment, the average particle size of the lubricant is preferably 0.1 μm or more and 5 μm or less. By setting the average particle size of the lubricant within the above range, unevenness can be efficiently

formed on the film surface, thereby imparting ease of handling, such as slipperiness and runnability, while suppressing an increase in haze and the formation of large protrusions. The average particle size of the lubricant can be determined, for example, by photographing the particles using an electron microscope, randomly selecting and observing 100 non-agglomerated particles, and determining the average equivalent circle diameter as the average particle size. The particles to be measured may be those before addition. Alternatively, the particles can also be measured by dissolving the lubricant masterbatch or the film in a solvent capable of dissolving the polyester resin, filtering the resulting solution through a membrane filter such as PTFE, and measuring the particles captured on the filter.

The lower limit of the lubricant content in the lubricant masterbatch is preferably 1000 ppm by mass, more preferably 2000 ppm by mass, even more preferably 3000 ppm by mass, particularly preferably 4000 ppm by mass, and most preferably 5000 ppm by mass. The upper limit of the lubricant content in the lubricant masterbatch is preferably 70000 ppm by mass, more preferably 50000 ppm by mass, even more preferably 40000 ppm by mass, particularly preferably 30000 ppm by mass, and most preferably 20000 ppm by mass. In one embodiment, the lubricant content in the lubricant masterbatch is preferably 1000 ppm by mass or more and 70000 ppm by mass or less.

When the polyester resin composition A is produced as a lubricant masterbatch, it is preferable to add the lubricant to the polyester resin A in such an amount that the resulting lubricant content falls within the desirable range. When the lubricant content in the lubricant masterbatch is within the above range, it is not necessary to add a large amount of the masterbatch, thereby avoiding potential issues such as deterioration in color tone, reduced heat resistance, or increased production costs. Further, the risk of lubricant aggregation leading to an increased number of coarse defects (large particles) after blend dilution is also avoided.

The lubricant masterbatch can be produced, for example, by a method comprising adding a lubricant during the polymerization of the polyester resin, or by a method comprising melt-kneading a lubricant with a polyester resin after producing the polyester resin.

When the lubricant is added during the polymerization of the polyester resin, the timing of its addition is not particularly limited; however, it is preferable to add the lubricant during the esterification (or transesterification) process or between the completion of the esterification (or transesterification) process and the start of the polycondensation process, because this allows the lubricant to be uniformly dispersed within the polyester resin. It is preferable to add the lubricant in the form of a slurry with ethylene glycol.

Examples of methods for adding an ionic compound to a lubricant masterbatch include a method of adding an ionic compound to a polyester resin composition for a lubricant masterbatch; a method of adding an ionic compound or an ionic compound masterbatch during the melt-kneading of polyester resin and a lubricant; a method of melt-kneading a polyester resin composition for an ionic compound masterbatch with a lubricant masterbatch; and a method of melt-kneading a lubricant masterbatch with an ionic compound masterbatch.

The film may also be produced by a method comprising the step of blending, for example, a polyester resin that does not contain (or contains a low concentration of) an ultraviolet absorber with a polyester resin composition (ultraviolet absorber masterbatch) to which an ultraviolet absorber has been added (or added in a high concentration). It is also a preferable method to incorporate an ionic compound into this ultraviolet absorber masterbatch to obtain a polyester resin composition A. Examples of ultraviolet absorbers include organic ultraviolet absorbers and inorganic ultraviolet absorbers. From the standpoint of transparency, organic ultraviolet absorbers are preferred. Examples of organic ultraviolet absorbers include benzophenone-based, benzotriazole-based, acrylonitrile-based, and cyclic imino ester-based compounds, as well as combinations thereof.

Examples of benzophenone-based ultraviolet absorbers, benzotriazole-based ultraviolet absorbers, and acrylonitrile-based ultraviolet absorbers include 2-[2'-hydroxy-5'-(methacryloyloxymethyl) phenyl] -2H-benzotriazole, 2-[2'-hydroxy-5'-methacryloyloxyethyl)phenyl]-2H-benzotriazole, 2-[2'-hydroxy-5'-(methacryloyloxypropyl)phenyl]-2H-benzotriazole, 2,2'-dihydroxy-4,4'-dimethoxybenzophenone, 2,2',4,4'-tetrahydroxybenzophenone, 2,4-di-tert-butyl-6-(5-chlorobenzotriazol-2-yl)phenol, 2-(2'-hydroxy-3'-tert-butyl-5'-methylphenyl)-5-chlorobenzotriazole, 2-(5-chloro(2H)-benzotriazol-2-yl)-4-methyl-6-(tert-butyl)phenol, and 2,2'-methylenebis(4-(1,1,3,3-tetramethylbutyl)-6-(2H-benzotriazol-2-yl)phenol).

Examples of cyclic imino ester-based ultraviolet absorbers include 2,2'-(1,4-phenylene)bis(4H-3,1-benzoxazin-4-one), 2-methyl-3,1-benzoxazin-4-one, 2-butyl-3,1-benzoxazin-4-one, and 2-phenyl-3,1-benzoxazin-4-one.

Benzotriazole-based ultraviolet absorbers and cyclic imino ester-based ultraviolet absorbers are particularly preferred in terms of durability.

It is also a preferable method to incorporate an ionic compound into an ultraviolet absorber masterbatch to obtain a polyester resin composition A. The concentration of the ultraviolet absorber in the ultraviolet absorber masterbatch is preferably set to 5 to 30 mass% in order to uniformly disperse and economically incorporate the ultraviolet absorber. As for the conditions for producing the ultraviolet absorber masterbatch, it is preferable to use a kneading extruder and to carry out extrusion at a temperature in the range of the melting point of the polyester resin or higher and 290°C or lower for 1 to 15 minutes. When the extrusion temperature and the extrusion time are within the ranges stated above, both the reduction in the amount of the ultraviolet absorber and the decrease in the viscosity of the ultraviolet absorber masterbatch can be

suppressed. When the extrusion time is within the above range, a more uniform mixing of the ultraviolet absorber can be achieved. In this process, additives such as stabilizers, color tone adjusters, and antistatic agents can be added as necessary. An ionic compound or a masterbatch of an ionic compound may be added to the polyester resin composition for a Ultraviolet absorber masterbatch; a Ultraviolet absorber may be added to a polyester resin composition for an ionic compound masterbatch; or a Ultraviolet absorber masterbatch and an ionic compound masterbatch may be melt-kneaded together.

Polyester Resin B

The melt resistivity of the polyester resin B is higher than that of the polyester resin composition A, and is preferably $1 \times 10^8$ Ω·cm or more. The melt resistivity of the polyester resin B is more preferably $5 \times 10^8$ Ω·cm or higher, and even more preferably $10 \times 10^8$ Ω·cm or higher. The upper limit of the melt resistivity of the polyester resin B is not particularly limited, but is preferably $10000 \times 10^8$ Ω·cm and more preferably $1000 \times 10^8$ Ω·cm. In one embodiment, it is preferable that the melt resistivity of the polyester resin B is $1 \times 10^8$ Ω·cm or more and $10000 \times 10^8$ Ω·cm or less.

In one preferred embodiment, the polyester resin comprises one selected from biomass PET, chemically recycled PET, and recovered polyester resin.

The polyester resin B may contain colorants such as pigments, lubricants (in particular, lubricant particles), ultraviolet absorbers, antistatic agents, antioxidants, thermal stabilizers, and resins other than polyester resins.

The polyester resin composition A and polyester resin B are preferably in the form of chips, and can take any shape, such as spherical, ellipsoidal (rugby ball-shaped), cylindrical, or barrel-shaped (hamburger-shaped). The mass of each chip is preferably 10 to 100 mg, more preferably 15 to 70 mg, and even more preferably 20 to 50 mg. When the polyester resin composition A is dry-blended with polyester resin B, it is preferable to make their chip shapes and masses similar to each other in order to reduce segregation during feeding. When the chip mass of the polyester resin composition A and that of polyester resin B are compared, taking the larger mass as 1, the smaller mass (including the case where both are equal) is preferably 0.5 or more, more preferably 0.6 or more, even more preferably 0.7 or more, and particularly preferably 0.75 or more. The upper limit is preferably 1.

Examples of methods for mixing the polyester resin composition A and the polyester resin B include:

- a method in which the chips of the polyester resin composition A and the polyester resin B are pre-mixed and fed from the same inlet of the extruder,
- a method in which the chips of the polyester resin composition A and the polyester resin B are fed through separate inlets of the extruder,
- a method in which the polyester resin composition A is first melted in a separate extruder and then merged with the polyester resin B in an extruder for polyester resin B, and
- a method in which the polyester resin composition A and the polyester resin B are individually melted in separate extruders and then mixed together in another extruder.

When the polyester resin composition A and polyester resin B are mixed, the mixture may be used with a lubricant masterbatch or with a Ultraviolet absorber masterbatch, other additives may be added directly or in the form of a masterbatch.

The amount of the polyester resin A is preferably 0.01 mass% or more, more preferably 0.1 mass% or more, even more preferably 0.2 mass% or more, particularly preferably 0.5 mass% or more, and most preferably 1 mass% or more, based on the total amount of the polyester resin composition A and the polyester resin B. The amount of the polyester resin A is preferably 33 mass% or less, more preferably 20 mass% or less, even more preferably 12.5 mass% or less, and particularly preferably 10 mass% or less. In one embodiment, the amount of the polyester resin A is preferably 0.01 mass% or more and 33 mass% or less. By setting the amount of the polyester resin A within the above range, an ionic compound can be stably added, which allows for fast and stable film formation and is also cost-effective, resulting in a polyester film with fewer defects and less discoloration.

In order to reduce film discoloration and contamination of the film production equipment by reducing the amount of the ionic compound added, it is preferable to add an ionic compound having an ion dissociation energy within the above range. However, if ion exchange or a similar reaction occurs within the film and forms an ionic compound having an ion dissociation energy that substantially falls within the above range, the ionic compound originally added may have a dissociation energy that falls outside the above range.

Specifically, multiple types of ionic compounds whose dissociation energies fall outside the above range may be added so that ion exchange or similar reactions occur within the film, thereby generating a combination of an anion and a cation whose dissociation energy falls within the above range. In this case, the polyester resin composition A may be prepared by adding a combination of an anion and a cation such that their dissociation energy falls within the above range, or alternatively, polyester resin compositions A may be individually prepared so as to have a combination of an anion and a

cation that will result in a dissociation energy within the above range when mixed, and then these compositions may be mixed. The content of the ionic compound in the film can be defined as the total amount of the combination of the anion and cation, among the detected ions, that correspond to ionic compound.

The polyester film may be a multilayer film comprising two or more polyester layers. The multilayer film may be, for example, a co-extruded film (CCF). When the polyester film is a multilayer film, it is preferable that at least one layer contains an ionic compound and one or more layers not containing an ionic compound may also be present.

When the film is a multilayer film composed of three or more layers, the film can be configured such that the outermost layers on both sides do not contain any ionic compounds and the inner layers contain an ionic compound. Such a structure can suppress the bleed-out of the ionic compound.

When the film comprises a layer not containing an ionic compound, the layers containing the ionic compound preferably accounts for 30% or more, more preferably 50% or more, even more preferably 60% or more, particularly preferably 70% or more, and most preferably 90% or more of the total film thickness. The layers containing the ionic compound preferably accounts for 99% or less, more preferably 96% or less, even more preferably 94% or less, and particularly preferably 92% or less of the total film thickness. In one embodiment, the layers containing the ionic compound preferably account for 30% or more and 99% or less of the total film thickness.

It is preferable to adjust the amount of the ionic compound added to the layers containing the ionic compound so that the melt resistivity of the entire layer falls within an appropriate range.

Other typical multilayer film structures include, for example, a structure with two or more layers in which one outermost layer contains a lubricant (in particular, lubricant particles) and the other outermost layer does not; a structure in which both outermost layers contain a lubricant (in particular, lubricant particles), and at least one inner layer does not; a structure in which both outermost layers do not contain a lubricant (in particular, lubricant particles), and at least one inner layer contains a lubricant (in particular, lubricant particles); a structure in which both outermost layers do not contain a Ultraviolet absorber, and at least one inner layer contains a Ultraviolet absorber. Any combination or composite of these (for example, a layer containing both an ionic compound and an ultraviolet absorber, or a layer containing both an ionic compound and a lubricant (in particular, lubricant particles)) is possible.

Method for Producing (Forming) Polyester Film

The method for producing (forming) the polyester film preferably comprises the steps of feeding the raw material polyester resin etc. into an extruder and melt-kneading, and then extruding the resulting mixture through a die with a long narrow slit onto a cooling roll to obtain an unstretched film. In one embodiment, the raw material may include a polyester resin composition A and a polyester resin B.

The lower limit of the melting temperature (melting point) is preferably the melting point of the raw resin of the film plus 5°C, more preferably the melting point plus 10°C, even more preferably the melting point plus 15°C, and particularly preferably the melting point plus 20°C. The upper limit of the melting temperature (melting point) is preferably the melting point plus 50°C, more preferably the melting point plus 45°C, even more preferably the melting point plus 40°C, and particularly preferably the melting point plus 35°C. In one embodiment, the melting temperature is preferably in the range of the melting point plus 5°C to the melting point plus 50°C. Maintaining the temperature within the above range facilitates the formation of a film with uniform thickness and can also suppress the generation of foreign matter and discoloration caused by decomposition of the raw resin. For example, when the resin is PET, the lower limit of the melting temperature is preferably 265°C, more preferably 270°C, and even more preferably 275°C. The upper limit of the melting temperature is preferably 310°C, more preferably 305°C, and even more preferably 300°C. In one embodiment, the melting temperature is preferably 265°C or more and 310°C or less. When multiple types of raw resins are used, the melting point of the raw resin for the film described above is defined as the melting point of the resin with the highest melting point. The melting point can be evaluated from the endothermic peak value obtained using a differential scanning calorimeter (e.g., DSC7020, produced by Hitachi High-Tech Science Corporation) under the following conditions:

Sample: 5 mg
Measurement conditions:

1st RUN (heating): heating rate 10°C/min, room temperature → 250°C (hold for 3 minutes)
1st RUN (cooling): cooling rate -50°C/min, 250°C → 25°C
2nd RUN (heating): heating rate 10°C/min, room temperature → 250°C

The method for bringing the molten raw resin into intimate contact with the cooling roll is preferably, for example, the electrostatic adhesion system. The electrostatic adhesion system is generally a method in which an electrode is placed before (in particular, immediately before) the molten resin comes into contact with the cooling roll, and a voltage is applied to the electrode to charge the molten resin, thereby bringing the resin into intimate contact with the cooling roll through

electrostatic force.

The electrode can be, for example, in the form of a wire or a ribbon. The wire-shaped electrode preferably has a diameter Φ of 0.05 to 1 mm, and particularly preferably 0.08 to 0.5 mm. The ribbon-shaped electrode preferably has a thickness of 0.05 to 1 mm, and particularly preferably 0.08 to 0.5 mm. The ribbon-shaped electrode preferably has a width of 3 to 50 mm, and particularly preferably 5 to 40 mm. Electrodes may be used by combining multiple types and sizes, such as wires and tapes, or small-diameter and large-diameter wires. It is preferable to have a system where the electrode is unwound from one end and wound up from the other end.

Examples of electrode materials include tungsten, iron, nickel, cobalt, molybdenum, titanium, tantalum, aluminum, copper, and stainless steel. Alloys of these materials may also be used. Further, the electrode surface may be plated with gold, platinum, or the like.

The electrode is preferably disposed on the side opposite to the cooling roll for the molten resin film. The distance between the electrode and the molten resin film is preferably in the range of 2 to 50 mm, more preferably 3 to 30 mm, and even more preferably 4 to 20 mm. The electrode is preferably provided between a die outlet and the contact point at which the cooling roll comes into contact with the molten resin, more preferably positioned 1 to 50 mm upstream of the contact point, and even more preferably 2 to 30 mm upstream of the contact point.

The voltage is preferably 1 to 100 kV, and more preferably 3 to 50 kV.

The electrostatic adhesion method may be used in combination with a mechanical adhesion method, such as a vacuum box or an air knife. It is particularly preferable to use the electrostatic adhesion method in combination with a method that blows air onto both end portions.

Since the melt resistivity of the raw resin can be optimized, high adhesion can be achieved even when the film is produced at high speeds. For example, an unstretched film can be produced at a speed of 60 m/min or more, 80 m/min or more, 100 m/min or more, or even 120 m/min or more. The upper limit of the speed is not limited because it also depends on the overall capacity of the extruder and film-forming machine and the cooling capacity; however, the upper limit is typically around 500 m/min, 400 m/min, or 300 m/min. In one embodiment, the speed is preferably 60 m/min or more and 500 m/min or less.

The cooled film may be used as an unstretched film, or the film may be then stretched to form a stretched film. The stretching may be either uniaxial stretching or biaxial stretching. In uniaxial stretching, the stretching may be in the MD (machine direction) or the TD (transverse direction), or may be even in a diagonal direction. In biaxial stretching, any method, such as sequential stretching, simultaneous biaxial stretching, or a combination of these, can be used. In biaxial stretching, either MD stretching followed by TD stretching or TD stretching followed by MD stretching may be used, and MD stretching and TD stretching may be alternately repeated, or MD stretching and TD stretching can be each carried out in multiple stages.

The lower limit of the draw ratio in uniaxial stretching is preferably 2 times, more preferably 2.5 times, even more preferably 2.8 times, particularly preferably 3 times, and most preferably 3.2 times. The upper limit of the draw ratio in uniaxial stretching is preferably 8 times, more preferably 7 times, even more preferably 6 times, particularly preferably 5.5 times, and most preferably 5 times. In one embodiment, the draw ratio in uniaxial stretching is preferably 2 times or more and 8 times or less.

The lower limit of the draw ratio in at least one direction (the main direction) of biaxial stretching is preferably 2 times, more preferably 2.5 times, even more preferably 2.8 times, particularly preferably 3 times, and most preferably 3.2 times. The upper limit of the draw ratio in at least one direction (the main direction) of biaxial stretching is preferably 8 times, more preferably 7 times, even more preferably 6 times, particularly preferably 5.5 times, and most preferably 5 times. In one embodiment, it is preferable that the draw ratio in at least one direction (the main direction) of biaxial stretching is 2 times or more and 8 times or less.

The lower limit of the draw ratio in the other direction of biaxial stretching is preferably 1.05 times, more preferably 1.1 times, even more preferably 1.2 times, particularly preferably 1.3 times, and most preferably 1.5 times. The upper limit of the draw ratio in the other direction of the biaxial stretching is preferably 8 times, more preferably 7 times, even more preferably 6 times, particularly preferably 5.5 times, and most preferably 5 times. In one embodiment, the draw ratio in the other direction of biaxial stretching is preferably 1.05 times or more and 8 times or less.

The lower limit of the area expansion ratio by biaxial stretching is preferably 4 times, more preferably 5 times, even more preferably 6 times, particularly preferably 7 times, and most preferably 8 times. The upper limit of the area expansion ratio by biaxial stretching is preferably 25 times, more preferably 22 times, even more preferably 20 times, particularly preferably 18 times, and most preferably 16 times. In one embodiment, it is preferable that the area expansion ratio by biaxial stretching is 4 times or more and 25 times or less.

In a typical biaxial stretching method in which TD stretching follows MD stretching, the lower limit of the MD draw ratio is preferably 2.3 times, more preferably 2.6 times, and even more preferably 2.8 times. The upper limit of the MD draw ratio is preferably 4.2 times, more preferably 3.8 times, and evenl more preferably 3.5 times. In one embodiment, the MD draw ratio is preferably from 2.3 times or more and 4.2 times or less.

The lower limit of the TD draw ratio is preferably 2.8 times, more preferably 3 times, even more preferably 3.2

times, and particularly preferably 3.4 times. The upper limit of the TD draw ratio is preferably 6 times, more preferably 5 times, even more preferably 4.5 times, particularly preferably 4.3 times, and most preferably 4 times. In one embodiment, the TD draw ratio is preferably 2.8 times or more and 6 times or less.

The lower limit of the stretching temperature is preferably Tg+0°C, more preferably Tg+3°C, even more preferably Tg+5°C, and particularly preferably Tg+10°C. The upper limit of the stretching temperature is preferably Tg+50°C, more preferably Tg+40°C, even more preferably Tg+35°C, and particularly preferably Tg+30°C. In one embodiment, the stretching temperature is preferably Tg or more and Tg+50°C or less. In the present specification, Tg refers to the midpoint glass transition temperature as defined in JIS K7121 (1987). In the case of a film composed of a mixture of multiple resins, Tg refers to that of the melt blend (the resin composition discharged onto the cooling roll).

The lower limit of the stretching temperature for PET is preferably 80°C, more preferably 83°C, and even more preferably 85°C. The upper limit of the stretching ratio temperature for PET is preferably 130°C, more preferably 125°C, and even more preferably 120°C. In one embodiment, the stretching temperature for PET is preferably 80°C or higher and 130°C or lower.

The lower limit of the MD stretching temperature for PET is preferably 80°C, more preferably 83°C, and even more preferably 85°C. The upper limit of the MD stretching temperature for PET is preferably 110°C, more preferably 105°C, and even more preferably 100°C. In one embodiment, the MD stretching temperature for PET is preferably 80°C or higher and 110°C or lower.

The lower limit of the TD stretching temperature for PET is preferably 85°C, more preferably 90°C, and even more preferably 95°C. The upper limit of the TD stretching temperature for PET is preferably 130°C, more preferably 125°C, and even more preferably 120°C. In one embodiment, the TD stretching temperature for PET is preferably 85°C or higher and 130°C or lower.

The above temperatures are merely guidelines for the film temperature, and it is preferable to adjust the temperatures of the heating rollers, infrared heater, tenter, etc. so that the film achieves the above temperature during stretching.

The lower limit of the stretching speed (tenter) is preferably 10%/s, more preferably 15%/s, even more preferably 20%/s, and particularly preferably 25%/s. By setting the stretching speed (tenter) at or above the above-mentioned lower limit, productivity can be improved. The upper limit of the stretching speed (tenter) is preferably 100%/s, more preferably 90%/s, even more preferably 80%/s, and particularly preferably 75%/s. By setting the stretching speed (tenter) at or below the above-mentioned upper limit, film breakage can be suppressed, resulting in uniform stretching. In one embodiment, the stretching speed (tenter) is preferably 10%/s or higher and 100%/s or lower. The criterion for the stretching speed is based on the length before stretching being 100%.

The lower limit of the heat treatment temperature is preferably 120°C, more preferably 150°C, even more preferably 170°C, and particularly preferably 190°C. By setting the heat treatment temperature at or above the above-mentioned lower limit, the thermal shrinkage of the film can be suppressed. The upper limit of the heat treatment temperature is preferably 250°C, more preferably 245°C, even more preferably 240°C, and particularly preferably 235°C. By setting the heat treatment temperature at or below the above-mentioned upper limit, the flatness of the film can be improved. In one embodiment, it is preferable that the heat treatment temperature is 120°C or higher and 250°C or lower.

The lower limit of the heat treatment time is preferably 2 seconds, more preferably 3 seconds, and even more preferably 5 seconds. The upper limit of the heat treatment time is preferably 120 seconds, more preferably 60 seconds, even more preferably 30 seconds, and particularly preferably 20 seconds. In one embodiment, the heat treatment time is preferably 2 seconds or longer and 120 seconds or shorter.

The lower limit of the relaxation treatment temperature is preferably 100°C, more preferably 120°C, even more preferably 140°C, and particularly preferably 150°C. The upper limit of the relaxation treatment temperature is preferably the heat treatment temperature, more preferably the heat treatment temperature minus 5°C, and even more preferably the heat treatment temperature minus 10°C, and may be, for example, 250°C or lower. In one embodiment, it is preferable that the relaxation treatment temperature is 100°C or higher and not more than the heat treatment temperature, and may also be 100°C or higher and 250°C or lower.

The lower limit of the relaxation ratio is preferably 0.5%, more preferably 1%, and even more preferably 1.5%. By setting the relaxation ratio at or above the above-mentioned lower limit, the thermal shrinkage can be effectively suppressed. The upper limit of the relaxation ratio is preferably 5%, more preferably 4.5%, and even more preferably 4%. By setting the relaxation ratio at or below the above-mentioned upper limit, the flatness of the film can be improved. In one embodiment, the relaxation ratio is 0.5% or more and 5% or less.

Relaxation in the TD direction can be achieved, for example, by narrowing the clip width within the tenter. As for relaxation in the MD direction, examples include a method comprising cutting off the edge portions held by the clips within the tenter or releasing the edge portions from the clips; a method comprising reducing the film winding speed to be slower than the film-conveying speed within the tenter; a method using a simultaneous biaxial stretching machine to narrow the clip pitch; and a method comprising transferring the film between a first clip chain and a second clip chain, the second clip chain operating at a lower running speed than the first clip chain.

Typically, the film is then cooled and wound up. The lower limit of the cooling temperature (at the tenter exit) is preferably 40°C, more preferably 50°C, and even more preferably 60°C. The upper limit of the cooling temperature (at the tenter exit) is preferably 140°C, more preferably 120°C, and even more preferably 100°C. In one embodiment, the cooling temperature (at the tenter exit) is preferably 40°C or higher and 140°C or lower.

The lower limit of the film temperature during winding is preferably 10°C, more preferably 15°C, and even more preferably 18°C. The upper limit of the film temperature during winding is preferably 50°C, more preferably 40°C, and even more preferably 35°C. By setting the film temperature during winding at or below the above-mentioned upper limit, static electricity and scratches caused by tight winding can be reduced. In one embodiment, the temperature of the film during winding is 10°C or higher and 50°C or lower.

An adhesion-facilitating layer is preferably provided on at least one surface of the polyester film. When an adhesion-facilitating layer is provided on both surfaces, the both surfaces may have the same composition or different compositions. The adhesion-facilitating layer may be provided inline during film formation or offline after film formation. The adhesion-facilitating layer is preferably provided inline during film formation. In the present specification, the term "polyester film" may refer to a film comprising the adhesion-facilitating layer described above.

Preferred examples of resins used for the adhesion-facilitating layer include polyesters, acrylic resins, polyurethane (such as polyester polyurethane, polycarbonate polyurethane, and polyether polyurethane), ethylene-vinyl acetic acid copolymers, polyamide, styrene-acrylic copolymers, and polyvinyl alcohol. These resins can be used singly or in a combination of two or more.

It is preferable that the adhesion-facilitating layer is crosslinked. Preferred examples of crosslinking agents include compounds containing isocyanate groups, compounds containing oxazoline groups, compounds containing epoxy groups, amino resins such as melamine, and carbodiimide compounds. In the case of photocurable resins, monomers or oligomers of compounds containing multiple double bonds, such as trimethylolpropane triacrylate, pentaerythritol tetraacrylate, acrylic-modified polyurethane, and acrylic-modified epoxy resin, may also be used. Crosslinking agents may be used alone or in a combination of two or more.

The adhesion-facilitating layer may contain additives, such as particles, surfactants, leveling agents, antistatic agents, and catalysts. Additives may be used singly or in a combination of two or more.

The lower limit of the thickness of the adhesion-facilitating layer after drying is preferably 0.001 μm, more preferably 0.005 μm, even more preferably 0.01 μm, and particularly preferably 0.02 μm. The upper limit of the thickness of the adhesion-facilitating layer after drying is preferably 1 μm or less, more preferably 0.5 μm or less, even more preferably 0.3 μm or less, and particularly preferably 0.2 μm. In one embodiment, the thickness of the adhesion-facilitating layer after drying is preferably 0.001 μm or more and 1 μm or less.

The melt resistivity of polyester resin to which no ionic compounds have been added varies depending on factors such as the composition of the polyester and the type and amount of the catalyst used, etc., and may reach as high as $100 \times 10^8$ Ω·cm. In particular, in applications such as insulation, a catalyst such as germanium, titanium, or manganese may be used, and the amount of metal catalyst is minimized to ensure high insulation performance by setting a high melt resistivity. However, when the catalyst amount is increased to achieve electrostatic adhesion, the catalyst may precipitate, leading to potential short-circuiting at those sites, making it difficult to maintain sufficient insulation. By using an ionic compound (or polyester resin composition A), it is possible to lower the melt resistivity while suppressing short circuits caused by foreign matter, thereby ensuring insulation performance. However, by using an ionic compound (or polyester resin composition A), it is possible to reduce the melt resistivity while suppressing short circuits caused by foreign matter and ensuring insulation.

The melt resistivity of the raw resin (in particular, polyester resin) after addition of the ionic compound is preferably $20 \times 10^8$ Ω·cm or less, more preferably $15 \times 10^8$ Ω·cm or less, even more preferably $10 \times 10^8$ Ω·cm or less, particularly preferably $5 \times 10^8$ Ω·cm or less, and most preferably $2 \times 10^8$ Ω·cm or less. By setting the melt resistivity at or below the above-mentioned upper limit, electrostatic adhesion can be imparted even to the raw resin (in particular, polyester resin) having high melt resistivity before addition of the ionic compound.

To achieve film formation at a higher speed, the melt resistivity of the raw resin (in particular, polyester resin) after addition of the ionic compound is preferably $1 \times 10^8$ Ω·cm or less, more preferably $0.8 \times 10^8$ Ω·cm or less, even more preferably $0.7 \times 10^8$ Ω·cm or less, particularly preferably $0.6 \times 10^8$ Ω·cm or less, and most preferably $0.5 \times 10^8$ Ω·cm or less. The lower limit of the melt resistivity is preferably $0.001 \times 10^8$ Ω·cm, more preferably $0.005 \times 10^8$ Ω·cm, even more preferably $0.01 \times 10^8$ Ω·cm, particularly preferably $0.05 \times 10^8$ Ω·cm, and most preferably $0.1 \times 10^8$ Ω·cm. By setting the melt resistivity at or above the above-mentioned lower limit, it is possible to retain the film's electrostatic charge and ensure high electrostatic adhesion. In addition, it is possible to suppress defects such as scratches, pinholes, and breakage in the film caused by sparking between the electrode and the molten resin. In one embodiment, the melt resistivity is preferably $0.001 \times 10^8$ Ω·cm or more and $1 \times 10^8$ Ω·cm or less.

When the object is to further reduce the amount of foreign matter, or in applications requiring high insulation, such as for insulation purposes, the melt resistivity may be $0.5 \times 10^8$ Ω·cm or higher, $0.6 \times 10^8$ Ω·cm or higher, $0.7 \times 10^8$ Ω·cm or higher, $0.8 \times 10^8$ Ω·cm or higher, or $1 \times 10^8$ Ω·cm or higher. The melt resistivity may be the melt resistivity after mixing the polyester resin composition A and the polyester resin B.

In the present specification, melt resistivity refers to the resistivity value (unit: Ω·cm) calculated from the amount of current that flows when the raw resin such as polyester resin is heated to a temperature 20°C higher than the melting point of the raw resin and a predetermined voltage is applied to the raw resin in a molten state. The melt resistivity is a numerical value indicative of the electrical conductivity of the raw resin.

It is preferable that the melt resistivity of the raw resin (in particular, polyester resin) of the polyester film falls within the above range.

When the polyester film is formed from a mixture (composition) of multiple polyester resins, it is preferable that the melt resistivity of the mixture falls within the above range.

When the raw resin of the polyester film comprises a resin other than polyester resin or other additives, it is preferable that the melt resistivity of the entire raw resin composition falls within the above range.

The melt resistivity of the film is measured by melting the film at a temperature 20°C higher than the melting point of the raw resin, such as polyester resin, used to form the film. When multiple raw resins such as different polyester resins are used in the film, the melting point measured after melt-kneading the film can be used. If no melting point can be clearly detected, then the following melting point can be used: in cases where the film's main polymerization components are dicarboxylic acid components and glycol components, the melting point of the polymer composed of the predominant dicarboxylic acid component and the predominant glycol component can be used; and in cases where the film's main polymerization component is a hydroxycarboxylic acid component, the melting point of the homopolymer of the predominant hydroxycarboxylic acid component can be used. The same approach applies even when the film is multilayered and the composition of the polyester resin differs between layers.

For example, when the repeating unit is mainly composed of ethylene terephthalate (i.e., the terephthalic acid component accounts for 50 mol% or more of the total acid components, and the ethylene glycol component accounts for 50 mol% or more of the total glycol components), the measurement can be conducted at 280°C.

Film Properties

The lower limit of the film thickness is preferably 1μm, more preferably 2 μm, even more preferably 3 μm, particularly preferably 5 μm, and most preferably 10 μm. The upper limit of the film thickness is preferably 300 μm, more preferably 250 μm, even more preferably 200 μm, particularly preferably 150 μm, and most preferably 100 μm. In one embodiment, the film thickness is preferably 1 μm or more and 300 μm or less. The film thickness can be measured, for example, in accordance with Method A of JIS K 7130:1999.

The lower limit of the intrinsic viscosity (IVf) of the film is preferably 0.4 dl/g, more preferably 0.45 dl/g, more preferably 0.5 dl/g, particularly preferably 0.55 dl/g, and most preferably 0.6 dl/g. By setting the intrinsic viscosity of the film equal to or higher than the above-mentioned lower limit, the mechanical strength of the film can be ensured. The upper limit of the intrinsic viscosity (IVf) of the film is preferably 1.2 dl/g, more preferably 1 dl/g, even more preferably 0.9 dl/g, particularly preferably 0.8 dl/g, and most preferably 0.7 dl/g. By setting the intrinsic viscosity at or below the above-mentioned upper limit, shear heat generation during melt extrusion can be suppressed, thereby reducing the generation of foreign matter and discoloration, and improving film formability. In one embodiment, it is preferable that the intrinsic viscosity (IVf) of the film is 0.4 dl/g or more and 1.2 dl/g or less.

The lower limit of the acid value (AVf) of the film is preferably 3 eq/ton, more preferably 5 eq/ton, and even more preferably 7 eq/ton. The upper limit of the acid value (AVf) of the film is preferably 100 eq/ton, more preferably 80 eq/ton, even more preferably 75 eq/ton, particularly preferably 70 eq/ton, and most preferably 60 eq/ton. By setting the acid value of the film at or below the above-mentioned upper limit, the generation of foreign matter can be suppressed. In one embodiment, it is preferable that the acid value (AVf) of the film is 3 eq/ton or more and 100 eq/ton or less.

The lower limit of haze is preferably 0.1%, and more preferably 0.2%. The upper limit of haze is preferably 10%, more preferably 5%, even more preferably 3%, particularly preferably 2%, and most preferably 1%. In one embodiment, it is preferable that the haze is 0.1% or more and 10% or less. By setting the haze within the above range, the film can be preferably used for applications requiring transparency. Haze can be measured in accordance with JIS K 7136, for example, using an NDH 5000 haze meter produced by Nippon Denshoku Industries Co., Ltd.

The lower limit of the total light transmittance is preferably 80%, more preferably 85%, even more preferably 88%, particularly preferably 89%, and most preferably 90%. The upper limit of the total light transmittance is preferably 99%, more preferably 97%, even more preferably 95%, and particularly preferably 94%. In one embodiment, the total light transmittance is preferably 80% or more and 99% or less. By setting the total light transmittance within the above range, it can be preferably used for applications requiring transparency. The total light transmittance is a value measured on a film comprising an in-line coated (IC) layer, such as an adhesion-facilitating layer, but not comprising any layers formed by post-processing, such as an anti-reflection layer. The total light transmittance can be measured, for example, using a haze meter (NDH 5000, produced by Nippon Denshoku Industries Co., Ltd).

The lower limit of the elongation at break in at least one of the MD and TD directions is preferably 30%, more preferably 40%, and even more preferably 50%. The upper limit of the elongation at break is preferably 400%, more

preferably 300%, and even more preferably 200%. In one embodiment, the elongation at break is preferably 30% or more and 400% or less. Further, the elongation at break in both the MD direction and TD direction may fall within the above range.

The lower limit of the breaking strength in at least one of the MD and TD directions is preferably 30 MPa, more preferably 50 MPa, even more preferably 100 MPa, particularly preferably 150 MPa, and most preferably 180 MPa. The upper limit of the breaking strength is preferably 500 MPa, more preferably 450 MPa, even more preferably 400 MPa, and particularly preferably 350 MPa. In one embodiment, the breaking strength is preferably 30 MPa or more and 500 MPa or less. The breaking strength at break in both the MD and TD directions may fall within the above range.

The lower limit of the elastic modulus in at least one of the MD and TD directions is preferably 0.1 GPa, more preferably 0.5 GPa, even more preferably 1 GPa, still even more preferably 1.5 GPa, particularly preferably 2 GPa, and most preferably 2.5 GPa. The upper limit of the elastic modulus is preferably 10 GPa, more preferably 8 GPa, even more preferably 7 GPa, and particularly preferably 6 GPa. In one embodiment, the elastic modulus is preferably 0.1 GPa or more and 10 GPa or less. The elastic modulus in both the MD and TD directions may fall within the above range.

The elongation at break and breaking strength can be determined, for example, in accordance with JIS K 7127, by cutting out a test sample with a width of 15 mm and a length of 100 mm in the longitudinal direction of the film, conducting a tensile test using a universal testing machine (Autograph AG-I, produced by Shimadzu Corporation) under the conditions of a gauge length of 50 mm and a tensile speed of 200 mm/min, and analyzing the obtained stress-strain curve. The elastic modulus can be determined from the tangent line to the rising portion of the stress-strain curve.

The lower limit of the tear propagation resistance in at least one of the MD and TD directions is preferably 1 N/mm, more preferably 3 N/mm, and even more preferably 5 N/mm. The upper limit of the tear propagation resistance is preferably 30 N/mm, more preferably 25 N/mm, and even more preferably 20 N/mm. In one embodiment, it is preferable that the tear propagation resistance is 1 N/mm or more and 30 N/mm or less. The tear propagation resistance in both the MD and TD directions may fall within the above range. The tear propagation resistance is a value measured in accordance with the Elmendorf method specified in JIS P 8116 (2000).

The lower limit of impact strength is preferably 0.005 J/μm, more preferably 0.01 J/um, even more preferably 0.02 J/μm, and particularly preferably 0.03 J/μm. The upper limit of impact strength is preferably 0.2 J/μm, more preferably 0.15 J/um, even more preferably 0.1 J/um, and particularly preferably 0.08 J/um. In one embodiment, the impact strength is preferably 0.005 J/μm or more and 0.2 J/μm or less. By setting the impact strength within the above range, the strength of the polyester film can be ensured, enabling stable film production, suppressing issues such as breakage during post-processing, and allowing the film to be used in accordance with the properties required for various applications. The impact strength can be measured at an ambient temperature of 23 °C using an impact tester (e.g., a Film Impact Tester, produced by Toyo Seiki Seisaku-sho, Ltd.) with a spherical impact surface having a diameter of 1/2 inch.

The lower limit of the thermal shrinkage in the maximum direction is preferably 0%, more preferably 0.1%, even more preferably 0.2%, and particularly preferably 0.3%. The upper limit of the thermal shrinkage in the maximum direction is preferably 5%, more preferably 4%, even more preferably 3%, and particularly preferably 2%. In one embodiment, it is preferable that the thermal shrinkage in the maximum direction is 0% or more and 5% or less. The thermal shrinkage in the maximum direction can be measured, for example, by the following method.

Measurement Method

After the polyester film is allowed to stand in an environment of 25°C and 50% RH for 168 hours, a circle with a diameter of 80 mm and a straight line D with a length of about 50 mm that passes through the center of the circle and that runs in parallel to the TD direction of the film are drawn. The diameter of the circle is measured using an image dimension measuring instrument (Image Measurer IM-6500, produced by Keyence Corporation) in continuous mode, with the direction of the straight line D being defined as 0° and measurements being taken at 1° intervals to determine the diameter length at each angle before heat treatment. Subsequently, heat treatment is performed at 150°C for 30 minutes and then the sample is cooled for 10 minutes in an environment set to a room temperature of 25°C. The diameter at each angle after heat treatment is then measured using the same method as that before the heat treatment. It should be noted that the above heat treatment is conducted on the polyester film alone.

The thermal shrinkage at each angle is calculated using the following formula.

**Thermal shrinkage = (Length before heat treatment - Length after heat treatment) / Length before heat treatment × 100**

In this way, the thermal shrinkage in the direction in which the polyester film exhibits the maximum shrinkage can be measured.

The lower limit of the dynamic friction coefficient of at least one surface is preferably 0.2, and more preferably 0.3. By setting the dynamic friction coefficient at or above the above-mentioned lower limit, winding misalignment during

transportation or the like can be suppressed. The upper limit of the dynamic friction coefficient of at least one surface is preferably 0.8, more preferably 0.7, and even more preferably 0.6. By setting the dynamic friction coefficient at or below the above-mentioned upper limit, winding can be facilitated. In one embodiment, the dynamic friction coefficient of at least one surface is preferably 0.2 or more and 0.8 or less. The dynamic friction coefficient of both of the surfaces may also fall within the above range.

The lower limit of the static friction coefficient on at least one surface is preferably 0.2, more preferably 0.25, and even more preferably 0.3. By setting the static friction coefficient at or above the lower limit, winding misalignment during transportation and the like can be suppressed. The upper limit of the static friction coefficient on at least one surface is preferably 0.8, more preferably 0.7, and even more preferably 0.6. By setting the static friction coefficient at or below the upper limit, winding can be facilitated. In one embodiment, the static friction coefficient on at least one surface is preferably 0.2 or more and 0.8 or less. The static friction coefficients on both of the surfaces may fall within the above range.

The dynamic friction coefficient and static friction coefficient can be measured, for example, using a Tensilon (RTG-1210) produced by AND Co., Ltd. under the conditions of a metal load of 3.5 kg at a tensile speed of 200 mm/min at 23°C and 65% RH.

The lower limit of the water vapor transmission rate, converted to a film thickness of 50 μm, is preferably 1 g/$m^2$·24 h, more preferably 2 g/$m^2$·24 h, even more preferably 3 g/$m^2$·24 h, particularly preferably 5 g/$m^2$·24 h, and most preferably 8 g/$m^2$·24 h. The upper limit of the water vapor transmission rate, converted to a film thickness of 50 μm, is preferably 100 g/$m^2$·24 h, more preferably 50 g/$m^2$·24 h, even more preferably 30 g/$m^2$·24 h, particularly preferably 20 g/$m^2$·24 h, and most preferably 15 g/$m^2$·24 h. In one embodiment, the water vapor transmission rate, converted to a film thickness of 50 μm, is preferably 1 g/$m^2$·24h or more and 100 g/$m^2$·24h or less. The water vapor transmission rate can be measured in accordance with JIS K 7129 B method using a water vapor permeability measurement device (for example, "PERMA-TRAN-W 3/33MG," produced by MOCON, Inc.).

The lower limit of the oxygen transmission rate, converted to a film thickness of 50 μm, is preferably 10 $cm^3$/$m^2$·24h·MPa, more preferably 50 $cm^3$/$m^2$·24h·MPa, even more preferably 100 $cm^3$/$m^2$·24h·MPa, particularly preferably 150 $cm^3$/$m^2$·24h·MPa, more particularly preferably 200 $cm^3$/$m^2$·24h·MPa, and most preferably 250 $cm^3$/$m^2$·24h·MPa. The upper limit of the oxygen transmission rate, converted to a film thickness of 50 μm, is preferably 1000 $cm^3$/$m^2$·24h·MPa, more preferably 700 $cm^3$/$m^2$·24h·MPa, even more preferably 500 $cm^3$/$m^2$·24h·MPa, particularly preferably 400 $cm^3$/$m^2$·24h·MPa, particularly more preferably 350 $cm^3$/$m^2$·24h·MPa, and most preferably 320 $cm^3$/$m^2$·24h·MPa. In one embodiment, it is preferable that the oxygen transmission rate, converted to a film thickness of 50 μm, is 10 $cm^3$/$m^2$·24h·MPa or more and 1000 $cm^3$/$m^2$·24h·MPa or less. The oxygen transmission rate can be measured using an oxygen permeability measurement device (for example, "OX-TRAN2/20," produced by MOCON, Inc.) in accordance with the electrolytic sensor method (Appendix A) of JIS-K7126-2.

The lower limit of the surface roughness (Ra) of at least one surface is preferably 0.1 nm, more preferably 0.5 nm, even more preferably 0.8 nm, and particularly preferably 1 nm. The upper limit of the surface roughness (Ra) of at least one surface is preferably 100 nm, more preferably 50 nm, even more preferably 30 nm, particularly preferably 20 nm, and most preferably 10 nm. In one embodiment, it is preferable that the surface roughness (Ra) of at least one surface is 0.1 nm or more and 100 nm or less. The surface roughness (Ra) of both of the surfaces may fall within the above range.

The lower limit of the ten-point average surface roughness (Rzjis) of at least one surface is preferably 5 nm, more preferably 10 nm, even more preferably 15 nm, and particularly preferably 20 nm. The upper limit of the ten-point average surface roughness of at least one surface is preferably 500 nm, more preferably 400 nm, even more preferably 300 nm, and particularly preferably 250 nm. In one embodiment, it is preferable that the ten-point average surface roughness of at least one surface is 5 nm or more and 500 nm or less. The ten-point average surface roughness of both of the surfaces may fall within the above range. By setting the ten-point average surface roughness within the above range, slidability, transparency, and clarity (low haze) can be ensured.

The surface roughness (Ra and Rzjis) can be measured in accordance with ISO 25178 using a non-contact surface profilometry system (VertScan R550H-M100, produced by Ryoka Systems, Inc.).

The above film properties are desirable characteristics particularly for PET or PEN films; however, they are also considered favorable for other types of polyester films. It is not necessary for a film to satisfy all of the above properties, and appropriate properties may be selected depending on, for example, the intended application and the type of polyester used.

Applications of Polyester Film

The polyester film of the present invention can find various applications. Examples of applications include, but are not limited to, the following.

- Optical films, such as polarizer protective films, prism and lens sheets, and anti-reflection films.
- Surface protection films for image display devices and polarizing plates.

- Base material films for transparent conductive films for use in application such as touch sensors.
- Release films for processing such as ceramic green sheet production and dry film resists, and functional thin-film transfer films such as liquid crystal compound thin films
- Insulating films for applications such as solar cell back sheets, motor insulation, and film capacitors.
- Circuit substrate films
- Barrier film substrates
- Light-reflective films and light-shielding films
- Paper-substitute void-containing films
- Various packaging films
- Heat-shrinkable films
- Heat-molded films
- Films for metal sheet lamination

The polyester film can be optimized for these applications by adjusting the resin composition and manufacturing conditions to achieve the appropriate film characteristics. For example, when the polyester film is used in the optical system of image display devices, for example, as a polarizer protective film, the lower limit of the film thickness is preferably 10 μm, and more preferably 20 μm, and the upper limit is preferably 150 μm, and more preferably 100 μm.

The orientation in one direction (draw ratio) may be increased to enhance uniaxiality, and the retardation may be increased to suppress rainbow unevenness when the film is used in an image display device. In this case, the retardation is preferably 1500 nm or more and more preferably 3000 nm or more. The retardation can be 15000 nm or less or can be 10000 nm or less. In this case, the lower limit of the difference between the refractive index in the slow axis direction of the film and the refractive index in the direction orthogonal thereto (fast axis direction) is preferably 0.05, more preferably 0.07, and even more preferably 0.08. The upper limit is preferably 0.2, more preferably 0.15, and even more preferably 0.1. In this case, the lower limit of the NZ coefficient is preferably 1.3, more preferably 1.4, and even more preferably 1.5. The upper limit of the NZ coefficient is preferably 3.0, more preferably 2.7, and even more preferably 2.5.

When the film is used in an optical system, it is also preferable to adjust the TD and MD draw ratios through biaxial stretching to enhance isotropy. In this case, the thickness can be selected from the same range as mentioned above. In this case, the retardation is preferably 3500 nm or less, more preferably 3000 nm or less, even more preferably 2500 nm or less, particularly preferably 2000 nm or less, and most preferably 1500 nm or less. Further, the retardation is preferably less than 1500 nm, more preferably 1000 nm or less, even more preferably 500nm or less, and particularly preferably 300 nm or less, thereby allowing the film to serve as a non-retardation (low retardation) film. The lower limit of retardation is 0 nm, but may practically be 10 nm or more, and preferably 50 nm or more. In this case, the lower limit of the NZ coefficient is preferably 3, more preferably 4, and even more preferably 5. Although the upper limit of the NZ factor is theoretically infinite, it is preferably 300, more preferably 200, and even more preferably 100.

Examples

Examples are provided to illustrate the present invention in more detail. However, the present invention is not limited to the Examples below. Various modifications and alterations can be made without departing from the spirit and scope of the invention. Such variations are all fall within the technical scope of the present invention.

Melt Resistivity

After vacuum-drying at 40°C for 16 hours, each raw resin composition was heated to a temperature 20°C higher than the melting point of the raw resin to melt the raw resin composition. Two electrodes (stainless steel wires with a diameter of 0.6 mm) were placed in the raw resin composition, and a voltage of 120 V was applied to measure the current (io). The melt resistivity Si (Ω·cm) was calculated using the following formula:

$$Si\ (\Omega\cdot cm) = (A / L) \times (V / io)$$

wherein

A = area between electrodes ($cm^2$);
L = distance between electrodes (cm);
V = voltage (V); and
io = current (A).

Number of Coarse Particles

The raw resin composition was placed between two cover glasses and melt-pressed to a thickness of 50 μm at a temperature 20°C higher than the melting point of the raw resin. After quenching, 20 fields of view, each with an area of 718 μm × 583 μm, were observed using a phase-contrast microscope at 100× magnification. The number of particles with a diameter of 5 μm or larger was counted using an image analyzer.

Oligomer Content

100 mg of each finely ground sample was accurately weighed and dissolved in 3 mL of a hexafluoroisopropanol/chloroform mixed solvent (volume ratio = 2/3). Further, 20 mL of chloroform was added for dilution. After adding 10 mL of methanol to precipitate the polymer, the mixture was filtered. The filtrate was evaporated to dryness and made up to a predetermined volume with 10 mL of dimethylformamide. The cyclic trimer was then quantified using the high-performance liquid chromatography (HPLC) method described below.

Device: L-7000 (produced by Hitachi, Ltd.)
Column: μ-Bondasphere C18 5μ 100 angstroms
3.9 mm x 15 cm (Waters)
Solvent: Eluent A: 2% acetic acid/water (v/v)
Eluent B: acetonitrile
Gradient B%: 10 → 100% (0 → 55 min)
Flow rate: 0.8 mL/min
Temperature: 30°C
Detector: UV-259 nm

Thermal Stability Parameter (TS)

The raw resin composition was placed in a glass ampoule. The ampoule was purged with nitrogen and then sealed under a reduced pressure of 13.3 kPa (in a nitrogen atmosphere). The raw resin composition was heated at a temperature 40°C higher than the melting point of the raw resin for 2 hours, and the inherent viscosity of the raw resin composition was then measured. The thermal stability parameter (TS) was calculated using the following equation.

$$TS = 0.245 \times \left\{ \left( [IV]_{f2}^{-1.47} \right) - \left( [IV]_{i}^{-1.47} \right) \right\}$$

wherein $[IV]_i$ and $[IV]_{f2}$ represent the inherent viscosity of the raw resin composition before the heat treatment and that after the heat treatment, respectively.

Film-Forming Stability

Electrostatic Casting

Raw resin composition No. A-1 was dried at 135°C for 6 hours under a reduced pressure of 33 Pa. The dried composition was then melted and filtered twice using 100 μm and 50 μm filters. A DC voltage of 6 kV was applied between the electrode placed above the melt-extruded film and the rotating cooling body, rapidly quenching and solidifying the sheet by close contact. The casting speed (m/min) at which uneven voltage application occurred was determined by gradually increasing the casting speed and evaluated according to the following criteria:

○: 50 m/min or higher
△: 30 m/min or higher and less than 50 m/min
×: Less than 30 m/min

Melting Point

The melting point was evaluated based on the endothermic peak value obtained under the following conditions using a DSC7020, produced by Hitachi High-Tech Science Corporation.

Sample: 5 mg

Measurement Conditions:

1st run (heating): heating rate of 10°C/min, from room temperature to 250°C (hold for 3 minutes)
1st run (cooling): cooling rate of -50°C/min, from 250°C to 25°C
2nd run (heating): heating rate of 10°C/min, from room temperature to 250°C

Elemental Content of Metals and Other Elements

Each sample was pretreated to prepare a measurement solution. The elemental concentrations in the resulting solution were measured using an inductively coupled plasma (ICP) optical emission spectrometer (SPECTROBLUE, produced by Hitachi High-Tech Science Corporation), and the elemental content in the sample was calculated.

Pretreatment

Sb, P, Ge

The sample was weighed into a platinum crucible, and 5 mL of a 5% yttrium nitrate ethanol solution was added. The sample was subjected to preliminary carbonization on a hot plate up to 400°C and then subjected to ashing treatment at 550°C for 8 hours using an electric furnace, Model FO610, produced by Yamato Scientific Co., Ltd. After ashing, 20 mL of 1.2N hydrochloric acid was added to dissolve nitrate, and the resulting solution was used as a measurement solution.

Ti, Mn, Al, Mg, Ca, K, Na, Li, Cu

The sample was weighed into a platinum crucible and subjected to preliminary carbonization on a hot plate up to 400°C and then subjected to ashing treatment at 550°C for 8 hours using a Yamato Scientific FO610 electric furnace. After ashing, 6.0N hydrochloric acid and a small amount of hydrofluoric acid were added, and acid decomposition was performed on a hot plate, followed by heating until the acids were completely volatilized. After completion of the acid decomposition, the residue was diluted to a predetermined volume with 20 mL of 1.2N hydrochloric acid to obtain a measurement solution.
ICP Emission Spectrometry Conditions
Plasma Power: 1400 W
Plasma Gas: 13.0 L/min
Auxiliary Gas: 1.0 L/min
Nebulizer: Crossflow nebulizer
Chamber: Scott chamber
Measurement Wavelength: See the table below.

| Element | Wavelength (nm) |
|---|---|
| Sb | 217.581 |
| Ge | 265.118 |
| P | 213.618 |
| Al | 396.152 |
| Ti | 334.941 |
| Mn | 257.611 |
| Mg | 280.27 |
| Ca | 315.887 |
| K | 766.491 |
| Na | 589.592 |
| Li | 670.78 |
| Cu | 324.754 |

Glass Transition Temperature (Tg)

The midpoint glass transition temperature determined by DSC as specified in JIS K 7121 (1987) is used as the glass transition temperature (Tg).

Film Thickness

The film thickness was measured in accordance with Method A of JIS K7130-1999 using an electric micrometer (Militron 1245D, produced by Feinprüf) after allowing the sample to stand in an environment of 25°C and 50% relative humidity for 168 hours.

Intrinsic Viscosity (IV)

The polyester resin (or film) was dissolved in a mixed solvent of phenol (6 parts by mass) and 1,1,2,2-tetrachloroethane (4 parts by mass), and the intrinsic viscosity was measured at 30°C using an Ostwald viscometer.

Acid Value

The polyester chips or film were cryogenically ground and dried. A 0.2 g portion of the dried sample was dissolved by heating in 10 mL of benzyl alcohol, and titrated using a 0.04 mol/L potassium hydroxide ethanol solution (prepared by diluting 80 mL of a 0.5 mol/L aqueous potassium hydroxide solution with ethanol to make a total volume of 1 L) with phenol red as an indicator.

Haze

The haze was measured in accordance with JIS K 7136 using a NDH 5000 haze meter produced by Nippon Denshoku Industries Co., Ltd.

Total Light Transmittance

The total light transmittance was measured using a haze meter (Model NDH5000, produced by Nippon Denshoku Industries Co., Ltd.).

Elongation at Break, Breaking strength, and Elastic Modulus

In accordance with JIS K 7127, test samples measuring 15mm in width and 100mm in length in the longitudinal direction of the film were cut out. A tensile test was conducted using a universal testing machine (Autograph AG-I, produced by Shimadzu Corporation) under the conditions of a 50 mm gauge length and a tensile speed of 200mm/min. From the obtained stress-strain curves, the elongation at break and breaking strength of the samples were determined. The elastic modulus was calculated from the tangent line to the rising portion of the stress-strain curve.

Tear Propagation Resistance

The tear propagation resistance was measured in accordance with the Elmendorf method specified in JIS P 8116 (2000). The obtained value was divided by the film thickness (μm) and then multiplied by 10 to obtain a value per 10 μm thickness.

Impact Strength

The impact strength was measured using an impact strength tester (product name: Film Impact Tester, Serial No. T-84-3) produced by Toyo Seiki Seisaku-sho, Ltd. Rectangular samples measuring 100 mm in the width direction of the film and 100 mm in the longitudinal direction of the film were cut out.

Subsequently, the sample was set in the tester, and at an ambient temperature of 23°C, the impact strength of the film against puncture was measured using an impactor with a spherical impact surface diameter of 1/2 inch. The measured strength was then converted to a value per 1 μm of film thickness and defined as the impact strength, with the unit expressed as J/μm.

The method for thickness correction of the impact strength is as follows.

$$\text{Impact Strength} = \text{Measured Value/Thickness of the Sample}$$

Thermal Shrinkage at 150°C in the Maximum Direction

After the polyester film was allowed to stand in an environment of 25°C and 50% relative humidity for 168 hours, a circle with a diameter of 80 mm and an about 50-mm straight line D passing through the center of the circle and running in parallel to the transverse direction (TD) of the film were drawn. The circle and line D were drawn using an ultra-fine permanent ink pen capable of producing lines no thicker than 0.5 mm, with care being taken to apply consistent pressure during drawing to ensure uniform line thickness. A template or compass can be used when the circle is drawn.
The diameter of the circle was measured using an image dimension measurement device (Image Dimension Measurement System IM6500, produced by Keyence Corporation) in continuous measurement mode, with the direction of line D set to 0° and measurements being taken at 1° intervals, and the diameter of the circle was determined at each angle before heat treatment. Subsequently, heat treatment was performed using a gear oven set at 150°C for 30 minutes. After the sample was then cooled in an environment set at room temperature (25°C) for 10 minutes, the diameter of the circle after heat treatment was measured at each angle in the same manner as the method for measurement of the film before heat treatment. It should be noted that the heat treatment was performed on the polyester film alone.
The thermal shrinkage at each angle was evaluated using the following formula:

Thermal shrinkage = (Length before heat treatment - Length after heat treatment) / Length before heat treatment × 100

In this way, the thermal shrinkage of the polyester film in the direction with the maximum shrinkage was measured.

Dynamic Friction Coefficient and Dynamic Friction Coefficient

A sample film was prepared by cutting out an area of 400 mm (longitudinal direction) × 100 mm (width direction) from the obtained film. This sample film was then aged under conditions of 23 °C and 65% RH for 12 hours. The sample was divided into two parts: one for a sliding stage (300 mm in the longitudinal direction × 100 mm in the width direction) and one for load application (100 mm in the longitudinal direction × 100 mm in the width direction). The sliding sample was set on the sliding stage, and the loading sample was affixed with tape to the surface of a 3.5 kg metal weight (with a bottom area size of 39.7 $mm^2$) so that the sliding sample and the loading sample would come into contact with each other. Using a Tensilon universal testing machine (RTG-1210, produced by AND Co., Ltd.), the static friction coefficient and dynamic friction coefficient were measured under the conditions of a metal load-pulling speed of 200 mm/min, at 23°C and 65% RH. The average of three measurements was calculated. Friction was measured between identical surfaces.

Water Vapor Transmission Rate

The water vapor transmission rate was measured under normal conditions using a water vapor permeability tester (PERMATRAN-W 3/33MG, produced by MOCON, Inc.) in accordance with JIS-K7129 B method. The measurement was conducted in an atmosphere in which the temperature and humidity on the high-humidity side around the sample during measurement were maintained at 40°C and 90% RH, respectively.

Oxygen Transmission Rate

The oxygen transmission rate under normal conditions was measured using an oxygen permeability tester (OX-TRAN2/20, produced by MOCON, Inc.) in accordance with the electrolytic sensor method (Appendix A) of JIS-K7126-2. The measurement was conducted in an atmosphere in which the temperature and humidity on the high-humidity side around the sample were maintained at 23°C and 65% RH, respectively.

Surface Roughness (Ra and Rzjis)

Each surface roughness parameter was measured in accordance with ISO 25178 using a non-contact surface profilometry system (VertScan R550H-M100, produced by Ryoka Systems Inc.) under the conditions described below.

Measurement Conditions

Measurement mode: WAVE mode
Objective lens: 10x
0.5x tube lens
Measurement area: 936 μm x 702 μm

Analysis Conditions

Surface correction: 4th-order correction
Interpolation process: full interpolation
ISO parameter processing: S-filter set to 10 μm

Measurements were taken at five points, and the average value was calculated.

Particle Size

The particle size of the IC particles was determined by measuring a dispersion of the particles to be added by laser diffraction.

The particle size of the particles added to the polyester was measured by taking photographs with a scanning electron microscope. One hundred non-aggregated inorganic particles were randomly selected and observed, and the average of their sizes was taken as the average particle size. The particle size was calculated as the equivalent circular diameter. The equivalent circular diameter was defined as twice the square root of the area of the observed inorganic particle divided by π. The area and equivalent circular diameter were calculated using an image analyzer (iSpect-DIA-10, a particle image analyzer produced by Shimadzu Corporation).

Composition of Polyester

20 mg of polyester resin was dissolved in 0.6 mL of a mixed solvent composed of hexafluoroisopropanol and chloroform at a volume ratio of 1:9, and subjected to centrifugation.

The supernatant was then collected, and $^{1}$H-NMR measurement was performed under the following conditions.

Device: Fourier Transform Nuclear Magnetic Resonance
Spectrometer (AVANCE NEO600, produced by BRUKER)
$^{1}$H resonance frequency: 600.13 MHz
Lock solvent: deuterated chloroform
Flip angle: 30°
Data acquisition time: 4 seconds
Delay time: 1 second
Measurement temperature: 30°C
Number of accumulations: 128

The content of EMIM-TFSI in the film was measured using the following analytical method.

Analytical Method

About 50 mg of a finely cut film sample was accurately weighed and dissolved in 1.5 mL of a solvent mixture of HFIP and chloroform mixed at a mass ratio of 2:3. 10 mL of chloroform was added to this solution, and 5 mL of methanol was added to precipitate the resin. The filtrate obtained by filtration was concentrated and evaporated to dryness. After 5 mL of DMF was added and the filtrate was appropriately diluted, the resulting mixture was subjected to HPLC analysis.

The HPLC conditions are as follows.

Instrument: Waters ACQUITY UPLC H-Class
Flow rate: 0.2 mL/min
Column temperature: 40°C
Injection volume: 5 μL

The HPLC conditions for TFSI were as follows:

Column: Waters BEH C18, 2.1 mm × 150 mm
Mobile phase: A: 0.1% formic acid, B: ACN (acetonitrile) Gradient program: 0 min (5% B) → 25 min (98% B) → 30 min (98% B) The conditions for EMIM are as follows:
Column: TSKgel Amide-80 3 μm, 2.1 mm × 150 mm
Mobile phase: A: 0.1% formic acid, B: ACN (acetonitrile) Gradient program: 0 min (90% B) → 10 min (50% B) → 15 min (50% B)

MS was measured using an Xevo G2-XS QTof instrument produced by Waters. The ionization method used for the measurement was electrospray ionization (ESI), with ESI negative mode used for TFSI and ESI positive mode used for EMIM.

Production Example of Polyester Resin

Polyester Resin SbA-1

When an esterification reactor had been heated to 80°C, terephthalic acid and ethylene glycol were placed in the reactor at a terephthalic acid:ethylene glycol molar ratio of 1:2. While the resulting mixture was stirred, antimony trioxide was added as a catalyst in an amount corresponding to 70 ppm of Sb atoms relative to the produced PET. Further, triethylamine was added at 0.33 mol% relative to terephthalic acid. Subsequently, the temperature was raised and a pressurized esterification reaction was carried out at 240°C under a gauge pressure of 0.34 MPa.

The pressure in the esterification reactor was then returned to atmospheric pressure, and EMIM-TFSI was added in the form of an ethylene glycol solution at 3 ppm relative to the produced PET. After the temperature was raised to 260°C over a period of 15 minutes, the resulting esterification product was transferred to a polycondensation reactor. After the temperature was gradually increased from 260°C to 280°C under reduced pressure, a polycondensation reaction was performed at 285°C. After completion of the polycondensation reaction, the reaction mixture was pelletized to obtain a polyester resin SbA-1. Table 1 shows the evaluation results.

Polyester Resin SbA-2

When the esterification reactor had been heated to a temperature of 200°C, a slurry composed of terephthalic acid and ethylene glycol at an ethylene glycol:terephthalic acid molar ratio of 2:1 was added to the reactor in such a manner terephthalic acid was fed at a rate of 2 tons per hour. While stirring, antimony trioxide was added as a catalyst so that the Sb atom concentration would be 70 ppm relative to the produced PET. Further, triethylamine was added at 0.33 mol% relative to the terephthalic acid. The temperature was then further increased, and a pressurized esterification reaction was carried out at 240°C under a gauge pressure of 0.34 MPa.

Subsequently, after the temperature was raised to 260°C over a period of 15 minutes, the obtained esterification product was transferred to the polycondensation reactor. After the temperature was gradually raised from 260°C to 280°C under reduced pressure, a polycondensation reaction was carried out at 285°C. After completion of the polycondensation reaction, the reaction mixture was pelletized. The obtained polyester resin pellets were then dried under a reduced pressure of 33 Pa at 135°C for 6 hours. While the dried pellets were added in fixed amounts into a twin-screw extruder (model KZW15TW-45/60MG-NH(-2200), produced by Technovel) and while EMIM-TFSI was simultaneously supplied in a predetermined amount through a separate feed port using an automatic feeder, the resulting mixture was melted and kneaded at an actual temperature of 270°C with a screw rotation speed of 200 rpm and a discharge rate of 1.6 to 2.0 kg/h, and further granulated into pellets to obtain a polyester resin SbA-2. Table 1 shows the evaluation results.

Polyester Resins SbA-3 to SbA-8, Sb-0, and SbB-1 to SbB-5

Polyester resins SbA-3 to SbA-8, Sb-0, and SbB-1 to SbB-5 were produced in the same manner as polyester resin SbA-1, except that the type and amount of the ionic compound added were changed to those listed in Table 1. Table 1 shows the evaluation results. Note that polyester resin SbA-8 is an example in which two types of ionic compounds were used in combination. The total amount of the ionic compounds added, R (ppm), was 8 + 2 = 10, and the dissociation energy, Q (kJ/mol), was calculated as (8/10) × 315 + (2/10) × 857 = 423.

Polyester resin SbA-9

Polyester resin SbA-9 was produced in the same manner as polyester resin SbA-1, except that the amount was adjusted to achieve a Sb concentration of 100 ppm.

Polyester resin TiA-1 (Ti catalyst PET)

When the esterification reactor had been heated to 80°C, terephthalic acid and ethylene glycol were placed into the reactor at a terephthalic acid:ethylene glycol molar ratio of 1:2. While the resulting mixture was stirred, triethylamine was added at 0.33 mol% relative to terephthalic acid. Subsequently, the temperature was raised and a pressurized esterification reaction was carried out at 240°C under a gauge pressure of 0.34 MPa.

The pressure in the esterification reactor was then returned to normal pressure, and EMIM-TFSI was added as an ethylene glycol solution at a concentration of 3 ppm relative to the produced PET. Further, tetra-n-butyl titanate was added to achieve a Ti element content of 7 ppm relative to the produced PET. Further, after the temperature was raised to 260°C over a period of 15 minutes, the obtained esterification product was transferred to the polycondensation reactor. After the temperature was gradually increased from 260°C to 280°C under reduced pressure, a polycondensation reaction was carried out at 285°C. After completion of the polycondensation reaction, the reaction mixture was pelletized to obtain a polyester resin TiA-1. Table 1 shows the evaluation results.

Polyester Resin Ti-0 (Ti Catalyst PET)

Polyester resin Ti-0 was produced in the same manner as polyester resin TiA-1, except that EMIM-TFSI was not added.

Polyester Resin GeA-1 (Ge Catalyst PET)

Polyester resin GeA-1 was produced in the same manner as TiA-1, except that instead of tetra-n-butyl titanate, germanium dioxide was added in the form of a mixed aqueous solution of water and ethylene glycol to achieve a Ge content of 65 ppm, relative to the produced PET.

Polyester resin AIA-1 (GS catalyst PET)

Preparation of Aluminum-containing Ethylene Glycol Solution

A 20 g/L aqueous solution of basic aluminum acetate and ethylene glycol were placed in an equal amount (volume ratio) into a mixing tank and stirred at room temperature (23°C) for several hours. Subsequently, the mixture was stirred at 50 to 90 °C under reduced pressure (3 kPa) for several hours while distilling off water from the system, thereby preparing an ethylene glycol solution containing an aluminum compound at a concentration of 20 g/L.

Preparation of Phosphorus-Containing Ethylene Glycol Solution

As a phosphorus compound, Irganox 1222 (produced by BASF) was placed into a mixing tank together with ethylene glycol, and the mixture was heat-treated at 175°C for 150 minutes under a nitrogen atmosphere with stirring. As a result, a phosphorus-containing ethylene glycol solution with a phosphorus compound concentration of 50 g/L was prepared.

Polymerization of PET

Polyester resin AIA-1 was produced in the same manner as polyester resin TiA-1, except that in place of tetra-n-butoxy titanium, an aluminum-containing ethylene glycol solution and a phosphorus-containing ethylene glycol solution were added to the produced PET so that the Al element content would be 21 ppm and the P element content would be 45 ppm. The aluminum-containing ethylene glycol solution and the phosphorus-containing ethylene glycol solution were mixed in advance and added.

Polyester Resin CRA-1Sb (Chemically Recycled PET)

Chemically recycled BHET was placed into a reactor equipped with a stirrer. Diantimony trioxide was added so that the Sb atom concentration in the produced PET was 70 ppm. Further, EMIM-TFSI was added in the form of an ethylene glycol solution at 3 ppm relative to the produced PET. The temperature of the system was then raised to 280°C over a period of one hour, during which the pressure in the system was gradually reduced to 0.15 kPa. Under these conditions, a polycondensation reaction was carried out to obtain polyester resin.

It should be noted that the chemically recycled BHET used was obtained by alkaline hydrolysis of collected PET bottles and polyester fibers in ethylene glycol, followed by a purification process such as filtration and distillation. The

isophthalic acid component in the chemically recycled BHET was 1.0 mol% (relative to the total acid components) and the amount of the diethylene glycol component was 1.2 mol% (relative to the total acid components).

Polyester Resin CRA-1Al (Chemically Recycled PET)

Chemically recycled BHET was placed into a reactor equipped with a stirrer, and an aluminum-containing ethylene glycol solution and a phosphorus-containing ethylene glycol solution were added so that the Al element content and the P element content relative to the produced PET would be 21 ppm and 45 ppm, respectively. Polyester resin CRA-lAl was otherwise produced in the same manner as polyester resin AlA-1.

Polyester resin CRA-1Al (Chemically Recycled PET)

Polyester resin CR-0Al was produced in the same manner as CRA-1Al, except that EMIM-TFSI was not added.

Polyester Resin BIA-1Sb (Bio-PET)

Polyester resin BIA-1Sb was produced in the same manner as polyester resin SbA-1, except that biomass-derived ethylene glycol was used as ethylene glycol.

Polyester Resin BI-0Al (Bio-PET)

Esterification was performed in the same manner as polyester resin TiA-1, except that biomass-derived ethylene glycol was used as ethylene glycol.

Subsequently, the esterification reactor was returned to normal pressure, and an aluminum-containing ethylene glycol solution and a phosphorus-containing ethylene glycol solution were added to the obtained PET to achieve an Al element content of 21 ppm and a P element content of 45 ppm, relative to the PET produced. Further, after the temperature was raised to 260°C over a period of 15 minutes, the obtained esterification product was transferred to a polycondensation reactor. Under reduced pressure, the temperature was gradually increased from 260°C to 280°C, and a polycondensation reaction was performed at 285°C. After completion of the polycondensation reaction, the reaction mixture was pelletized to obtain a polyester resin BI-0Al.

Polyester Resin BIA-lAl

Polyester resin BIA-lAl was obtained in the same manner as polyester resin BI-0, except that EMIM-TFSI was added at 3 ppm relative to the produced PET.

Polyester Resin PEN

100 parts by mass of ethylene glycol and 100 parts by mass of dimethyl 2,6-naphthalenedicarboxylate were placed into a reactor. Antimony acetate was then added so that the Sb atom content would be 120 ppm relative to the produced PEN. Further, triethylamine was added at 0.33 mol% relative to the dimethyl 2,6-naphthalenedicarboxylate, and 150 ppm of trimethyl phosphate was added. Subsequently, the resulting mixture was heated to raise the temperature, and a pressurized esterification reaction was carried out at 245°C under a gauge pressure of 0.34 MPa.

Subsequently, the temperature was raised to 285°C while the pressure was gradually reduced to 133 Pa. A polycondensation reaction was then carried out at 285°C. Immediately before completion of the reaction, EMIM-TFSI was added to a concentration of 5 ppm. After stirring for 5 minutes, the reaction was terminated, and the product was pelletized.

Polyester Resin MR (material Recycle PET)

The polyester resin MR (material-recycled PET) to be used was prepared by washing and pulverizing collected PET beverage bottles, followed by pelletization. The isophthalic acid component content was 1.5 mol% (relative to the total acid components), and the diethylene glycol component content was 1.8 mol% (relative to the total acid components). The Sb content was 175 ppm, and the Ge content was 2.0 ppm. The IV was 0.64.

Polyester Resin MB-1Sb

Polyester resin MB-1Sb was produced in the same manner as polyester resin SbA-1, except that the concentration of EMIM-TFSI was 80 ppm relative to the produced PET.

Polyester Resin MB-1BI

Polyester resin MB-1BI was produced in the same manner as polyester resin BI-0Al, except that 80 ppm of EMIM-TFSI was added to the produced PET.

Polyester Resin MB-1CR

Polyester resin MB-1CR was produced in the same manner as polyester resin CRA-1Al, except that 80 ppm of EMIM-TFSI was added to the produced PET.

Polyester Resin MB-2Si1

Dried polyester resin Sb-0 and silica particles with an average particle size of 2.5 μm were fed into a twin-screw extruder and kneaded at 285°C to produce pellets of a polyester resin MB-2Si1 containing 6000 ppm of silica particles.

Polyester Resin MB-2Ca

Polyester Resin MB-2Ca was produced in the same manner as polyester resin MB-2Si1 except that calcium carbonate particles with an average particle size of 0.6 μm were used and the calcium carbonate particle content was 3000 ppm.

Polyester Resin MB-2Si2

Polyester Resin MB-2Si2 was produced in the same manner as polyester resin MB-2Si1 except that porous colloidal silica with an average particle size of 0.06 μm was used and its content was set to 10000 ppm.

Polyester Resin MB-2St

Polyester Resin MB-2St was produced in the same manner as MB-2Sil, except that porous colloidal silica with an average particle size of 0.2 μm and crosslinked polystyrene particles with an average particle size of 0.30 μm were used, and their contents were respectively set to 20000 ppm and 15000 ppm.

Polyester Resin Composition MB-1Sia

Pellets of polyester resin composition MB-1Sia were produced in the same manner as MB-2Sil, except that a dry blend of polyester resin Sb-0 and polyester resin composition SbA-2 in a mass ratio of 9:1 was used in place of polyester resin Sb-0.

Polyester Resin Composition MB-1Sib

Polyester resin composition MB-1Sib was produced in the same manner as MB-2Si1, except that EMIM-TFSI was simultaneously supplied from a separate supply port using an automatic supply device to achieve an EMIM-TFSI concentration of 80 ppm relative to the polyester resin.

Polyester Resin MB-3

10 parts by mass of a dried ultraviolet absorber (2,2'-(1,4-phenylene)bis(4h-3,1-benzoxazin-4-one) was mixed with 90 parts by mass of polyester resin SbA-1, and the mixture was kneaded using an extruder to obtain pellets of a polyester resin MB-3 containing an ultraviolet absorber.

Polyester Resin Composition MB-1UV

Polyester resin composition MB-1UV was produced in the same manner as polyester resin MB-1Sb except that a polyester resin MB-3 was used in place of polyester resin SbA-1.

In the above production, the dimensions of pellets, as measured with a caliper, were all approximately 2.5 mm × 3.0 mm × 3.6 mm.

Table 1 shows the properties of the resins obtained. The meanings of the abbreviations of the anions and cations constituting the ionic compounds in Table 1 are as follows:

Anion
AA: acetic acid
DCA: dicyanamide
DMP: dimethyl phosphate
FSI: bis(fluorosulfonyl)imide
TFSI: bis(trifluoromethanesulfonyl)imide
OA: oleic acid
Cation
AMIM: 1-aryl-3-methylimidazolium
EMIM: 1-ethyl-3-methylimidazolium
MEMP: 1-(2-methoxyethyl)-1-methylpyrrolidine
MMIM: 1,3-dimethylimidazolium

Table 1-1

| | Production Example 1 | Production Example 2 | Production Example 3 | Production Example 4 | Production Example 5 | Production Example 6 | Production Example 7 | Production Example 8 | | Production Example 9 |
|---|---|---|---|---|---|---|---|---|---|---|
| Resin | SbA-1 | SbA-2 | SbA-3 | SbA-4 | SbA-5 | SbA-6 | SbA-7 | SbA-8 | | SbA-9 |
| Cation | EMIM | EMIM | Mg | EMIM | Mg | MMIM | AMIM | EMIM | Mg | EMIM |
| Anion | TFSI | TFSI | TFSI | FSI | TFSI | DMP | DCA | TFSI | AA | TFSI |
| Dissociation energy | 315 | 315 | 689 | 305 | 689 | 392 | 333 | 315 | 857 | 315 |
| Ionic radius (Anion) | 3.66 | 3.66 | 3.66 | 3.17 | 3.66 | 3.11 | 3.42 | 3.66 | 2.57 | 3.66 |
| Ionic radius (Cation) | 3.30 | 3.30 | 1.64 | 3.30 | 1.64 | 3.15 | 2.69 | 3.30 | 1.64 | 3.30 |
| Absolute value of the average charge density (Anion) | 0.0044 | 0.0044 | 0.0044 | 0.0065 | 0.0044 | 0.0067 | 0.0098 | 0.0044 | 0.01 09 | 0.0044 |
| Absolute value of the average charge density (Cation) | 0.0059 | 0.0059 | 0.0593 | 0.0059 | 0.0593 | 0.0047 | 0.0054 | 0.0059 | 0.05 93 | 0.0059 |
| $R \leq 0.15 \times Q + 890$ | 937 | 937 | 993 | 936 | 993 | 949 | 940 | 937 | 1019 | 937 |
| $R \leq -20 \times Q + 16000$ | 9700 | 9700 | 2220 | 9900 | 2220 | 8160 | 9340 | 9700 | - 1140 | 9700 |
| Amount of ionic compound added (ppm) | 3 | 700 | 850 | 100 | 10 | 100 | 30 | 8 | 2 | 3 |
| Addition method | During polymerization | Post-addition | During polymerization | During polymerization | During polymerization | During polymerization | During polymerization | During polymerization | | During polymerization |
| Resin IV | 0.63 | 0.63 | 0.60 | 0.59 | 0.62 | 0.61 | 0.60 | 0.59 | | 0.65 |
| Resin AV | 14 | 13 | 13 | 12 | 11 | 13 | 13 | 15 | | 13 |
| Ethylene terephthalate content (mol%) | 98.6 | 98.6 | 98.6 | 98.6 | 98.6 | 98.6 | 98.6 | 98.6 | | 98.6 |
| Copolymer component (mol%) | DEG:1.4 | DEG:1.4 | DEG:1.4 | DEG:1.4 | DEG:1.4 | DEG:1.4 | DEG:1.4 | DEG:1.4 | | DEG:1.4 |
| Catalyst species | Sb | Sb | Sb | Sb | Sb | Sb | Sb | Sb | | Sb |

(continued)

<table>
<tr><th></th><th>Production Example 1</th><th>Production Example 2</th><th>Production Example 3</th><th>Production Example 4</th><th>Production Example 5</th><th>Production Example 6</th><th>Production Example 7</th><th colspan="2">Production Example 8</th><th>Production Example 9</th></tr>
<tr><td>Sb (content: ppm)</td><td>70</td><td>70</td><td>70</td><td>70</td><td>70</td><td>70</td><td>70</td><td colspan="2">70</td><td>100</td></tr>
<tr><td>Ge (content: ppm)</td><td>0</td><td>0</td><td>0</td><td>0</td><td>0</td><td>0</td><td>0</td><td colspan="2">0</td><td>0</td></tr>
<tr><td>Ti (content: ppm)</td><td>0</td><td>0</td><td>0</td><td>0</td><td>0</td><td>0</td><td>0</td><td colspan="2">0</td><td>0</td></tr>
<tr><td>Al (content: ppm)</td><td>0</td><td>0</td><td>0</td><td>0</td><td>0</td><td>0</td><td>0</td><td colspan="2">0</td><td>0</td></tr>
<tr><td>P (content: ppm)</td><td>0</td><td>0</td><td>0</td><td>0</td><td>0</td><td>0</td><td>0</td><td colspan="2">0</td><td>0</td></tr>
<tr><td>Mg+Ca (content: ppm)</td><td>0</td><td>0</td><td>35.3</td><td>0</td><td>0.4</td><td>0</td><td>0</td><td colspan="2">0.2</td><td>0</td></tr>
<tr><td>Total metal (content: ppm)</td><td>70</td><td>70</td><td>105.3</td><td>70</td><td>70.4</td><td>70</td><td>70</td><td>70</td><td>0.2</td><td>100</td></tr>
<tr><td>TS</td><td>0.22</td><td>0.23</td><td>0.21</td><td>0.23</td><td>0.26</td><td>0.24</td><td>0.23</td><td colspan="2">0.23</td><td>-</td></tr>
</table>

Table 1-2

| | Production Example 10 | Production Example 11 | Production Example 12 | Production Example 13 | Production Example 14 | Production Example 15 | Production Example 16 | Production Example 17 | Production Example 18 | Production Example 19 |
|---|---|---|---|---|---|---|---|---|---|---|
| Resin | SbB-1 | Sb-0 | SbB-2 | SbB-3 | SbB-4 | SbB-5 | TiA-1 | Ti-0 | GeA-1 | AIA-1 |
| Cation | Mg | - | EMIM | Mg | Na | Mg | EMIM | - | EMIM | EMIM |
| Anion | A | - | TFSI | AA | OA | AA | TFSI | - | TFSI | TFSI |
| Dissociation energy | 857 | - | 315 | 857 | 586 | 857 | 315 | - | 315 | 315 |
| Ionic radius (Anion) | 2.57 | - | 3.66 | 2.57 | 22.64 | 2.57 | 3.66 | - | 3.66 | 3.66 |
| Ionic radius (Cation) | 1.64 | - | 3.30 | 1.64 | 1.76 | 1.64 | 3.30 | - | 3.30 | 3.30 |
| Absolute value of the average charge density (Anion) | 0.0109 | - | 0.0044 | 0.0109 | 0.0023 | 0.0109 | 0.0044 | - | 0.0044 | 0.0044 |
| Absolute value of the average charge density (Cation) | 0.0593 | - | 0.0059 | 0.0593 | 0.0258 | 0.0593 | 0.0059 | - | 0.0059 | 0.0059 |
| $R \leq 0.15 \times Q + 890$ | 1019 | - | 937 | 1019 | 978 | 1019 | 937 | - | 937 | 937 |
| $R \leq -20 \times Q + 16000$ | -1140 | - | 9700 | -1140 | 4280 | -1140 | 9700 | - | 9700 | 9700 |
| Amount of ionic compound added (ppm) | 80 | 0 | 1200 | 1300 | 1300 | 1000 | 3 | 0 | 3 | 3 |
| Addition method | During polymerization | - | During polymerization | During polymerization | During polymerization | During polymerization | During polymerization | - | During polymerization | During polymerization |
| Resin IV | 0.62 | 0.62 | 0.60 | 0.62 | 0.60 | 0.59 | 0.63 | 0.63 | 0.65 | 0.62 |
| Resin AV | 15 | 13 | 15 | 15 | 13 | 15 | 14 | 14 | 14 | 15 |
| Ethylene terephthalate content (mol%) | 98.6 | 98.6 | 98.6 | 98.6 | 98.6 | 98.6 | 98.5 | 98.6 | 98.6 | 98.4 |

(continued)

| | Production Example 10 | Production Example 11 | Production Example 12 | Production Example 13 | Production Example 14 | Production Example 15 | Production Example 16 | Production Example 17 | Production Example 18 | Production Example 19 |
|---|---|---|---|---|---|---|---|---|---|---|
| Copolymer component (mol%) | DEG:1.4 | DEG:1.4 | DEG:1.4 | DEG:1.4 | DEG:1.4 | DEG:1.4 | DEG:1.5 | DEG:1.4 | DEG:1.4 | DEG:1.6 |
| Catalyst species | Sb | Sb | Sb | Sb | Sb | Sb | Ti | Ti | Ge | Al-P |
| Sb (content: ppm) | 70 | 70 | 70 | 70 | 70 | 70 | 0 | 0 | 0 | 0 |
| Ge (content: ppm) | 0 | 0 | 0 | 0 | 0 | 0 | 0 | 0 | 65 | 0 |
| Ti (content: ppm) | 0 | 0 | 0 | 0 | 0 | 0 | 7 | 7 | 0 | 0 |
| Al (content: ppm) | 0 | 0 | 0 | 0 | 0 | 0 | 0 | 0 | 0 | 21 |
| P (content: ppm) | 0 | 0 | 0 | 0 | 0 | 0 | 0 | 0 | 0 | 45 |
| Mg+Ca (content: ppm) | 9 | 0 | 0 | 146 | 0 | 112 | 0 | 0 | 0 | 0 |
| Total metal (content: ppm) | 79 | 70 | 70 | 216 | 70 | 182 | 7 | 7 | 65 | 21 |
| TS | 0.24 | 0.22 | 0.32 | 0.24 | 0.28 | 0.24 | - | 0 | - | - |

Table 1-3

| | Production Example 20 | Production Example 21 | Production Example 22 | Production Example 23 | Production Example 24 | Production Example 25 | Production Example 26 | Production Example 31 | Production Example 32 | Production Example 33 | Production Example 34 |
|---|---|---|---|---|---|---|---|---|---|---|---|
| Resin | CRA-1Sb | CR-OAl | CRA-1Al | BIA-1Sb | BI-OAl | BIA-1Al | PEN | MR | MB-1Sb | MB-1BI | MB-1CR |
| Cation | EMIM | - | EMIM | EMIM | - | EMIM | EMIM | - | EMIM | EMIM | EMIM |
| Anion | TFSI | - | TFSI | TFSI | - | TFSI | TFSI | - | TFSI | TFSI | TFSI |
| Dissociation energy | 315 | - | 315 | 315 | - | 315 | 315 | - | 315 | 315 | 315 |
| Ionic radius (Anion) | 3.66 | - | 3.66 | 3.66 | - | 3.66 | 3.66 | - | 3.66 | 3.66 | 3.66 |
| Ionic radius (Cation) | 3.30 | - | 3.30 | 3.30 | - | 3.30 | 3.30 | - | 3.30 | 3.30 | 3.30 |
| Absolute value of the average charge density (Anion) | 0.0044 | - | 0.0044 | 0.0044 | - | 0.0044 | 0.0044 | - | 0.0044 | 0.0044 | 0.0044 |
| Absolute value of the average charge density (Cation) | 0.0059 | - | 0.0059 | 0.0059 | - | 0.0059 | 0.0059 | - | 0.0059 | 0.0059 | 0.0059 |
| $R \leq 0.15 \times Q + 890$ | 937 | - | 937 | 937 | - | 937 | 937 | - | 937 | 937 | 937 |
| $R \leq -20 \times Q + 16000$ | 9700 | - | 9700 | 9700 | - | 9700 | 9700 | - | 9700 | 9700 | 9700 |
| Amount of ionic compound added (ppm) | 3 | 0 | 3 | 3 | 0 | 3 | 5 | 0 | 80 | 80 | 80 |
| Addition method | During polymerization | - | During polymerization | During polymerization | - | During polymerization | During polymerization | - | During polymerization | During polymerization | During polymerization |
| Resin IV | 0.63 | 0.63 | 0.63 | 0.64 | 0.64 | 0.63 | 0.55 | 0.64 | 0.63 | 0.63 | 0.63 |
| Resin AV | 13 | 13 | 14 | 14 | 14 | 14 | 15 | 32 | 14 | 14 | 14 |
| Ethylene terephthalate content (mol%) | 98.8 | 98.8 | 98.6 | 98.6 | 98.6 | 98.6 | - | 98.4 | 98.6 | 98.6 | 98.6 |
| Copolymer component (mol%) | DEG: 1.2, IPA:1 | DEG: 1.2, IPA:1 | DEG: 1.4 | DEG: 1.4 | DEG: 1.4 | DEG: 1.4 | | DEG: 1.8, IPA:1.5 | DEG: 1.4 | DEG: 1.4 | DEG: 1.4 |
| Catalyst species | Sb | Al-P | Al-P | Sb | Al-P | Al-P | Sb | - | Sb | Al-P | Al-P |
| Sb (content: ppm) | 70 | 0 | 0 | 70 | 0 | 0 | 120 | 175 | 70 | 0 | 0 |

(continued)

| | Production Example 20 | Production Example 21 | Production Example 22 | Production Example 23 | Production Example 24 | Production Example 25 | Production Example 26 | Production Example 31 | Production Example 32 | Production Example 33 | Production Example 34 |
|---|---|---|---|---|---|---|---|---|---|---|---|
| Ge (content: ppm) | 0 | 0 | 0 | 0 | 0 | 0 | 0 | 2 | 0 | 0 | 0 |
| Ti (content: ppm) | 0 | 0 | 0 | 0 | 0 | 0 | 0 | 0 | 0 | 0 | 0 |
| Al (content: ppm) | 0 | 21 | 21 | 0 | 21 | 21 | 0 | 0 | 0 | 21 | 21 |
| P (content: ppm) | 0 | 45 | 45 | 0 | 45 | 45 | 0 | - | 0 | 45 | 45 |
| Mg+Ca (content: ppm) | 0 | 0 | 0 | 0 | 0 | 0 | 0 | - | 0 | 0 | 0 |
| Total metal (content: ppm) | 70 | 21 | 21 | 70 | 21 | 21 | 120 | - | 70 | 21 | 21 |
| TS | - | - | - | - | - | - | - | - | 0.22 | - | - |

Preparation of Adhesion-Promoting Coating Solution

The starting materials listed below were mixed to prepare a coating solution for forming a coating layer with excellent adhesion to the functional layer. The coating solution was filtered using a 10 μm filter medium (nominal filtration efficiency: 95% removal of 10 μm particles).

Water: 55.62 wt%
Isopropanol: 30.00 wt%
Aliphatic polycarbonate-based polyurethane resin aqueous solution (35% solids): 11.29 wt%
Oxazoline group-containing acrylic crosslinking agent aqueous solution (40% solids): 2.26 wt%
Particles (silica sol with an average particle size of 40nm, 40wt% solids): 0.71 wt%
Particles (silica sol with an average particle size of 450nm, 40wt% solids): 0.07 wt%
Surfactant (silicone-based, 100 wt% solids): 0.05 wt%

Example 1

The polyester resin was dried at 135°C under a reduced pressure of 33 Pa for 6 hours, then fed into a single-screw extruder and melted at 285°C. The molten polymer was filtered through a stainless steel sintered filter medium (nominal filtration accuracy: 95% removal of 20 μm particles), extruded into a sheet through a T-die, and then cooled and solidified by winding onto a casting drum with a surface temperature of 30°C using an electrostatic casting method, thereby forming an unstretched film.

Casting was performed at a speed of 60 m/min by placing a tungsten wire electrode between the die of the extruder and the cooling drum, and applying a voltage of 5 to 15 kV between the electrode and the casting drum.

Subsequently, this unstretched film was longitudinally stretched 3.3 times at 95°C using rolls with different peripheral speeds.

Both surfaces of the uniaxially stretched PET film were coated with an adhesion-facilitating layer coating solution so that the coating amount after drying would be 0.12 g/m$^2$. The resulting film was then led into a dryer and dried at 80°C for 20 seconds.

The uniaxially stretched film with a coating layer formed thereon was led a tenter stretching machine, in which while the edges of the film were gripped with clips, the film was guided into a hot air zone at 125°C, and stretched 3.5 times in the transverse direction. Subsequently, while maintaining the stretched width in the transverse direction, the film was heat-treated at 225°C for 30 seconds. The film was then subjected to a 3% relaxation treatment in the TD and then cooled. After trimming both edges of the film, the film was wound up to obtain a biaxially oriented PET film with a film thickness of 50 μm.

Examples 2 to 32 and Comparative Examples 1 to 10

The resins shown in Table 1 were fed into the extruder in the same manner as in Example 1 to obtain biaxially stretched polyester films. In Example 10, the casting speed was set to 30 m/min. In Examples 18 to 32 and Comparative Examples 8 and 9 where two or more types of resins were used, the resins were dry-blended in advance and then dried. In Examples 24, 25, 31, and 32, no adhesion-facilitating layer was provided on the film. In the case of PEN (Example 17), the melt temperature was set to 290°C, the roll temperature during longitudinal stretching was set to 110°C, and the tenter temperature was set to 135°C.

In all of the Examples except Example 10, the casting speed was 50 m/min or higher, and high-speed and stable film formation was achieved. No sparking was observed.

Example 10 corresponds to a case where the metal content, such as catalysts, was reduced for applications requiring insulation. Nevertheless, the melt resistivity was effectively lowered and a film with low risk of short-circuiting was obtained.

On the other hand, Comparative Examples 1 and 5 exhibited excellent electrostatic adhesion and no sparking, but the films contained a higher amount of foreign matter. Comparative Examples 2 and 7 did not have issues with foreign matter, but showed poor electrostatic adhesion. Comparative Example 6 exhibited slightly inferior electrostatic adhesion and contained a large amount of foreign matter. In Comparative Examples 3 and 4, sparking occurred, and stable film formation could not be achieved.

Examples 33, 40, 41, and 44

The resins for a surface layer and the resins for an intermediate layer were dry-blended separately. After drying, the blends were fed into an extruder for a surface layer and an extruder for an intermediate layer, and each blend was

filtered through the same type of filter material, and then introduced into a two-material, three-layer T-die to obtain a biaxially stretched film in the same manner as above.

Examples 34 and 42

The resins for a surface layer and the resins for an intermediate layer were dry-blended separately. After drying, the blends were fed into an extruder for a surface layer and an extruder for an intermediate layer, filtered through the same type of filter material, and then fed into a two-material, three-layer T-die to obtain an unstretched sheet. An adhesion-facilitating layer was formed on both surfaces of the obtained unstretched sheet, and the resulting sheet was then stretched 4.0 times in the transverse direction using a tenter at 125°C. Heat setting was carried out at 190°C, and 2% relaxation in the TD direction was performed. The resulting film had a thickness of 80 μm.

Examples 35 and 43

The above-obtained unstretched sheet with the adhesion-facilitating layers formed thereon was biaxially stretched using a simultaneous biaxial stretching machine at a draw ratio of 2.2 times in the transverse direction and 6.5 times in the machine direction. The sheet was then heat-set at 225°C. The resulting film had a thickness of 40 μm.

Examples 36 to 39 and 44

Biaxially oriented polyester films were prepared using a two-material, two-layer T-die in the same manner as above except that the thickness of the layer containing a lubricant and the thickness of the layer not containing a lubricant were changed.

Tables 2 to 4 show the resins used, and compositions, structures, and properties of the films. The ionic compound content of the film obtained in Example 1 was measured to be 2.2 ppm by mass.

Table 2-1

| | Example 1 | Example 2 | Example 3 | Example 4 | Example 5 | Example 6 | Example 7 | Example 8 | Example 9 | Comparative Example 1 | Comparative Example 2 | Comparative Example 3 |
|---|---|---|---|---|---|---|---|---|---|---|---|---|
| Raw resin | SbA-1 | SbA-2 | SbA-3 | SbA-4 | SbA-5 | SbA-6 | SbA-7 | SbA-8 | SbA-9 | SbB-1 | Sb-0 | SbB-2 |
| Film IV | 0.60 | 0.60 | 0.58 | 0.57 | 0.59 | 0.58 | 0.57 | 0.57 | 0.62 | 0.60 | 0.59 | 0.58 |
| Film AV | 25 | 25 | 24 | 24 | 22 | 25 | 25 | 26 | 24 | 26 | 23 | 26 |
| Melt resistivity | 0.21 | <0.01 | <0.01 | 0.21 | 0.18 | 0.61 | 0.06 | 0.17 | 0.2 | 0.28 | >2 | <0.01 |
| Number of coarse particles | <10 | <10 | <10 | <10 | <10 | <10 | <10 | <10 | <10 | >50 | <10 | 20 |
| Oligomer content | 1 | 1 | 1 | 1 | 1 | 1 | 1 | 1 | 1 | 1 | 1 | 1 |
| Film-forming stability | ○ | ○ | ○ | ○ | ○ | ○ | ○ | ○ | ○ | ○ | × | × |

Table 2-2

| | Comparative Example 4 | Comparative Example 5 | Comparative Example 6 | Example 10 | Comparative Example 7 | Example 11 | Example 12 | Example 13 | Example 14 | Example 15 | Example 16 | Example 17 |
|---|---|---|---|---|---|---|---|---|---|---|---|---|
| Raw Resin | SbB-3 | SbB-4 | SbB-5 | TiA-1 | Ti-0 | GeA-1 | AlA-1 | CRA-1Sb | CRA-1Al | BIA-1Sb | BIA-1Al | PEN |
| Film IV | 0.59 | 0.58 | 0.57 | 0.60 | 0.60 | 0.62 | 0.59 | 0.60 | 0.59 | 0.61 | 0.59 | 0.52 |
| Film AV | 26 | 23 | 25 | 24 | 25 | 25 | 25 | 23 | 25 | 25 | 25 | 25 |
| Melt resistivity | <0.01 | 0.43 | 0.6 | 1.5 | >2 | 0.35 | 0.4 | 0.22 | 0.4 | 0.21 | 0.4 | 0.2 |
| Number of coarse particles | >50 | 30 | >50 | <10 | <10 | <10 | <10 | <10 | <10 | <10 | <10 | <10 |
| Oligomer content | 1 | 1 | 1 | 1 | 1 | 1 | 1 | 1 | 1 | 1 | 1 | 1 |
| Film-forming stability | × | ○ | Δ | Δ | × | ○ | ○ | ○ | ○ | ○ | ○ | ○ |

Table 3-1

| | Example 18 | Example 19 | Example 20 | Example 21 | Example 22 | Example 23 | Example 24 | Example 25 |
|---|---|---|---|---|---|---|---|---|
| Resin | CR-0Al | CR-0Al | BI-OAl | BI-OAl | MR | MR | MR | SbA-1 |
| | MB-1Sb | MB-1CR | MB-1Sb | MB-1BI | MB-1Sb | MB-1CR | MB-1Sb | - |
| | - | - | - | - | - | - | MB-2Si1 | MB-2Si1 |
| Resin ratio | 19/1 | 19/1 | 19/1 | 19/1 | 19/1 | 19/1 | 18/1/1 | 9/1 |
| Amount of ionic compound added | 4 | 4 | 4 | 4 | 4 | 4 | 4 | 2.7 |
| Film IV | 0.60 | 0.60 | 0.60 | 0.60 | 0.61 | 0.61 | 0.61 | 0.60 |
| Film AV | 25 | 27 | 27 | 27 | 32 | 32 | 33 | 26 |
| Melt resistivity | 0.23 | 0.22 | 0.22 | 0.22 | 0.20 | 0.10 | 0.21 | 0.21 |
| Number of coarse particles | <10 | <10 | <10 | <10 | <10 | <10 | <10 | <10 |
| Oligomer content | 1 | 1 | 1 | 1 | 0.9 | 1 | 0.9 | 1 |
| Easily slipping IC | Both surfaces | Both surfaces | Both surfaces | Both surfaces | Both surfaces | Both surfaces | None | None |
| Film-forming stability | ○ | ○ | ○ | ○ | ○ | ○ | ○ | ○ |
| Ra | 1.3 | 1.4 | 1.4 | 1.3 | 1.4 | 1.3 | 22 | 31 |
| Rzjis | 18 | 17 | 15 | 15 | 16 | 18 | 182 | 276 |

Table 3-2

| | Example 26 | Example 27 | Example 28 | Example 29 | Example 30 | Example 31 | Example 32 | Comp. Ex. 8 | Comp. Ex. 9 | Comp. Ex. 10 |
|---|---|---|---|---|---|---|---|---|---|---|
| Resin | Sb-0 | Sb-0 | Sb-0 | Sb-0 | Sb-0 | Sb-0 | Sb-0 | Sb-0 | Sb-0 | SbB-1 |
| | MB-1Sb | MB-1Sb | MB-1Sb | SbA-2 | SbA-7 | MB-1Sia | MB-1Sib | - | SbB-3 | - |
| | - | - | - | - | - | - | - | - | - | - |
| Resin ratio | 39/1 | 19/1 | 9/1 | 99/1 | 9/1 | 19/1 | 19/1 | - | 19/1 | - |
| Amount of ionic compound added | 2 | 4 | 8 | 7 | 3 | 3.5 | 4 | 0 | 65 | 80 |
| Film IV | 0.60 | 0.60 | 0.60 | 0.60 | 0.59 | 0.61 | 0.59 | 0.60 | 0.59 | 0.59 |
| Film AV | 25 | 25 | 25 | 25 | 26 | 26 | 27 | 24 | 26 | 26 |
| Melt resistivity | 0.40 | 0.23 | 0.15 | 0.18 | 0.25 | 0.25 | 0.22 | >2 | 0.30 | 0.28 |
| Number of coarse particles | <10 | <10 | <10 | <10 | <10 | <10 | <10 | <10 | >50 | >50 |
| Oligomer content | 1 | 1 | 1 | 1 | 1 | 1 | 1 | 1 | 1 | 1 |
| Inline slide coating | Both surfaces | Both surfaces | Both surfaces | Both surfaces | Both surfaces | None | None | Both surfaces | Both surfaces | Both surfaces |
| Film-forming stability | ○ | ○ | ○ | ○ | ○ | ○ | ○ | × | ○ | ○ |
| Ra | 1.3 | 1.3 | 1.3 | 1.4 | 1.3 | 25 | 23 | 1.4 | 1.5 | 1.3 |
| Rzjis | 18 | 17 | 18 | 20 | 19 | 210 | 207 | 18 | 21 | 19 |

Table 4-1

| | Example 33 | Example 34 | Example 35 | Example 36 | Example 37 | Example 38 | Example 39 | Example 40 |
|---|---|---|---|---|---|---|---|---|
| Resin of surface layer 1 (mass ratio) | Sb-0+MB-2Si1 (9/1) | SbA-1 | | SbA-1+MB-2Si1(9/1) | | | SbA-1 + MB-2Ca (9/1) | SbA-1 + MB-2Si$_2$ (9/1) |
| Resin of intermediate layer (mass ratio) | SbA-1 | SbA-1+MB-3 (9/1) | | SbA-1 | | | SbA-1 | SbA-1 |
| Resin of surface layer 2 (mass ratio) | Sb-0+MB-2Si1 (9/1) | SbA-1 | | - | | | - | SbA-1 +MB-2St (9/1) |
| Thickness ratio (Surface layer 1/Intermediate layer/Surface layer 2) | 1/8/1 | 1/8/1 | | 2/8/- | 5/5/- | 8/2/- | 5/5/- | 1/8/1 |
| Amount of ionic compound added | 2.40 | 2.76 | | 2.91 | 2.85 | 2.76 | 2.85 | 2.91 |
| Melt resistivity | 0.23 | 0.22 | | 0.22 | 0.22 | 0.22 | 0.22 | 0.22 |
| Number of coarse particles | <10 | <10 | | <10 | <10 | <10 | <10 | <10 |
| Inline slip coating | None | Both surfaces | | None | None | None | None | None |
| Film-forming stability | ○ | ○ | | ○ | ○ | ○ | ○ | ○ |
| Ra | 28 | 1.2 | 1.3 | 33/1.7 | 27/2.0 | 26/2.7 | 25/1.8 | 1.1/27 |
| Rzjis | 255 | 18 | 17 | 282/25 | 270/29 | 255/37 | 240/17 | 15/260 |
| | | | | Surface layer 1/Surface layer 2 | | | | |

Table 4-2

| | Example 41 | Example 42 | Example 43 | Example 44 |
|---|---|---|---|---|
| Resin of surface layer 1 (mass ratio) | Sb-0+MB-2Si1 (9/1) | Sb-0 | | Sb-0+MB-2Si1 (9/1) |
| Resin of intermediate layer (mass ratio) | Sb-0+MB-1Sb (19/1) | Sb-0+MB-1 UV (9/1) | | Sb-0+MB-1Sb (19/1) |
| Resin of surface layer 2 (mass ratio) | Sb-0+MB-2Si1 (9/1) | Sb-0 | | - |
| Thickness ratio (Surface layer 1/Intermediate layer/Surface layer 2) | 1/8/1 | 1/8/1 | | 2/8/- |
| Amount of ionic compound added | 3.20 | 5.76 | | 3.20 |
| Melt resistivity | 0.22 | 0.18 | | 0.24 |
| Number of coarse particles | <10 | <10 | | <10 |
| Inline slip coating | None | Both surfaces | | None |
| Film-forming stability | ○ | ○ | | ○ |

(continued)

| | Example 41 | Example 42 | Example 43 | Example 44 |
|---|---|---|---|---|
| Ra | 25 | 1.2 | 1.3 | 30/1.7 |
| Rzjis | 190 | 18 | 17 | 275/25 |

Table 5 shows the physical properties and other characteristics of the films obtained.

Table 5-1

| | Example 1 (*1) | Example 22 | Example 24 | Example 25 | Example 33 | Example 34 | Example 35 | Example 36 |
|---|---|---|---|---|---|---|---|---|
| Haze (%) | 0.8 | 1.5 | 3.7 | 4.2 | 1.8 | 0.8 | 0.8 | 2.0 |
| Total light transmittance (%) | 90.6 | 88.0 | 85.3 | 85.0 | 88.0 | 90.3 | 90.5 | 88.0 |
| Elongation at break in the MD direction (%) | 155 | 170 | 165 | 160 | 155 | 6 | 65 | 160 |
| Elongation at break in the TD direction (%) | 110 | 130 | 125 | 115 | 115 | 70 | 26 | 100 |
| Breaking strength in the MD direction (MPa) | 240 | 250 | 245 | 240 | 240 | 80 | 310 | 250 |
| Breaking strength in the TD direction (MPa) | 295 | 305 | 300 | 295 | 295 | 320 | 180 | 295 |
| Elastic modulus in the MD direction (GPa) | 3.8 | 3.8 | 3.8 | 3.8 | 3.8 | 2.0 | 6.3 | 3.8 |
| Elastic modulus in the TD direction (GPa) | 4.0 | 3.9 | 4.0 | 4.0 | 4.0 | 6.5 | 2.5 | 4.0 |
| Tear propagation resistance (N/mm) | 7 | 8 | 7 | 7 | 7 | - | - | 7 |
| Impact strength (J/μm) | 0.05 | 0.07 | 0.06 | 0.05 | 0.05 | - | - | 0.06 |
| Thermal shrinkage in the maximum shrinkage direction at 150°C (%) | 1.0 | 1.0 | 1.0 | 1.0 | 1.0 | 2.2 | 1.5 | 1.0 |
| Dynamic friction coefficient | 0.48 | 0.47 | 0.42 | 0.35 | 0.35 | 0.50 | 0.50 | 0.35 (*2) |
| Static friction coefficient | 0.50 | 0.50 | 0.44 | 0.35 | 0.35 | 0.50 | 0.50 | 0.36 (*2) |
| Water vapor transmission rate ($g/m^2 \cdot 24h$, converted per 50 μm thickness) | 11 | 11 | 10 | 11 | - | - | - | - |

(continued)

| | Example 1 (*1) | Example 22 | Example 24 | Example 25 | Example 33 | Example 34 | Example 35 | Example 36 |
|---|---|---|---|---|---|---|---|---|
| Oxygen transmission rate ($cm^3/m^2 \cdot 24h \cdot MPa$, converted per 50 $\mu m$ thickness) | 240 | 240 | 240 | 240 | - | - | - | - |
| (*1) Since the films obtained in Examples 1 to 16 and 18 to 21 exhibited almost equivalent properties, properties of the film obtained in Example 1 are shown as representative. (*2) Values of the particle-containing layer. | | | | | | | | |

Table 5-2

| | Example 26 (*3) | Example 31 | Example 32 | Example 41 | Example 42 | Example 43 | Example 44 |
|---|---|---|---|---|---|---|---|
| Haze (%) | 0.8 | 3.7 | 3.7 | 1.8 | 0.8 | 0.8 | 2.0 |
| Total light transmittance (%) | 90.4 | 85.3 | 85.2 | 88.0 | 90.4 | 90.5 | 88.1 |
| Elongation at break in the MD direction (%) | 160 | 170 | 165 | 160 | 7 | 65 | 160 |
| Elongation at break in the TD direction (%) | 115 | 120 | 130 | 115 | 70 | 25 | 105 |
| Breaking strength in the MD direction (MPa) | 235 | 245 | 240 | 245 | 80 | 300 | 240 |
| Breaking strength in the TD direction (MPa) | 300 | 295 | 300 | 300 | 310 | 190 | 300 |
| Elastic modulus in the MD direction (GPa) | 3.8 | 3.9 | 3.8 | 3.8 | 2.0 | 6.5 | 3.9 |
| Elastic modulus in the TD direction (GPa) | 4.1 | 4.0 | 4.0 | 4.0 | 6.5 | 25 | 4.0 |
| Tear propagation resistance (N/mm) | 7 | 8 | 7 | 7 | - | - | 7 |
| Impact strength($J/\mu m$) | 0.05 | 0.06 | 0.06 | 0.05 | - | - | 0.06 |
| Thermal shrinkage in the maximum shrinkage direction at 150°C (%) | 1.0 | 1.0 | 1.0 | 1.0 | 2.2 | 1.5 | 1.0 |
| Dynamic friction coefficient | 0.48 | 0.42 | 0.42 | 0.35 | 0.50 | 0.50 | 0.35 (*2) |
| Static friction coefficient | 0.50 | 0.44 | 0.44 | 0.35 | 0.50 | 0.50 | 0.36 (*2) |
| Water vapor transmission rate ($g/m^2 \cdot 24h$, converted per 50 $\mu m$ thickness) | 11 | 10 | 11 | - | - | - | - |
| Oxygen transmission rate ($cm^3/m^2 \cdot 24h \cdot MPa$, converted per 50 $\mu m$ thickness) | 240 | 240 | 240 | - | - | - | - |
| (*3) Since the films obtained in Examples 26 to 30 exhibited almost equivalent properties, properties of the film obtained in Example 26 are shown as representative. | | | | | | | |

Table 6 shows the optical properties of the films of Examples 34, 35, 42, and 43.

Table 6

| | Example 34 | Example 35 | Example 42 | Example 43 |
|---|---|---|---|---|
| Thickness ($\mu$m) | 80 | 40 | 80 | 40 |
| In-plane retardation (nm) | 8640 | 3440 | 8640 | 3440 |
| Thickness direction retardation (nm) | 9200 | 5100 | 9200 | 5100 |
| NZ coefficient | 1.57 | 1.85 | 1.57 | 1.85 |

**Claims**

**1.** A polyester film comprising an ionic compound in an amount of 0.01 ppm by mass or more and 950 ppm by mass or less, the ionic compound having an anion-cation dissociation energy Q of 850 kJ/mol or less.

**2.** The polyester film according to claim 1, comprising a resin having a melt resistivity of 20 x $10^8$ $\Omega\cdot$cm or less.

**3.** The polyester film according to claim 1, comprising a resin having a melt resistivity of 0.001 x $10^8$ $\Omega\cdot$cm or more.

**4.** The polyester film according to claim 1, wherein the ionic compound comprises at least one ion selected from the group consisting of an anion and a cation, the at least one ion having an ionic radius of 10 Å or less.

**5.** The polyester film according to claim 1, wherein the ionic compound comprises at least one ion selected from the group consisting of an anion and a cation, the at least one ion having an absolute value of average charge density of 0.0025 e/Å$^2$ or more and 0.075 e/Å$^2$ or less.

**6.** The polyester film according to claim 4, wherein the ionic compound comprises a cation having an ionic radius of 2 Å or more.

**7.** The polyester film according to claim 5, wherein the ionic compound comprises a cation having an absolute value of average charge density of 0.015 e/Å$^2$ or less.

**8.** The polyester film according to claim 1, comprising the ionic compound in an amount of less than 100 ppm by mass.

**9.** The polyester film according to claim 1, comprising a resin that is polyethylene terephthalate and/or polyethylene naphthalate.

**10.** A method for producing a polyester film comprising an ionic compound having an anion-cation dissociation energy Q of 850 kJ/mol or less, the method comprising:

mixing a polyester resin composition A, which comprises a polyester resin A and an ionic compound having an anion-cation dissociation energy Q of 850 kJ/mol or less, with a polyester resin B having a melt resistivity greater than that of the polyester resin composition A; and
forming the resulting mixture of the polyester resin composition A and the polyester resin B into a film.

**11.** The method according to claim 10, wherein the polyester resin composition A has a melt resistivity of 5 x $10^8$ $\Omega\cdot$cm or less.

**12.** A method for producing a polyester film comprising an ionic compound having an anion-cation dissociation energy Q of 850 kJ/mol or less, the method comprising:

mixing a polyester resin composition A, which comprises a polyester resin A and an ionic compound having an anion-cation dissociation energy Q of 850 kJ/mol or less, with a polyester resin B having a melt resistivity of $1\times10^8$ $\Omega\cdot$cm or more, and
forming the resulting mixture of the polyester resin composition A and the polyester resin B into a film.

**13.** A method for producing the polyester film of claim 1, the method comprising:

mixing a polyester resin composition A, which comprises a polyester resin A and an ionic compound having an anion-cation dissociation energy Q of 850 kJ/mol or less, with a polyester resin B having a melt resistivity greater than that of the polyester resin composition A; and
forming the resulting mixture of the polyester resin composition A and the polyester resin B into a film.

**14.** A method for producing the polyester film of claim 1, comprising:

mixing a polyester resin composition A, which comprises a polyester resin A and an ionic compound having an anion-cation dissociation energy Q of 850 kJ/mol or less, with a polyester resin B having a melt resistivity of $1 \times 10^8$ $\Omega \cdot cm$ or more, and
forming the resulting mixture of the polyester resin composition A and the polyester resin B into a film.

**15.** A polyester resin composition comprising a polyester resin and an ionic compound having an anion-cation dissociation energy Q of 850 kJ/mol or less, the polyester resin composition having a melt resistivity of $0.0001 \times 10^8$ $\Omega \cdot cm$ or more and $0.1 \times 10^8$ $\Omega \cdot cm$ or less.

## INTERNATIONAL SEARCH REPORT

International application No. **PCT/JP2024/036413**

**A. CLASSIFICATION OF SUBJECT MATTER**

***C08L 67/00***(2006.01)i; ***C08J 5/18***(2006.01)i; ***C08K 5/00***(2006.01)i; *B29C 48/08*(2019.01)n; *B29C 48/88*(2019.01)n
FI: C08L67/00; C08K5/00; C08J5/18 CFD; B29C48/88; B29C48/08

According to International Patent Classification (IPC) or to both national classification and IPC

**B. FIELDS SEARCHED**

Minimum documentation searched (classification system followed by classification symbols)

C08L67/00-67/04; C08J5/18; C08K5/00-5/59; B32B27/36

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2016/167084 A1 (TORAY INDUSTRIES, INC.) 20 October 2016 (2016-10-20) claims 1, 9, 11, 24, paragraphs [0063]-[0225] | 1-9, 15<br>10-14 |
| A | JP 2016-210868 A (DAIWA CAN COMPANY) 15 December 2016 (2016-12-15) | 1-15 |
| A | JP 2009-280710 A (DAIWA CAN COMPANY) 03 December 2009 (2009-12-03) | 1-15 |
| A | JP 2006-299120 A (SUMITOMO BAKELITE CO., LTD.) 02 November 2006 (2006-11-02) | 1-15 |
| A | JP 2003-41022 A (MITSUBISHI POLYESTER FILM CORP.) 13 February 2003 (2003-02-13) | 1-15 |
| A | JP 51-70269 A (TORAY INDUSTRIES, INC.) 17 June 1976 (1976-06-17) | 1-15 |
| A | JP 2023-114422 A (TORAY INDUSTRIES, INC.) 17 August 2023 (2023-08-17) | 1-15 |
| A | JP 59-108058 A (TORAY INDUSTRIES, INC.) 22 June 1984 (1984-06-22) | 1-15 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 December 2024** | **07 January 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
PCT/JP2024/036413

C. DOCUMENTS CONSIDERED TO BE RELEVANT

| Category* | Citation of document, with indication, where appropriate, of the relevant passages | Relevant to claim No. |
|---|---|---|
| A | JP 10-329188 A (DIAFOIL HOECHST CO., LTD.) 15 December 1998 (1998-12-15) | 1-15 |
| A | JP 62-257928 A (TEIJIN LIMITED) 10 November 1987 (1987-11-10) | 1-15 |

Form PCT/ISA/210 (second sheet) (July 2022)

**INTERNATIONAL SEARCH REPORT**
**Information on patent family members**

International application No.
**PCT/JP2024/036413**

| Patent document cited in search report | Publication date (day/month/year) | Patent family member(s) | Publication date (day/month/year) |
|---|---|---|---|
| WO 2016/167084 A1 | 20 October 2016 | US 2018/0126714 A1<br>claims 27, 35, 37, 50, paragraphs [0077]-[0312]<br>EP 3284786 A1<br>CN 107429047 A<br>KR 10-2017-0138990 A<br>TW 201700529 A<br>JP 2017-165988 A<br>JP 2017-193718 A<br>JP 2018-111822 A | |
| JP 2016-210868 A | 15 December 2016 | (Family: none) | |
| JP 2009-280710 A | 03 December 2009 | (Family: none) | |
| JP 2006-299120 A | 02 November 2006 | (Family: none) | |
| JP 2003-41022 A | 13 February 2003 | (Family: none) | |
| JP 51-70269 A | 17 June 1976 | (Family: none) | |
| JP 2023-114422 A | 17 August 2023 | (Family: none) | |
| JP 59-108058 A | 22 June 1984 | (Family: none) | |
| JP 10-329188 A | 15 December 1998 | US 5958659 A<br>US 6361734 B1<br>EP 873844 A2<br>KR 10-0450143 B1 | |
| JP 62-257928 A | 10 November 1987 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2023177741 A
- JP 2024031431 A
- JP 2024031434 A
- JP 2024055982 A
- JP 2024055985 A
- JP 2024055986 A
- JP 2024076078 A
- JP 2024094269 A
- JP 2024094270 A
- JP 2024113434 A
- JP 2024113436 A
- JP 2024113437 A
- JP 2002327053 A